(19) Europäisches Patentamt
European Patent Office
Office européen des brevets

(11) **EP 3 358 611 B1**

(12) **EUROPEAN PATENT SPECIFICATION**

(45) Date of publication and mention
of the grant of the patent:
**26.08.2020 Bulletin 2020/35**

(21) Application number: **16851598.9**

(22) Date of filing: **28.09.2016**

(51) Int Cl.:
*H01L 21/677* (2006.01)     *B65G 49/00* (2006.01)
*G03F 7/20* (2006.01)      *H01L 21/02* (2006.01)
*H01L 21/67* (2006.01)

(86) International application number:
**PCT/JP2016/078567**

(87) International publication number:
**WO 2017/057427 (06.04.2017 Gazette 2017/14)**

(54) **PRODUCTION SYSTEM**

PRODUKTIONSSYSTEM

SYSTÈME DE PRODUCTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.09.2015 JP 2015190796**

(43) Date of publication of application:
**08.08.2018 Bulletin 2018/32**

(73) Proprietor: **Nikon Corporation
Tokyo 108-6290 (JP)**

(72) Inventors:
• **KATO Masaki
Tokyo 108-6290 (JP)**
• **KITO Yoshiaki
Tokyo 108-6290 (JP)**

• **NARA Kei
Tokyo 108-6290 (JP)**
• **HORI Masakazu
Tokyo 108-6290 (JP)**
• **KIUCHI Tohru
Tokyo 108-6290 (JP)**

(74) Representative: **Hoffmann Eitle
Patent- und Rechtsanwälte PartmbB
Arabellastraße 30
81925 München (DE)**

(56) References cited:
**WO-A1-2013/118764     JP-A- H0 428 415
JP-A- H0 428 415       JP-A- 2015 145 971
JP-A- 2015 145 971**

**Description**

Technical Field

The present invention relates to a production (manufacturing) system for manufacturing electronic devices by a roll-to-roll method.

Background Art

Document JP H04 28415 A discloses a method for controlling a looper position, in an in-line manufacturing system.

Japanese Laid-Open Patent Publication No. 2009-146746 discloses a manufacturing system using a roll-to-roll (RTR) method in which, in order to form electronic devices (organic EL display panels) on a belt-like flexible substrate (a flexible elongate plastic film), the flexible substrate, which is wound in a roll shape, is drawn out and conveyed along a longitudinal direction, and after the flexible substrate is subjected to sequential processing by processing devices responsible for each of a plurality of formation steps aligned along the longitudinal direction, the flexible substrate is wound up again in a roll shape. Furthermore, in Japanese Laid-Open Patent Publication No. 2009-146746, it is disclosed that an accumulator for adjusting the speed of the flexible substrate between the respective formation steps (processing devices) is provided, and the organic EL display panels are continuously produced. In the case of such an RTR type of manufacturing line, since the single elongate flexible substrate, which is continuous in a band shape, is continuously conveyed in the longitudinal direction, it is desirable for each of the plurality of processing devices constituting the manufacturing line to be continuously operated normally over the entire length (roll length) of the continuously conveyed flexible substrate.

However, depending on the processing devices, the processing operations performed on the flexible substrate may be interrupted for a certain period of time, in order to maintain the performance of the devices or to maintain the quality of the manufactured electronic devices, or the like. If an interruption in operation occurs in any one of the processing devices in the manufacturing line, for example, even if the interruption time period is slight, there is a possibility of causing stoppage of the entire manufacturing line, which results in a decrease in productivity. In the event that the manufacturing line is constituted by a plurality of processing devices which implement different types of processes on the flexible substrate, such as a film forming step, a patterning step, and a wet processing step, the factors causing interruption in operation, the timing (interval) of interruption, and the interruption time period required for each of the processing devices are different, and therefore, the possibility that the entire manufacturing line will be stopped is further increased, and there is a concern that productivity may be significantly deteriorated.

Summary of Invention

A first aspect of the present invention is characterized by a manufacturing system as recited in claim 1 below.

A second aspect of the present invention is characterized by a manufacturing system as recited in claim 13 below.

The dependent claims define particular embodiments of each respective aspect.

Brief Description of Drawings

FIG. 1 is a schematic configuration diagram showing a schematic configuration of a device manufacturing system according to a first embodiment;
FIG. 2 is a diagram showing a configuration of a processing device for forming a photosensitive functional layer on a sheet substrate in the device manufacturing system of FIG. 1;
FIG. 3 is a partial cross-sectional view showing a configuration of a die coater type of coating head provided in the processing device of FIG. 2;
FIG. 4 is a diagram showing a configuration of a pattern forming device for storing and exposing a sheet substrate in the device manufacturing system of FIG. 1;
FIG. 5 is a diagram showing the arrangement of an alignment microscope for detecting alignment marks formed on a sheet substrate and a scanning line of a spotlight moved on the sheet substrate by the pattern forming device of FIG. 4;
FIG. 6 is a diagram showing a configuration of a drawing unit constituting an exposure head of the pattern forming device of FIG. 4;
FIG. 7 is a diagram showing an arrangement of a reflected light monitoring system provided in the drawing unit of FIG. 6;

FIG. 8 is a diagram showing a configuration of a processing device that performs a development process in the device manufacturing system of FIG. 1;

FIG. 9 is a diagram showing an arrangement of a device forming region and alignment marks on a sheet substrate processed by the device manufacturing system of FIG. 1;

FIG. 10 is a flowchart showing process operations with respect to status information (a stop request) generated in respective processing devices in the device manufacturing system of FIG. 1;

FIG. 11 is a flowchart showing process operations of a simulation of a stoppage possibility executed in the flowchart of FIG. 10;

FIG. 12 is a flowchart showing operations of the device manufacturing system for determining a processing device in which a processing error has occurred in excess of an allowable range in a second embodiment;

FIG. 13 is a flowchart showing operations of the device manufacturing system, in the case that a processing error occurs in a processing device which is an exposure device in the second embodiment;

FIG. 14 is a flowchart showing operations of the device manufacturing system, in the case that a processing error occurs in a processing device other than the processing device which is the exposure device in the second embodiment;

FIG. 15 is a diagram showing a configuration of a processing unit according to a first modification of the first and second embodiments;

FIG. 16 is a diagram showing a configuration of a processing unit according to a second modification of the first and second embodiments; and

FIG. 17 is a schematic configuration diagram of a device manufacturing system in a third modification of the first and second embodiments.

Description of Embodiments

Preferred embodiments of a manufacturing system according to aspects of the present invention will be presented and described in detail below with reference to the accompanying drawings. It should be noted that the aspects of the present invention are not limited to such embodiments, and various modifications or improvements may be included therein. Stated otherwise, in the constituent elements described below, components which are substantially the same or can be easily conceived of by those skilled in the art are included, and the constituent elements described below can be appropriately combined. Further, within a scope that does not deviate from the intent of the present invention, various component omissions, substitutions, or modifications are possible.

[First Embodiment]

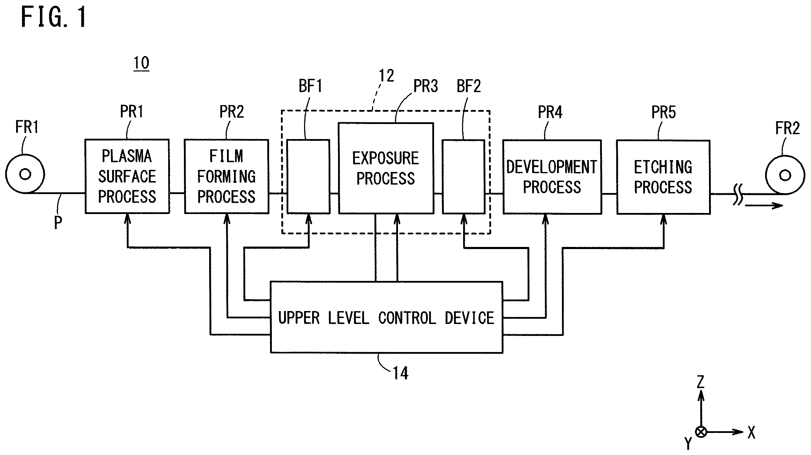

FIG. 1 is a schematic configuration diagram showing a schematic configuration of a device manufacturing system (processing system, manufacturing system) 10 according to a first embodiment. The device manufacturing system 10 shown in FIG. 1, for example, is a line (flexible display manufacturing line) for manufacturing a pattern layer (i.e., a layered structure of any one from among an electrode layer, a bus line wiring layer, an insulating layer, and a transparent electrode layer, etc., of thin film transistors) of a portion of a flexible display as an electronic device. As a flexible display, for example, there are organic EL displays, liquid crystal displays, and the like. The device manufacturing system 10 is of a so-called roll-to-roll method, in which a substrate P is fed out from a supply roll FR1 on which a flexible sheet substrate (hereinafter referred to simply as a substrate) P is wound in a roll shape, and after each of respective processes have been implemented continuously with respect to the fed out substrate P, the processed substrate P is wound up onto a collection roll FR2. The substrate P has a band shape in which the movement direction (conveying direction) of the substrate P is an elongate dimension, and the widthwise direction is a short dimension. The device manufacturing system 10 of the first embodiment illustrates an example in which the substrate P, which is a film-shaped sheet, is fed out from a supply roll FR1, and the substrate P which was fed out from the supply roll FR1 passes at least through the processing devices PR1, PR2, PR3, PR4, PR5, until the substrate P is wound up onto the collection roll FR2. In FIG. 1, an orthogonal coordinate system is shown in which an X direction, a Y direction, and a Z direction are mutually orthogonal. The X direction is the conveying direction of the substrate P in the horizontal plane, and is the direction that connects the supply roll FR1 and the collection roll FR2. The Y direction is a direction orthogonal to the X direction in a horizontal plane, and is the widthwise direction of the substrate P. The Z direction is a direction (vertical direction) orthogonal to the X direction and the Y direction.

The processing device PR1 is a surface processing device that performs processing steps for plasma surface processing with respect to the substrate P while the substrate P, which is conveyed from a supply roll FR1, is conveyed along a conveying direction (+X direction) in the longitudinal direction. The surface of the substrate P is reformed by the processing device PR1, whereby the adhesive property of the photosensitive functional layer is improved. The processing device (first processing device) PR2 is a film forming device (coating device) that performs a film forming process step (first processing step) for forming a film on the photosensitive functional layer while the substrate P, which is conveyed from the processing device PR1, is conveyed in the conveying direction (+X direction). By the processing device PR2 selectively or uniformly applying a photosensitive functional fluid onto the surface of the substrate P, the photosensitive functional layer (photosensitive thin film, coating layer, cover layer) is selectively or uniformly formed on the surface of the substrate P. Further, the processing device (second processing device) PR3 is an exposure device that performs a processing step (second processing step) for exposure processing, while the substrate P, which is fed from the processing device PR2 and has the photosensitive functional layer formed on the surface thereof, is conveyed in the conveying direction (+X direction). The processing device PR3 irradiates light patterns on the surface (photosensitive surface) of the substrate P in accordance with patterns for display panel circuits, or wiring patterns and the like. This causes a latent image (reformed portion) corresponding to the patterns to be formed on the photosensitive functional layer. The processing device (third processing device) PR4 is a developing device that performs a processing step (third processing step) for a wet type of development process while the substrate P, which is conveyed from the processing device PR3, is conveyed in the conveying direction (+X direction). This causes a resist layer or the like of the patterns to appear on the photosensitive functional layer in accordance with the latent image. The processing device PR5 is an etching device that performs a processing step for etching processing, with the photosensitive functional layer with patterns formed thereon serving as a mask, while the substrate P, which is conveyed from the processing device PR4, is conveyed in the conveying direction (+X direction). As a result, wiring patterns formed by insulating materials, semiconductor materials, conductive materials, or the like for lines and electrodes for an electronic device appear on the substrate P.

A first storage device (first storage unit) BF1, which is capable of storing the substrate over a predetermined length, is disposed between the processing device PR2 and the processing device PR3, and a second storage device (second storage unit) BF2, which is capable of storing the substrate P over a predetermined length, is disposed between the processing device PR3 and the processing device PR4. Accordingly, the substrate P, which is delivered out from the processing device PR2 through the first storage device BF1, is transported into the processing device PR3, and the processing device PR3 sends the substrate P out through the second storage device BF2 to the processing device PR4. Processing devices PR1 to PR5 are disposed on installation surfaces of a manufacturing plant. Such installation surfaces may be surfaces provided on installation stands or on the floor. The processing device PR3, the first storage device (storage device, storage unit) BF1, and the second storage device (storage device, storage unit) BF2 collectively constitute a pattern forming device 12.

An upper level control device 14 controls the respective processing devices PR1 to PR5, the first storage device BF1, and the second storage device BF2 of the device manufacturing system 10. The upper level control device 14 includes a computer and a storage medium with programs stored therein, and by the computer executing the programs stored in the storage medium, the computer functions as the upper level control device 14 of the present first embodiment. It should be noted that, although the device manufacturing system 10 of the present first embodiment is provided with five processing devices PRs, it is sufficient if the device manufacturing system 10 is provided with two or more processing devices PRs. For example, the device manufacturing system 10 of the present first embodiment may be provided with a total of two processing devices PRs, which may be the processing devices PR2, PR3, or the processing devices PR3, PR4, or the device manufacturing system may be provided with a total of three processing devices PRs, which may be the processing devices PR2 to PR4.

Next, a description will be given concerning the substrate P that serves as a processing target of the device manufacturing system 10. As for the substrate P, for example, a resin film, foils made from metals such as stainless steel or alloys, and the like are used. As materials for the resin film, for example, a material containing one or two or more from among the following may be used: polyethylene resin, polypropylene resin, polyester resin, ethylene-vinyl copolymer resin, polychloride vinyl resin, cellulose resin, polyamide resin, polyimide resin, polycarbonate resin, polystyrene resin, vinyl acetate resin. Further, the thickness and hardness (Young's Modulus) of the substrate P should be within a range that does not produce creases or irreversible wrinkles due to buckling of the substrate P. In the case of making a flexible display panel, a touch panel, a color filter, an electromagnetic wave blocking filter or the like as an electronic device, a resin sheet of PET (polyethylene terephthalate) or PEN (polyethylene naphthalate) or the like with a thickness of 25 $\mu$m to 200 $\mu$m is used.

For example, in order to enable the deformation amount due to heat received from each process being implemented on the substrate P to be substantially disregarded, it is desirable to select a substrate P with a thermal expansion coefficient that is not significantly large. Further, on the resin film which serves as a base, when inorganic fillers such as titanium oxide, zinc oxide, alumina, silicon oxide, and the like are mixed therein, the thermal expansion coefficient can be lowered as well. Further, the substrate P may be a single layer body of ultra-thin glass with a thickness of approximately 100 $\mu$m manufactured by a float method or the like, or the substrate P may also be a stacked layer body in which the aforementioned resin film, or a metal layer (foil) of aluminum, copper or the like is laminated on such an ultra-thin glass.

Incidentally, the flexibility of the substrate P refers to a property whereby, even if a force of approximately its own weight is added thereto, no shearing or fracturing will occur, and the substrate P is capable of bending. Further, included therein is a property whereby the substrate is capable of curving under a force of approximately its own weight. Further, the degree of flexibility varies depending on the environment and the like, such as the material of the substrate P, the size and thickness thereof, the layer structure deposited on the substrate P, the temperature, the humidity, and the like. In any event, insofar as the substrate P can be conveyed smoothly, without creasing from buckling and without damage (the occurrence of tears or breaks) when the substrate P is correctly wound on members for conveying direction conversion, such as respective types of conveying rollers, rotation drums, and the like provided in the conveying path within the device manufacturing system 10 according to the present embodiment, the substrate P can be said to lie within the scope of flexibility.

The substrate P that is configured in the foregoing manner becomes the supply roll FR1 by being wound into a roll shape, and the supply roll FR1 is installed in the device manufacturing system 10. The device manufacturing system 10 in which the supply roll FR1 is installed sequentially executes various processes for manufacturing electronic devices with respect to the substrate P that is delivered out from the supply roll FR1. For this reason, on the substrate P after processing is performed thereon, device forming regions W in which a plurality of respective electronic devices are formed are contiguous with each other in the longitudinal direction with predetermined marginal regions (marginal portions) inserted therebetween. In other words, the substrate P that is delivered out from the supply roll FR1 is a multiple layout substrate.

The electronic device is configured with a plurality of pattern layers (multiple stacked layers with patterns formed thereon) which are stacked together within a predetermined error range. Although one pattern layer is produced by passing through the device manufacturing system 10 made up from the respective processing devices PR1 to PR5 shown in FIG. 1, in order to produce the electronic device having a multilayer structure, a plurality of the device manufacturing systems 10 shown in FIG. 1 are provided, and the substrate P is sequentially processed through the plurality of device manufacturing systems 10.

The substrate P after processing is performed thereon is collected in the form of the collection roll FR2 by being wound into a roll shape thereon. The collection roll FR2 may be installed in a non-illustrated dicing device. Such a dicing device in which the collection roll FR2 is installed separates (dices) the post-processed substrate P for each of respective electronic devices, thereby producing a plurality (sheets) of individual electronic devices. Concerning the dimensions of the substrate P, for example, the dimension in the widthwise direction (direction of the short dimension) is on the order of from 10 cm to 2 m, whereas the dimension in the length direction (direction in the longitudinal dimension) is greater than or equal to 10 m. It should be noted that the dimensions of the substrate P are not limited to the dimensions described above.

[Configuration of Processing Device PR2 (Film Forming Device)]

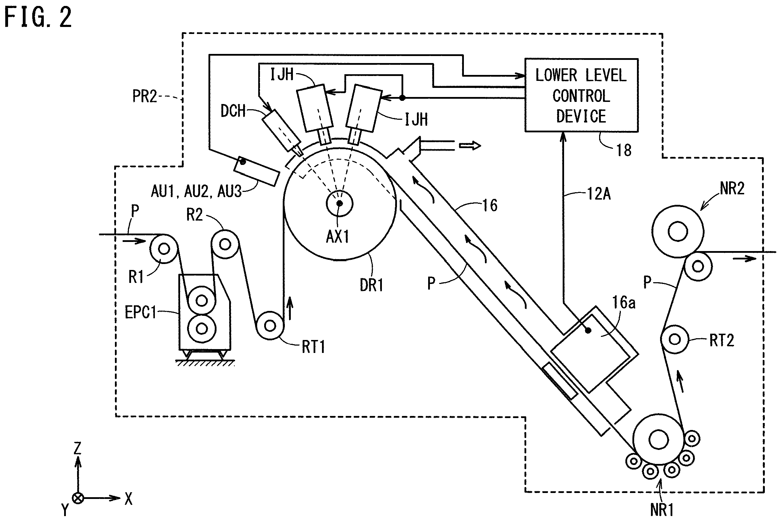

FIG. 2 is a diagram showing the configuration of the processing device PR2. The processing device PR2 is equipped with guide rollers R1, R2, an edge position controller EPC1, tension adjusting rollers RT1, RT2, a rotation drum DR1, drive rollers NR1, NR2, alignment microscopes AU, a die coater head (a die coater type of coating head) DCH, ink jet heads IJH, a drying device 16, and a lower level control device 18. The substrate P is conveyed by the rotation drum DR1 and the drive rollers NR1, NR2.

The guide roller R1 guides the substrate P, which is conveyed to the processing device PR2 from the processing device PR1, to the edge position controller EPC1. The edge position controller EPC1 has a plurality of rollers, and performs a control in a manner so that the positions of both end portions (edge portions) in the widthwise direction of the substrate P, which is conveyed in a state with a predetermined tension applied thereto, do not vary in the widthwise direction of the substrate P. More specifically, in the edge position controller EPC1, the substrate P is conveyed toward the guide roller R2 while the rollers that support the substrate P are moved in the widthwise direction and the position in the widthwise direction of the substrate P is adjusted in response to signals from a sensor that detects the position of the substrate P, so that the positions of the edge portions fall within a range (permissible range) of approximately from $\pm$ ten and several $\mu$m to tens of $\mu$m with respect to target positions in the widthwise direction of the edge portions. The guide roller R2 guides the substrate P, which has been conveyed thereto, to the rotary drum DR1. The edge position controller EPC1 adjusts the position in the widthwise direction of the substrate P, in a manner so that the longitudinal direction of the substrate P, which is conveyed onto the rotation drum DR1, remains orthogonal (without meandering) to the axial direction of a central axis AX1 of the rotation drum DR1.

The rotation drum DR1 includes the central axis AX1 which extends in the Y direction, and a cylindrically shaped outer peripheral surface having a fixed radius from the central axis AX1. The rotation drum DR1 conveys the substrate P in the +X direction by rotating about the central axis AX1, while supporting a portion of the substrate P along the outer peripheral surface (circumferential surface) in the longitudinal direction. The rotation drum DR1 supports, on the circumferential surface, regions (portions) on the substrate P that are imaged by the alignment microscopes AU, and regions (portions) on the substrate P that are subjected to processing by the die coater head DCH or the ink jet heads IJH.

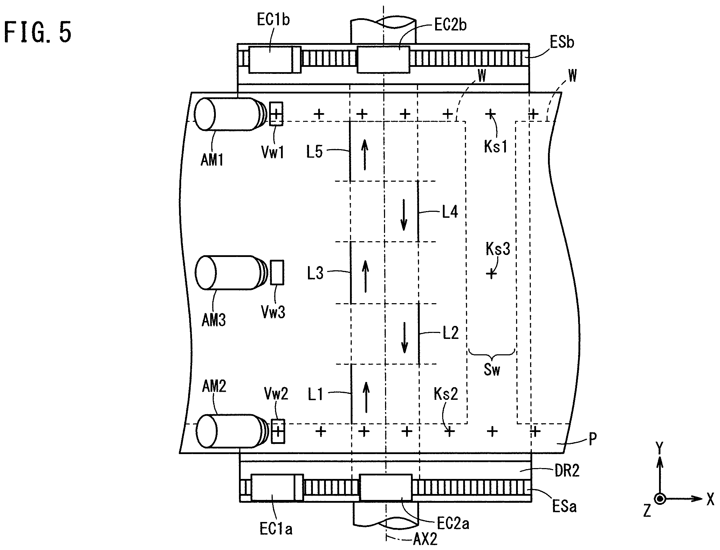

The alignment microscopes AU (AU1 to AU3) are operated to detect alignment marks (Ks1 to Ks3) formed on the substrate P as illustrated in FIG. 5, and three of such alignment microscopes AU are disposed along the Y direction. Detection regions of the alignment microscopes AU (AU1 to AU3) are arranged on a single line, so as to be aligned in the Y direction on the circumferential surface of the rotation drum DR1. The alignment marks Ks (Ks1 to Ks3) are standard marks used in order to relatively position (perform alignment) between the substrate P and the electronic device forming regions (device forming regions) W on the substrate P where the electronic devices are formed. The alignment marks Ks (Ks1 to Ks3), together with being formed at regular intervals along the longitudinal direction of the substrate P on both ends in the widthwise direction of the substrate P, are formed between the device forming regions W arranged along the longitudinal direction of the substrate P, as well as centrally in the widthwise direction of the substrate P. Light patterns corresponding to patterns such as circuits or wirings for the display panel are irradiated (exposed) on the device forming regions (pattern forming regions) W on the substrate P by the processing device PR3.

The alignment microscopes AU (AU1 to AU3) project illumination light for alignment unto the substrate P, and detect the alignment marks Ks (Ks1 to Ks3) by imaging the reflected light with image capturing elements such as CCD, CMOS, or the like. More specifically, the alignment microscope AU1 images the alignment marks Ks1 formed on the side edge in the +Y direction of the substrate P and existing within the detection region (imaging region) of the alignment microscope AU1. The alignment microscope AU2 images the alignment marks Ks2 formed on the side edge in the -Y direction of the substrate P and existing within the detection region of the alignment microscope AU2. The alignment microscope AU3 images the alignment marks Ks3 formed in the center in the widthwise direction of the substrate P and existing within the detection region of the alignment microscope AU3. The image data imaged by the alignment microscopes AU (AU1 to AU3) is transmitted to the lower level control device 18, whereupon, on the basis of the image data, the lower level control device 18 calculates (detects) the position and a position error of the alignment marks Ks (Ks1 to Ks3) on the substrate P. Although the size of the detection regions of the alignment microscopes AU (AU1 to AU3) on the substrate P is set according to the size and alignment precision of the alignment marks Ks (Ks1 to Ks3), the size thereof is on the order of 100 to 500 $\mu$m.

As illustrated in FIG. 5, the alignment marks Ks (Ks1 to Ks3) for accurately detecting the position of the substrate P are generally disposed at outer peripheral portions of the device forming regions (electronic device forming regions) W, however, the locations thereof do not necessarily have to be at the outer peripheral portions, and may be provided within the device forming region W, in a blank portion thereof where the circuit pattern for the device does not exist. Furthermore, an alignment system may be used in which patterns (partial patterns such as image pixel regions, wiring portions, electrode portions, terminal portions, or via holes) formed in specific positions taken from among portions of the circuit pattern formed in the device forming region W themselves are subjected to image recognition as alignment marks so as to detect the position.

The die coater head (die coater head unit, die coating head unit) DCH broadly and uniformly applies the photosensitive functional fluid with respect to the substrate P. The ink jet heads IJH selectively apply the photosensitive functional fluid with respect to the substrate P. The die coater head DCH and the ink jet heads IJH can selectively apply the photosensitive functional fluid to the substrate P based on the positions of the alignment marks Ks (Ks1 to Ks3) on the substrate P as detected using the alignment microscopes AU (AU1 to AU3). The die coater head DCH and the ink jet heads IJH apply the photosensitive functional fluid to the electronic device forming region W. The die coater head DCH and the ink jet heads IJH are provided on a downstream side (+X direction side) in the conveying direction of the substrate P with respect to the alignment microscopes AU (AU1 to AU3), and the ink jet heads IJH are provided on a downstream side (+X direction side) in the conveying direction of the substrate P with respect to the die coater head DCH. A plurality of the ink jet heads IJH are provided along the conveying direction (+X direction) of the substrate P. The region on the substrate P to which the photosensitive functional fluid is applied by the die coater head DCH and the ink jet heads IJH is supported by the circumferential surface of the rotation drum DR1.

The drying device 16 is provided on a downstream side (+X direction side) in the conveying direction of the substrate P with respect to the die coater head DCH and the ink jet heads IJH, and forms the photosensitive functional layer on the substrate P by drying the photosensitive functional fluid existing on the substrate P that was applied by the die coater head DCH and the ink jet heads IJH. The drying device 16 removes a solute (solvent or water) included in the photosensitive functional fluid by blowing drying air such as hot air or dry air in order to dry the photosensitive functional fluid.

A traditional photosensitive functional fluid is a photoresist, however, as for materials that do not require development processing, there may be considered photosensitive silane coupling agents (SAM) in which hydrophobic or hydrophilic properties of portions that are irradiated with ultraviolet rays are reformed, or photosensitive reducing agents in which a plating reduction group is exposed in portions that are irradiated with ultraviolet rays. When a photosensitive silane coupling agent is used as the photosensitive functional fluid, a pattern portion on the substrate P, which is exposed to ultraviolet rays, is reformed from being hydrophobic to hydrophilic. Therefore, a pattern layer can be formed by selectively applying a conductive ink (an ink containing conductive nanoparticles such as silver or copper), or a fluid body containing a semiconductor material, or the like. When a photosensitive reducing agent is used as the photosensitive fluid, a pattern portion on the substrate P, which is exposed to ultraviolet rays, is reformed, thereby exposing a plating reduction group. Therefore, after exposure thereof, the pattern layer is formed (precipitated) from palladium, by immediately immersing the substrate P in an electroless plating solution including palladium ions or the like for a set time. This sort of plating process is an additive process, however, apart therefrom, on the premise of an etching process as a subtractive process, the substrate P which is delivered to the processing device PR3 may have PET or PEN as a base material, with a metallic film such as aluminum (Al) or copper (Cu) deposited entirely or selectively on the surface thereof, and furthermore, a photoresist layer may be laminated thereon. According to the present first embodiment, a photoresist is used as the photosensitive functional layer.

In the drying device 16, a film thickness measuring device 16a is provided, which measures the processing quality such as the film thickness and a film-thickness unevenness of the photosensitive functional layer formed on the substrate P. The film thickness measuring device 16a performs the contact measurement or non-contact measurement of a film thickness according to an electromagnetic method, an overcurrent method, an overcurrent phase method, a fluorescent X-ray method, an electrical resistance method, a β-wave back scatter method, a magnetic method, an ultrasonic wave method, or the like. The substrate P with the photosensitive functional layer formed thereon is guided to the drive roller NR1 by the drying device 16. The drive roller NR1 guides the substrate P to the drive roller NR2 by being rotated while sandwiching both sides of the substrate P. The drive roller NR2 supplies the substrate P that was conveyed thereto by the drive roller NR1 to the first storage device BF1 by being rotated while sandwiching both sides of the substrate P. The tension adjusting roller RT1 is biased in the -Z direction, and applies a predetermined tension with respect to the substrate P that is conveyed to the rotation drum DR1. The tension adjusting roller RT2 is biased in the -X direction, and applies a predetermined tension with respect to the substrate P that is conveyed to the drive roller NR2. The drive rollers NR1, NR2 and the rotation drum DR1, which convey the substrate P, are rotated by applied rotational torques from rotary drive sources (omitted from illustration) each having a motor or speed reducer and the like and which are controlled by the lower level control device 18. The conveying speed of the substrate P inside the processing device PR2 is regulated by the rotational speeds of the drive rollers NR1, NR2 and the rotation drum DR1. Further, rotational speed signals (substrate P conveying speed signals), which are transmitted from non-illustrated encoders provided on the drive rollers NR1, NR2 and the rotation drum DR1, etc., are transmitted to the lower level control device 18.

The lower level control device 18 follows a control from the upper level control device 14, and controls the respective components of the processing device PR2. For example, the lower level control device 18 controls the conveying speed of the substrate P, which is conveyed inside the processing device PR2, the edge position controller EPC1, the alignment microscopes AU1 to AU3, the die coater head DCH, the ink jet heads IJH, and the drying device 16. Further, the lower level control device 18 outputs to the upper level control device 14 the position information of the alignment marks Ks (Ks1 to Ks3) on the substrate P that are detected by the alignment microscopes AU (AU1 to AU3), film thickness information detected by the film thickness measuring device 16a, and rotational speed information (conveying speed information of the substrate P inside the processing device PR2), and the like. The lower level control device 18 includes a computer and a storage medium with programs stored therein, and by the computer executing the programs stored in the storage medium, the computer functions as the lower level control device 18 of the present first embodiment. The lower level control device 18 may be provided as a portion of the upper level control device 14, or may be a separate control device apart from the upper level control device 14.

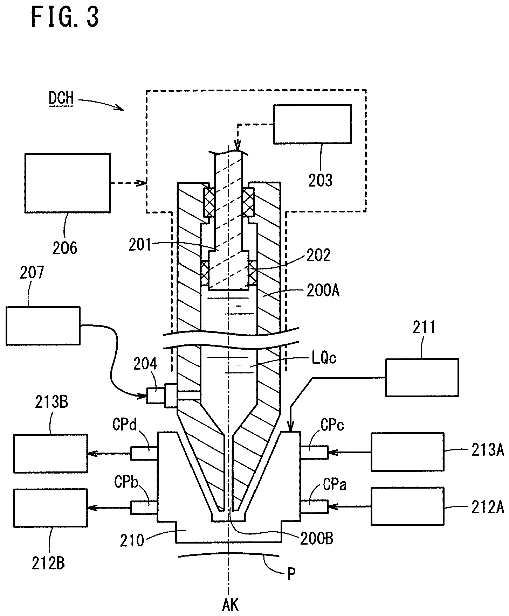

FIG. 3 is a partial cross-sectional view illustrating an example of the configuration of the die coater head DCH. The die coater head DCH is constituted by a head main body 200A in which a coating liquid LQc serving as the photosensitive functional liquid is stored, a slit portion 200B formed at the distal end of the head main body 200A to extend in the Y direction (the widthwise direction of the substrate P), a piston 201 that is capable of moving along an axis AK in order to push out the coating liquid LQc in the head main body 200A from the slit portion 200B, a packing 202 that provides a seal so as to prevent the coating liquid LQc from leaking out from between the inner wall of the head main body 200A and the piston 201, a driving unit 203 for pressing down the piston 201 along the axis AK at a time of coating, and a supply port 204 for supplying the coating liquid LQc into the head main body 200A. The entirety of the die coater head DCH is moved up and down along the axis AK by a vertical movement driving unit 206, in order to adjust the gap between the substrate P and the slit portion 200B during coating, or to largely retract the die coater head DCH away from the substrate P.

Since there is a limit to the capacity of the coating liquid LQc stored in the head main body 200A, after the piston 201 has been pressed down to a permissible position, then while the piston 201 is raised, a new coating liquid LQc is replenished from a coating liquid replenishing unit 207 through the supply port 204. During such a replenishing operation, the coating operation with respect to the substrate P is interrupted (conveyance of the substrate P is stopped or decelerated), and the die coater head DCH is moved slightly away from the substrate P by the vertical movement driving unit 206. A sensor (a linear encoder or the like) for measuring the movement amount of the piston 201 is provided in the driving unit 203, and measurement information therefrom is sequentially transmitted to the lower level control device 18 shown in FIG. 2.

Based on the movement amount of the piston 201, the lower level control device 18 calculates the amount of coating liquid LQc remaining in the head main body 200A, and on the basis of the calculated remaining amount of the coating liquid LQc and the set coating conditions (an extrusion speed of the piston 201, etc.), a time period (allowable continuous time period) during which the coating operation is capable of being continued, and a starting time (replenishment start time) until a next replenishing operation of the coating liquid LQc is started are sequentially predicted. Whether or not the replenishing operation of the coating liquid LQc is necessary is primarily determined by the lower level control device 18, however, information of the predicted allowable continuous time period and the replenishment starting time are also sent to the upper level control device 14 shown in FIG. 1, and the upper level control device 14 can instruct the lower level control device 18 to perform the replenishing operation in consideration of the operating state of the entire manufacturing line (in particular, the state of conveyance of the substrate P).

Further, according to the first embodiment, a cleaning unit 210 is provided that is inserted, when the head main body 200A is retracted upward, into a space formed between the head main body 200A and the substrate P (the rotating drum DR1) for cleaning the distal end (slit portion 200B) of the head main body 200A. In the cleaning unit 210, a cross-sectional shape of an inner wall in the XZ plane perpendicular to the Y axis is formed in a V-shape that matches with the cross-sectional shape of the distal end of the head main body 200A, and the cleaning unit 210 is movable (capable of being inserted and removed) in the Y direction by a driving unit 211. In the cleaning unit 210, there are provided an injection port CPa through which a cleaning liquid from a cleaning liquid supply unit 212A flows, and a discharge port CPb for discharging the cleaning liquid, which has passed through a gap between the distal end of the head main body 200A and the V-shaped inner wall of the cleaning unit 210, into a cleaning liquid recovery unit 212B. Furthermore, in the cleaning unit 210, there are provided an injection port CPc through which a gas flows from a gas supply unit 213A in order to dry the distal end of the head main body 200A after having been cleaned, and a discharge port CPd for discharging the gas, which has passed through the gap between the distal end of the head main body 200A and the V-shaped inner wall of the cleaning unit 210, into a gas recovery unit 213B. Moreover, the cleaning liquid supply unit 212A and the cleaning liquid recovery unit 212B are equipped with a function to adjust the flow rate of supply and discharge of the cleaning liquid, in a manner so that the cleaning liquid does not overflow from the V-shaped inner wall of the cleaning unit 210.

The cleaning and drying operation is instructed in accordance with a determination made by the lower level control device 18 of FIG. 2, each time that a fixed time period has elapsed in the coating operation. However, since it is necessary to take into consideration the operating state of the entire manufacturing line (in particular, the state of conveyance of the substrate P), whether or not the coating operation can be temporarily stopped after a predetermined time period is determined by the upper level control device 14 of FIG. 1, and in the case it is determined that the coating operation can be temporarily stopped, the cleaning and drying operation is initiated at the designated time. Further, in the case that an unevenness in film thickness or the like is measured by the film thickness measuring device 16a, it is desirable to immediately perform the cleaning and drying operation. However, in this case as well, the lower level control device 18 makes a request to the upper level control device 14 of FIG. 1 to the effect that an irregular cleaning and drying operation is required.

In accordance with the above-described configuration, the die coater head DCH of the present embodiment is capable of temporarily suspending the coating operation, and continuing with the coating operation after having replenished the coating liquid LQc. The replenishing operation of the coating liquid LQc can be performed in a relatively short time, for example, about 30 seconds. Further, when the replenishing operation is performed, the cleaning and drying operation by the cleaning unit 210 may be carried out at the same time. The cleaning and drying operation can also be performed in a comparatively short time, for example, about 60 seconds to 120 seconds. Furthermore, even if only the replenishing operation is performed, when the cleaning unit 210 is inserted between the distal end of the head main body 200A and the substrate P by largely pulling up the entirety of the die coater head DCH, it is possible to prevent the coating liquid LQc that leaks (leaks out) from the slit portion 200B during the replenishing operation, from falling down onto the substrate P. In such a case, the time required for the insertion and removal operation of the cleaning unit 210, as well as the time for moving the die coater head DCH up and down are required, but in both cases, the operations are completed in a short time period. The replenishing operation of the coating liquid LQc, and the cleaning and drying operation by the cleaning unit 210 are both additional operations to avoid a deterioration in the processing quality of the substrate P in the processing device PR2.

[Configuration of Pattern Forming Device 12 Including the Processing Device PR3]

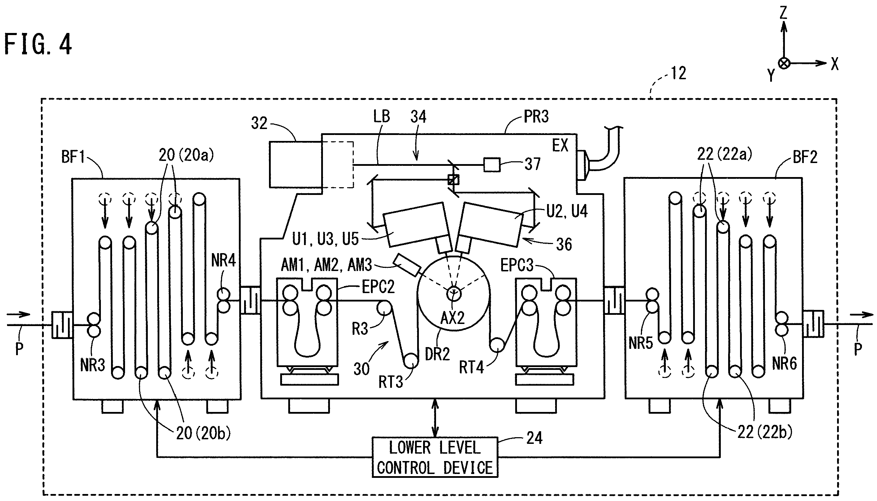

FIG. 4 is a diagram illustrating the configuration of the pattern forming device 12. The first storage device BF1 of the pattern forming device 12 includes drive rollers NR3, NR4, and a plurality of dancer rollers 20. The drive roller NR3 is rotated while sandwiching both front and back surfaces of the substrate P that was delivered thereto from the processing device PR2, and conveys the substrate P into the first storage device BF1. The drive roller NR4 is rotated while sandwiching both surfaces of the substrate P, and conveys the substrate P inside the first storage device BF1 to the processing device PR3. The plurality of dancer rollers 20 are provided between the drive roller NR3 and the drive roller NR4, and serve to apply a predetermined tension with respect to the substrate P. The plurality of dancer rollers 20 are capable of being moved in the Z direction. The upper side (+Z direction side) dancer rollers 20 (20a) are biased toward the side of the +Z direction, and the lower side (-Z direction side) dancer rollers 20 (20b) are biased toward the side of the -Z direction. The dancer rollers 20a and the dancer rollers 20b are alternately arranged in relation to the X direction.

If the conveying speed of the substrate P conveyed into the first storage device BF1 becomes comparatively fast relative to the conveying speed of the substrate P conveyed out from the first storage device BF1, the length (storage length) of the substrate P stored by the first storage device BF1 increases. As the storage length of the first storage device BF1 becomes longer, the dancer rollers 20a are moved in the +Z direction, and the dancer rollers 20b are moved in the -Z direction by the biasing forces applied thereto. Consequently, it is possible for the substrate P to be stored at a predetermined length, in a state in which a predetermined tension is applied to the substrate, even in the case that the storage capacity of the first storage device BF1 has increased. Conversely, if the conveying speed of the substrate P conveyed into the first storage device BF1 becomes comparatively slow relative to the conveying speed of the substrate P conveyed out from the first storage device BF1, the length (storage length) of the substrate P stored by the first storage device BF1 decreases. As the storage length of the first storage device BF1 decreases, the dancer rollers 20a are moved in the -Z direction, and the dancer rollers 20b are moved in the +Z direction in opposition to the biasing forces applied thereto. In either case, the first storage device BF1 is capable of storing the substrate P in a state in which a predetermined tension is applied to the substrate P. The drive rollers NR3, NR4 are rotated due to an applied rotational torque from rotary drive sources (omitted from illustration) each having a motor or speed reducer and the like and which are controlled by a lower level control device 24. The conveying speed of the substrate P that is conveyed into the first storage device BF1 is regulated by the speed of rotation of the drive roller NR3, whereas the conveying speed of the substrate P that is conveyed out from the first storage device BF1 is regulated by the speed of rotation of the drive roller NR4. Further, rotational speed signals that are transmitted from non-illustrated encoders provided on the drive rollers NR3, NR4 are transmitted to the lower level control device 24 of the pattern forming device 12.

The second storage device BF2 of the pattern forming device 12 includes drive rollers NR5, NR6, and a plurality of dancer rollers 22. The drive roller NR5 is rotated while sandwiching both surfaces of the substrate P that was delivered thereto from the processing device PR3, and conveys the substrate P into the second storage device BF2. The drive roller NR6 is rotated while sandwiching both surfaces of the substrate P, and conveys the substrate P inside the second storage device BF2 to the processing device PR4. The plurality of dancer rollers 22 are provided between the drive roller NR5 and the drive roller NR6, and serve to apply a predetermined tension with respect to the substrate P. The plurality of dancer rollers 22 are capable of being moved in the Z direction. The upper side (+Z direction side) dancer rollers 22 (22a) are biased toward the side of the +Z direction, and the lower side (-Z direction side) dancer rollers 22 (22b) are biased toward the side of the -Z direction. The dancer rollers 22a and the dancer rollers 22b are alternately arranged in relation to the X direction. With such a configuration, in the same manner as the first storage device BF1, the second storage device BF2 is capable of storing the substrate P in a state in which a predetermined tension is applied to the substrate P. Here, the first storage device BF1 and the second storage device BF2 have the same configuration. The drive rollers NR5, NR6 are rotated due to an applied rotational torque from rotary drive sources (omitted from illustration) each having a motor or speed reducer and the like and which are controlled by the lower level control device 24. The conveying speed of the substrate P that is conveyed into the second storage device BF2 is regulated by the speed of rotation of the drive roller NR5, whereas the conveying speed of the substrate P that is conveyed out from the second storage device BF2 is regulated by the speed of rotation of the drive roller NR6. Further, rotational speed signals that are transmitted from non-illustrated encoders provided on the drive rollers NR5, NR6 are transmitted to the lower level control device 24.

According to the present first embodiment, the processing device PR3 of the pattern forming device 12 is a direct drawing-type exposure device EX that does not use a mask, which is a so-called raster scanner-type exposure device, in which a light pattern is irradiated, in accordance with patterns for circuits or wiring and the like for a display (electronic device), with respect to the substrate P that is supplied from the processing device PR2 via the first storage device BF1. As examples of patterns for circuits or wiring for the display, there may be cited a TFT source electrode and a drain electrode for configuring a display along with a pattern for wiring and the like pertaining thereto, or a TFT gate electrode and a pattern for wiring and the like pertaining thereto. While the substrate P is conveyed in the X direction, the processing device PR3 performs drawing, exposure of the light pattern on the surface (photosensitive surface) of the substrate P, by way of high speed modulation (on/off) of a spotlight intensity in accordance with pattern data (drawing data), while one-dimensionally scanning a laser beam LB spotlight for exposure in a predetermined scanning direction (Y direction) on the substrate P. Stated otherwise, by conveying (secondarily scanning) the substrate P in the +X direction, and scanning (primarily scanning) the spotlight in the scanning direction (Y direction), the spotlight is scanned in two dimensions on the substrate P, and light energy (energy beams) corresponding to the pattern is irradiated onto the substrate P. This causes a latent image (reformed portion) corresponding to a predetermined pattern to be formed on the photosensitive functional layer. The pattern data may be stored in a storage medium of the lower level control device 24 of the pattern forming device 12, or may be stored in a storage medium of the upper level control device 14.

The processing device PR3 is equipped with a conveying unit 30, a light source device 32, a light introduction optical system 34, and an exposure head 36. The conveying unit 30 conveys the substrate P transported from the processing device PR2, via the first storage device BF1, and towards the processing device PR4. The conveying unit 30 includes, in this order from the upstream side (-X direction side) along the conveying direction of the substrate P, an edge position controller EPC2, a guide roller R3, a tension adjusting roller RT3, a rotation drum DR2, a tension adjusting roller RT4, and an edge position controller EPC3.

Similar to the edge position controller EPC1, the edge position controller EPC2 includes a plurality of rollers, whereby the substrate P is conveyed toward the rotation drum DR2 while the substrate P is moved in the widthwise direction and the position of the substrate P in the widthwise direction is corrected so as to keep the positions of both ends (edges) in the widthwise direction of the substrate P within a range (permissible range) of approximately from ± ten and several μm to tens of μm with respect to target positions therefor, so that there is no fluctuation in the widthwise direction of the substrate P. The edge position controller EPC2 adjusts the position in the widthwise direction of the substrate P, in a manner so that the longitudinal direction of the substrate P that is conveyed onto the rotation drum DR2 remains orthogonal (without meandering) to the axial direction of a central axis AX2 of the rotation drum DR2. The guide roller R3 guides the substrate P that has been conveyed thereto from the edge position controller EPC2, to the rotary drum DR2.

As shown in FIG. 5, the rotation drum DR2 includes the central axis AX2 which extends in the Y direction, and a cylindrically shaped outer peripheral surface having a fixed radius from the central axis AX2. The rotation drum DR2 conveys the substrate P in the +X direction by rotating about the central axis AX2, while supporting a portion of the substrate P in the longitudinal direction along the outer peripheral surface (circumferential surface). The rotation drum DR2 supports, on the circumferential surface thereof, a portion (exposure region) on the substrate P where the light pattern is exposed.

Similar to the edge position controller EPC1, the edge position controller EPC3 includes a plurality of rollers, whereby the substrate P is conveyed toward the processing device PR4 while the substrate P is moved in the widthwise direction and the position of the substrate P in the widthwise direction is corrected so as to keep the positions of both ends (edges) in the widthwise direction of the substrate P within a range (permissible range) of approximately from ± ten and several μm to tens of μm with respect to target positions therefor, so that there is no fluctuation in the widthwise direction of the substrate P. The tension adjusting rollers RT3, RT4 are biased in the -Z direction, and apply a predetermined tension to the substrate P that is wound around and supported by the rotation drum DR2. The rotation drum DR2 is rotated due to an applied rotational torque from a rotary drive source (omitted from illustration) having a motor or speed reducer and the like, and which is controlled by the lower level control device 24. The conveying speed of the substrate P inside the processing device PR3 is regulated by the rotational speed of the rotation drum DR2. Measurement information such as rotational speed signals (substrate P conveying speed signals) and a conveyance movement amount and the like, which are transmitted from an encoder system provided on the rotary drum DR2 or the like, is transmitted to the lower level control device 24.

As shown in FIG. 5, the encoder system is disposed on both end sides in the direction (Y direction) of the central axis AX2 of the rotation drum DR2, and is constituted by scale members (scale disks) ESa, ESb for measuring a rotation angle position of the rotary drum DR2, or a movement amount in the circumferential direction of the outer peripheral surface (surface of the substrate P) of the rotation drum DR2, and reading heads EC1a, EC1b, EC2a, EC2b for reading diffraction grating shaped scale markings inscribed on the scale members ESa, ESb. The arrangement relationship between the scale members ESa, ESb and the respective reading heads EC1a, EC1b, EC2a, EC2b is explained in detail, for example, in International Publication No. WO 2013/146184, and therefore, a simplified explanation thereof will be presented herein.

The conveying distance and the conveying speed of the substrate P are obtained from the measurement results of the encoder system, which is constituted by the scale members ESa, ESb and the respective reading heads EC1a, EC1b, EC2a, EC2b. Further, the encoder system is used to obtain exposure positions of the device forming regions W of the devices (patterns), and the positions of marginal portions Sw on the substrate P shown in FIG. 5, from the detected positions of the alignment marks Ks1 to Ks3 of the substrate P as detected by the alignment microscopes AM1 to AM3. Furthermore, the encoder system is also used for position management of the rotation drum DR2 during a calibration operation, or for position management of the rotation drum DR2 when conveyance of the substrate P is temporarily reversed.

The light source device 32 includes a laser light source, and emits an ultraviolet ray laser beam (irradiating light, an exposure beam) LB used in exposure. The laser beam LB may be ultraviolet light having a peak wavelength in a wavelength band of 370 nm or less. The laser beam LB may be pulsed light generated at a given light-generation frequency Fs. The laser beam LB that is emitted from the light source device 32 is guided to the light introduction optical system 34, and together with being incident on the exposure head 36, is incident on an intensity sensor 37. The intensity sensor 37 is a sensor adapted to detect the intensity of the laser beam LB.

The exposure head 36 is equipped with a plurality of drawing units U (U1 to U5), with the laser beam LB from the light source device 32 being made incident on each of the drawing units U (U1 to U5). More specifically, the laser beam LB from the light source device 32 is guided by the light introduction optical system 34, which includes reflective mirrors or beam splitters and the like, and is made incident on the plurality of drawing units U (U1 to U5). The exposure head 36 carries out drawing, exposure of patterns on a portion of the substrate P, which is supported by the circumferential surface of the rotation drum DR2, through the plurality of drawing units U (U1 to U5). The exposure head 36 includes the plurality of drawing units U (U1 to U5) of the same configuration, and is referred to as a so-called multi-beam type exposure head 36. The drawing units U1, U3, U5 are disposed on an upstream side (-X direction side) in the conveying direction of the substrate P with respect to the central axis AX2 of the rotation drum DR2, whereas the drawing units U2, U4 are disposed on a downstream side (+X direction side) in the conveying direction of the substrate P with respect to the central axis AX2 of the rotation drum DR2.

Each of the drawing units U causes the incident laser beam LB to converge on the substrate P in the form of a spotlight, and scans the spotlight along a scanning line. As illustrated in FIG. 5, the scanning lines L of the respective drawing units U are not mutually separated in relation to the Y direction (the widthwise direction of the substrate P), but are set so as to be joined together. In FIG. 5, the scanning line L of the drawing unit U1 is represented by L1, and the scanning line L of the drawing unit U2 is represented by L2. Similarly, the scanning lines L of the drawing units U3, U4, U5 are represented by L3, L4, L5. In this manner, each of the drawing units is allotted a scanning region, in a manner so that the entire widthwise direction of the device forming region W is covered by all of the drawing units U1 to U5. For example, if the drawing width (length of the scanning line L) in the Y direction of one drawing unit U is about 20 to 50 mm, the width of the Y direction in which drawing can be carried out will be approximately 100 to 250 mm, by disposing the three odd-numbered drawing units U1, U3, U5 and the two even-numbered drawing units U2, U4, making up a total of five drawing units U, in the Y direction.

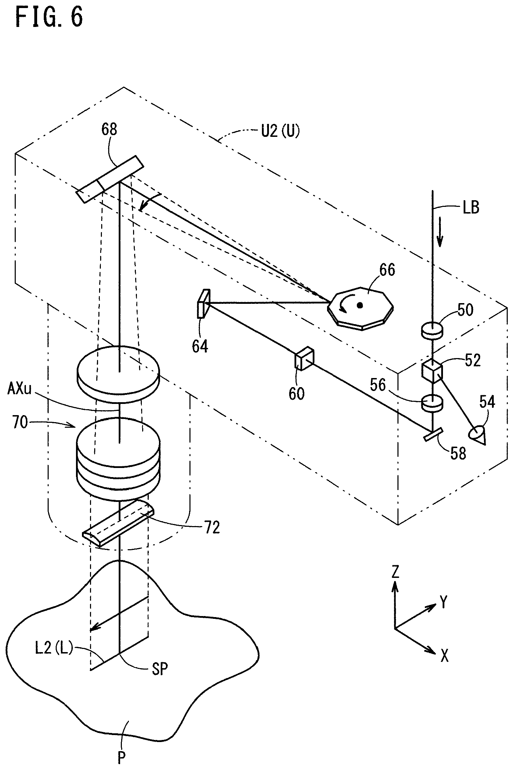

Next, with reference to FIG. 6, a description will be given concerning the drawing units U. Since the respective drawing units U (U1 to U5) are of the same configuration, only the drawing unit U2 will be described, and descriptions of the other drawing units U will be omitted.

As shown in FIG. 6, the drawing unit U2, for example, includes a condensing lens 50, an optical element for drawing (optical modulation element) 52, an absorber 54, a collimating (collimator) lens 56, a reflective mirror 58, a cylindrical lens 60, a reflective mirror 64, a polygon mirror (light scanning member) 66, a reflective mirror 68, an f-θ lens 70, and a cylindrical lens 72.

The laser beam LB incident on the drawing unit U2 progresses from the upper direction in a vertical direction toward the lower direction (-Z direction), and is made incident on the optical element for drawing 52 via the condensing lens 50. The condensing lens 50 causes the laser beam LB incident on the optical element for drawing 52 to condense (converge) so that the laser beam LB becomes a beam waist within the optical element for drawing 52. The optical element for drawing 52 exhibits transparency in relation to the laser beam LB, and for example, an acoustic optical modulator element (AOM: Acousto-Optic Modulator) is used therefor.

When a drive signal (high frequency signal) from the lower level control device 24 is in an OFF state, the optical element for drawing 52 causes the incident laser beam LB to proceed toward the absorber 54, and when the drive signal (high frequency signal) from the lower level control device 24 is in an ON state, the optical element for drawing 52 causes the incident laser beam LB to be refracted and proceed toward the reflective mirror 58. The absorber 54 is a light trap that absorbs the laser beam LB in order to suppress leakage of light from the laser beam LB to the exterior. In this manner, switching of the laser beam LB is carried out so as to proceed toward the reflective mirror 58 or to proceed toward the absorber 54 by high speed ON/OFF switching of drive signals (ultrasonic wave frequency) for drawing, which are to be impressed on the optical element for drawing 52, in accordance with (black and white) pattern data. This implies that, when observing the substrate P from above, the intensity of the laser beam LB (spotlight SP) that reaches the photosensitive surface can be modulated at high speed, to either one of a high level or a low level (for example, a zero level) in accordance with the pattern data.

The collimating lens 56 makes the laser beam LB, which proceeds toward the reflective mirror 58 from the optical element for drawing 52, into parallel light. The reflective mirror 58 reflects the incident laser beam LB in the -X direction, and leads the laser beam LB to the reflective mirror 64 via the cylindrical lens 60. The reflective mirror 64 irradiates the polygon mirror 66 with the incident laser beam LB. By being rotated, the polygon mirror (rotating multi-surfaced mirror) 66 continuously changes the reflection angle of the laser beam LB, and moves, in the scanning direction (the widthwise direction of the substrate P), the position of the laser beam LB irradiating the substrate P. The polygon mirror 66 is rotated at a constant speed by a non-illustrated rotary drive source (for example, a motor or speed reducer and the like) controlled by the lower level control device 24. Further, a rotational speed signal (spotlight SP scanning speed signal) that is transmitted from a non-illustrated encoder provided on the polygon mirror 66 is transmitted to the lower level control device 24.

The cylindrical lens 60, which is disposed between the reflective mirror 58 and the reflective mirror 64, condenses (converges) the laser beam LB on the reflective surface of the polygon mirror 66, in relation to a non-scanning direction (Z direction), which is orthogonal to the scanning direction. Even in the case that, due to the cylindrical lens 60, the reflective surface is inclined with respect to the Z direction (inclined from a balanced state between the normal line to the XY surface and the reflective surface), the influence thereof can be suppressed, thereby suppressing a deviation toward the X direction of the irradiation position of the laser beam LB that irradiates the substrate P.

The laser beam LB reflected by the polygon mirror 66 is reflected in the -Z direction by the reflective mirror 68, and is made incident on the f-θ lens 70 having an optical axis AXu parallel to the Z axis. The f-θ lens 70 is a telecentric optical system in which a principal light beam of the laser beam LB that is projected onto the substrate P is at all times a normal line to the surface of the substrate P during scanning, thereby making it possible to move the laser beam LB accurately and at a consistent speed in the Y direction. The laser beam LB from the f-θ lens 70 becomes a microscopic spotlight SP with a substantially circular shape having a diameter on the order of several μm (for example, 3 μm), and is irradiated onto the substrate P via the cylindrical lens 72 with the generatrix thereof being parallel to the Y direction. The spotlight (scanning spotlight) SP is moved one dimensionally by the polygon mirror 66 in a direction along the scanning line L2 that extends in the Y direction.

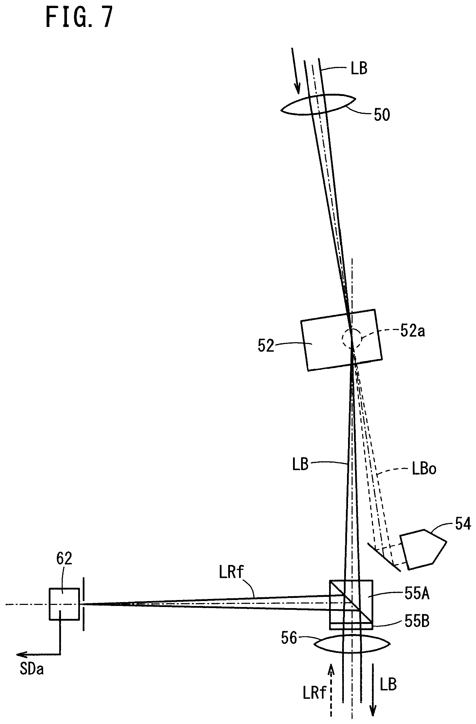

FIG. 7 is a diagram showing an arrangement of a reflected light monitoring system provided in the drawing unit U (U1 to U5) of FIG. 6. The laser beam LB of linearly polarized light passing through the condensing lens 50 is converged by the condensing lens 50 in a manner so as to become a beam waist at a deflection unit 52a of the optical element for drawing (AOM) 52, and when the drive signal (high frequency signal) is in an OFF state, a 0th order beam LB0 passing straight through the deflection unit 52a is absorbed by the absorber (light trap) 54. When the drive signal (high frequency signal) is in an ON state, the laser beam LB, which is deflected as 1st order diffracted light by the deflection unit 52a, is transmitted through a polarizing beam splitter 55A and a quarter-wavelength plate 55B so as to become circularly polarized light, which is made incident on the collimating lens 56 and is shaped again into a parallel light flux. The laser beam LB that has passed through the collimating lens 56 passes through the reflecting mirror 58, the cylindrical lens 60, the reflecting mirror 64, the polygon mirror 66, the reflecting mirror 68, the f-θ lens 70, and the cylindrical lens 72 shown in FIG. 6, and irradiates the substrate P (rotation drum DR2).

Reflected light (specularly reflected light, scattered light, etc.) is generated from the irradiation position of the spotlight SP in accordance with the reflectance of the surface of the substrate P (or the rotation drum DR2) that is irradiated by the spotlight SP of the laser beam LB. Since the f-θ lens 70 is telecentric in a manner so that the principal light beam of the laser beam LB emitted from the f-θ lens 70 is made perpendicular to the surface of the substrate P (rotation drum DR2), from among the reflected light, specularly reflected light is made incident from the cylindrical lens 72, reverses the optical path of the laser beam LB, and returns to the collimating lens 56. As shown in FIG. 7, the specularly reflected light LRf that has returned to the collimating lens 56 is converted by the quarter-wavelength plate 55B from circularly polarized light into linearly polarized light, is reflected by the polarizing beam splitter 55A, and reaches a light receiving unit 62. A light receiving surface of the light receiving unit 62 is arranged so as to be optically conjugate with the surface of the substrate P, and the light receiving unit 62 is equipped with a photoelectric element such as a PIN photodiode, which outputs a photoelectric signal SDa corresponding to the light intensity of the specularly reflected light Lrf on the light receiving surface.

The reflected light monitoring system, which is constituted by the polarizing beam splitter 55A (quarter-wavelength plate 55B) and the light receiving unit 62, when scanned with the spotlight SP so as to traverse the reference patterns (reference marks) formed on the rotation drum DR2, photoelectrically detects a change in intensity of the specularly reflected light generated from the reference patterns, and monitors the inclination of the scanning line L2 (L) and the scanning position of the spotlight SP with reference to the reference patterns of the rotation drum DR2. Consequently, it is possible to calibrate (perform calibration of) variations in the relative positional relationship of the pattern drawing positions by each of the drawing units U1 to U5 (fluctuations in jointing accuracy or the like), the relative positional relationship between the mark detection positions (detection regions Vw1 to Vw3) by the alignment microscopes AM1 to AM3 shown in FIG. 5 and the respective positions of the scanning lines L1 to L5, that is, variations of so-called baselines. Concerning the reference patterns formed on the rotation drum DR2 and the calibration, details thereof are disclosed in International Publication No. WO 2014/034161, and therefore, detailed explanation of these features is omitted herein. Further, in the reflected light monitoring system shown in FIG. 7, in the case that the reflectance of the reference patterns (or the outer peripheral surface of the rotation drum DR2) is of a known value, then based on measurement of the amount of reflected light (the intensity of the photoelectric signal SDa), it is possible to estimate the intensity (illuminance) of the spotlight SP. Therefore, the amount of exposure imparted by each of the drawing units U1 to U5 to the substrate P or differences in the amount of exposure between the drawing units U1 to U5 when patterns are drawn can be determined. The calibration operation (measurement operation) of the baseline variation, and the measurement operation of the exposure amount, as described above, can be said to be additional operations for preventing deterioration in processing quality of the exposure device EX.

Further, as shown in FIGS. 4 and 5, the processing device PR3 is provided with the three alignment microscopes AM (AM1 to AM3) for detecting the alignment marks Ks (Ks1 to Ks3). The detection regions Vw (Vw1 to Vw3) of the alignment microscopes AM (AM1 to AM3) are arranged on a single line, so as to be aligned in the Y-axis direction on the circumferential surface of the rotation drum DR2. The alignment microscopes AM (AM1 to AM3) project illumination light for alignment unto the substrate P, and detect the alignment marks Ks (Ks1 to Ks3) by imaging the reflected light with image capturing elements such as CCD, CMOS, or the like. More specifically, the alignment microscope AM1 images the alignment marks Ks1 formed on the side edge in the +Y direction of the substrate P and existing within the detection region (imaging region) Vw1. The alignment microscope AM2 images the alignment marks Ks2 formed on the side edge in the -Y direction of the substrate P and existing within the detection region Vw2. The alignment microscope AM3 images the alignment marks Ks3 formed in the center in the widthwise direction of the substrate P and existing within the detection region Vw3.

The image data imaged by the alignment microscopes AM (AM1 to AM3) is transmitted to an image processing unit provided in the lower level control device 24, whereupon, on the basis of the image data, the image processing unit of the lower level control device 24 calculates (detects) the position and a position error of the alignment marks Ks (Ks1 to Ks3). Although the size of the detection regions Vw (Vw1 to Vw3) on the substrate P is set according to the size and alignment precision of the alignment marks Ks (Ks1 to Ks3), the size thereof is on the order of 100 to 500 $\mu$m. Further, the illumination light for alignment is light of a wavelength region that is for the most part non-sensitive with respect to the photosensitive functional layer on the substrate P, and for example, is broadband light having a wavelength width on the order of 500 to 800 nm, or white light that does not include wavelengths in the ultraviolet region, or the like.

The lower level control device 24 follows the control of the upper level control device 14, and controls the respective components of the first storage device BF1, the second storage device BF2, and the processing device PR3, which make up the pattern forming device 12. For example, the lower level control device 24 controls the conveying speed of the substrate P that is conveyed inside the processing device PR3, the edge position controllers EPC2, EPC3, the alignment microscopes AM1 to AM3, the light source device 32, rotation of the polygon mirror 66, and the optical element for drawing 52, etc. Further, the lower level control device 24 outputs to the upper level control device 14 the position information of the alignment marks Ks (Ks1 to Ks3) on the substrate P as detected by the alignment microscopes AM (AM1 to AM3), rotational speed information (conveying speed information of the substrate P inside the processing device PR3, scanning speed information of the spotlight SP), and intensity information of the laser beam LB as detected by the intensity sensor 37, and the like. The lower level control device 24 includes a computer and a storage medium with programs stored therein, and by the computer executing the programs stored in the storage medium, the computer functions as the lower level control device 24 of the present first embodiment. The lower level control device 24 may be provided as a portion of the upper level control device 14, or may be a separate control device apart from the upper level control device 14.

[Configuration of Processing Device PR4 (Wet Processing Device)]

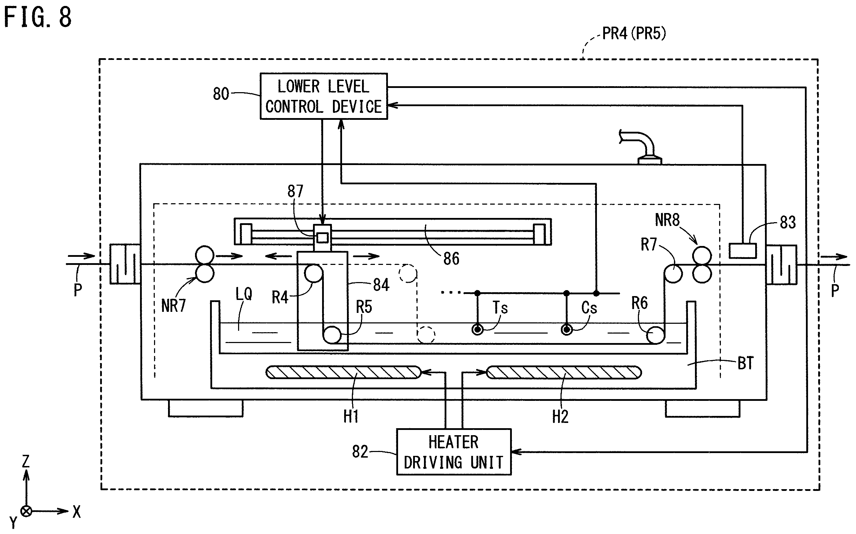

FIG. 8 is a diagram showing the configuration of the processing device PR4. The processing device PR4 includes a processing tank BT with a developing solution LQ stored therein, guide rollers R4 to R7, which form a conveying path for the substrate P so that the substrate P is immersed in the developing solution LQ that is stored in the processing tank BT, drive rollers NR7, NR8, and a lower level control device 80. In the bottom of the processing tank BT, heaters H1, H2 are provided in order to adjust the temperature of the developing solution LQ. The heaters H1, H2 are driven to generate heat by a heater driving unit 82 under the control of the lower level control device 80.

The drive roller NR7 guides the substrate P to the guide roller R4 by being rotated while sandwiching both surfaces of the substrate P that is fed out from the processing device PR3 via the second storage device BF2. The guide roller R4 bends the substrate P, which was conveyed thereto in the +X direction, toward the side of the -Z direction, and guides the substrate P to the guide roller R5. The guide roller R5 bends the substrate P, which was conveyed thereto in the -Z direction, toward the side of the +X direction, and guides the substrate P to the guide roller R6. The guide roller R6 bends the substrate P, which was conveyed thereto in the +X direction, toward the side of the +Z direction, and guides the substrate P to the guide roller R7. The guide roller R7 bends the substrate P, which was conveyed thereto in the +Z direction, toward the side of the +X direction, and guides the substrate P to the drive roller NR8. The drive roller NR8 is rotated while sandwiching both surfaces of the substrate P that was delivered thereto, and conveys the substrate P into the processing device PR5. The substrate P is immersed in the developing solution LQ by the guide rollers R5, R6. The drive rollers NR7, NR8 are rotated due to an applied rotational torque from rotary drive sources (omitted from illustration) each having a motor or speed reducer and the like and which are controlled by a lower level control device 80. The conveying speed of the substrate P inside the processing device PR4 is regulated by the rotational speeds of the drive rollers NR7, NR8. Further, rotational speed signals (substrate P conveying speed signals), which are transmitted from non-illustrated encoders provided on the drive rollers NR7, NR8, are transmitted to the lower level control device 80. Moreover, an imaging device (a microscope camera or the like) 83, which images the developed surface of the substrate P, is provided within the processing device PR4. The imaging device 83 is provided on a downstream side (+X direction side) in the conveying direction of the substrate P with respect to the drive roller NR8. The imaging device 83 enlarges and captures a portion of the pattern for the device that is formed on the photosensitive functional layer by development thereof.

The guide rollers R4, R5 are provided on a movable member 84. The movable member 84 includes a driving unit such as a linear motor, and is capable of being moved in the X direction along a guide rail 86. A position sensor 87 is disposed on the movable member 84 for detecting the position of the movable member 84 in the X direction. Position information of the movable member 84, which is detected by the position sensor 87, is transmitted to the lower level control device 80. When the movable member 84 is moved along the guide rail 86 toward the side of the -X direction, the distance between the guide rollers R5, R6 becomes longer, and therefore, the time that the substrate P remains immersed in the developing solution LQ (immersion time) is made longer. Further, when the movable member 84 is moved toward the side of the +X direction, the distance between the guide rollers R5, R6 becomes shorter, and therefore, the time that the substrate P remains immersed in the developing solution LQ (immersion time) is made shorter. In this manner, it is possible to adjust the time (length of contact with the fluid) during which the substrate P is immersed in the developing solution LQ.

Further, the processing device PR4 has a temperature sensor Ts that detects the temperature of the developing solution LQ, and a concentration sensor Cs that detects the concentration of the developing solution LQ. By immersing the substrate P in the developing solution LQ, patterns are formed in the photosensitive functional layer in accordance with the latent image (reformed portions) formed in the photosensitive functional layer. When the photosensitive functional layer is a positive type photoresist, the portions irradiated with ultraviolet rays are reformed, and the reformed portions are dissolved and removed by the developing solution LQ. Further, when the photosensitive functional layer is a negative type photoresist, the portions irradiated with ultraviolet rays are reformed, and the non-reformed portions that were not irradiated with ultraviolet rays are dissolved and removed by the developing solution LQ. According to the present first embodiment, the photosensitive functional layer is described as being of a positive type. Moreover, although not shown, the processing device PR4 may have, for the substrate P that is conveyed from the processing device PR5, a cleaning and drying mechanism for removing the developing solution LQ adhered to the substrate P with pure water or the like.

Furthermore, the guide rollers R5, R6 of the processing device PR4 are equipped with a mechanism that is movable in the Z direction by driving a motor, and as shown in FIG. 8, is capable of switching between the state in which the substrate P is immersed in the developing solution LQ, and the state in which the substrate P is pulled up from the developing solution LQ. In accordance with this feature, in the case that the entire manufacturing line is stopped due to a malfunction (failure) of the processing device PR4, or is temporarily suspended for a short time in order to adjust the processing device PR4, the development process performed on the substrate P can be promptly interrupted, and a deterioration or the like of the developing solution LQ due to immersion of the substrate P in the developing solution LQ over a prolonged time period can be reduced.

The lower level control device 80 follows a control from the upper level control device 14, and controls the respective components of the processing device PR4. For example, the lower level control device 80 controls the conveying speed of the substrate P that is conveyed inside the processing device PR4, the heater driving unit 82, the movable member 84, the move of the guide rollers R5, R6 along the Z direction, and the like. Further, the lower level control device 80 outputs to the upper level control device 14 temperature information and concentration information of the developing solution as detected by the temperature sensor Ts and the concentration sensor Cs, the position information of the movable member 84 as detected by the position sensor 87, the image data detected by the imaging device 83, and rotational speed information (conveying speed information of the substrate P inside the processing device PR4), and the like. The lower level control device 80 includes a computer and a storage medium with programs stored therein, and by the computer executing the programs stored in the storage medium, the computer functions as the lower level control device 80 of the present first embodiment. The lower level control device 80 may be provided as a portion of the upper level control device 14, or may be a separate control device apart from the upper level control device 14.

Moreover, in the case that the photosensitive functional layer is a silane coupling agent or a photosensitive reducing agent, then within the processing tank BT of the processing device PR4, instead of the developing solution LQ, for example, there may be stored a non-electrolytic plating solution (hereinafter also referred to simply as a plating solution) containing a material (metal) for an electronic device such as palladium ions or the like. Stated otherwise, in this case, the processing device PR4 is a plating device, which performs a plating processing step (third processing step). By immersing the substrate P in the plating solution, plating nuclei (metallic palladium) are precipitated in accordance with the latent image (reformed portions) formed in the photosensitive functional layer. Furthermore, by the additional electrolytic or non-electrolytic plating process, when metal materials (NiP, Cu, Au, etc.) are deposited on the plating nuclei, a metallic layer (conductive) pattern is formed on the substrate P.

Basically, the processing device PR5 for performing etching has the same configuration as that of the processing device PR4, and therefore is not shown. However, an etching solution (corrosive fluid) is stored in the processing tank BT instead of the developing solution LQ. Accordingly, when the movable member 84 of the processing device PR5 is moved to the side of the -X direction, the time that the substrate P remains immersed in the etching solution (immersion time) is lengthened, whereas when the movable member 84 is moved to the side of the +X direction, the time that the substrate P remains immersed in the etching solution (immersion time) is made shorter. Further, the temperature of the etching solution is detected by a temperature sensor Ts of the processing device PR5, and the concentration of the etching solution is detected by a concentration sensor Cs. By the substrate P being immersed in the etching solution by the processing device PR5, a metallic thin film (Al or Cu or the like) formed in a lower layer of the photosensitive functional layer is etched using the photosensitive functional layer having a pattern thereon as a mask. As a result, a pattern of the metal layer appears on the substrate P. An imaging device 83 of the processing device PR5 captures an image of the pattern of the metal layer that was formed on the substrate P by etching. The substrate P for which processing was performed thereon by the processing device PR5 may be delivered to another processing device PR that carries out a subsequent process thereon. In the case that a plating process is performed by the processing device PR4, the etching process becomes unnecessary, and therefore, another processing device PR, for example, a processing device for performing cleaning and drying or the like, is provided instead of the processing device PR5.

[Operations of First Embodiment]

The setting conditions for each of the processing devices PR1 to PR5 are preset so that the states of the actual processes (actual processing) implemented by each of the processing devices PR1 to PR5 become target processing states. The setting conditions of each of the processing devices PR1 to PR5 may be stored in a non-illustrated storage medium provided respectively in each of the processing devices PR1 to PR5, or may be stored in a non-illustrated storage medium of the upper level control device 14. Further, in the device manufacturing system 10, it is assumed that the substrate P is conveyed at a constant speed, and the conveying speed condition from among the setting conditions set in each of the processing devices PR1 to PR5 is essentially the same specified speed Vpp (for example, a constant speed in a range of 5 mm/second to 50 mm/second). In order to maintain the quality of the patterns for the electronic devices formed on the substrate P, in addition to dynamically adjusting only the processing conditions for the substrate P from among the setting conditions set for each of the processing devices PR1 to PR5, by making it possible to individually adjust the conveying speed condition of the substrate P in each of the processing devices, line management is made possible so as not to require stoppage of the entire manufacturing line (device manufacturing system 10) while maintaining the quality of the patterns. Details concerning such line management will be described in a later embodiment.

In each of the processing devices PR2 to PR4 (PR5) shown in FIGS. 2, 4 and 8, occasionally, processing with respect to the substrate P is suspended, and it is desirable to perform an additional operation (measurement operation, adjustment operation, switching operation, cleaning operation, maintenance operation, etc.) for preventing a deterioration in processing quality (maintaining performance) in certain cases. For example, in the film forming device (coating device) that serves as the processing device PR2, a replenishing operation of the coating liquid (photosensitive functional fluid) supplied to the die coater head DCH and the ink jet heads IJH, a cleaning operation of the rotation drum DR1 and the nozzles of the heads DCH, IJH, or an exchanging/switching operation of the heads DCH, IJH is performed in certain cases. In the exposure device EX that serves as the processing device PR3, cases exist in which a calibration operation of measuring the variation of the relative positional relationship (baseline length) between exposure positions of the pattern (the scanning lines L1 to L5 by the scanning of the spotlight SP) and the detection regions Vw1 to Vw3 of the alignment microscopes AM1 to AM3, and of measuring the intensity (illuminance) of the spotlight SP that reaches the substrate P (rotation drum DR2), and a switching operation of switching to a spare light source device that was additionally installed in advance on the assumption that the light source device 32 (laser light source, UV lamp, etc.) will be replaced upon deterioration thereof are performed. Furthermore, in the wet processing device that serves as the processing device PR4 (PR5), a maintenance operation of refreshment or replacement in order to suppress decrease in the concentration of the developing solution LQ or the plating solution or a deterioration of the developing solution LQ or the plating solution due to oxidation, or a cleaning operation for removing fine dust in the processing tanks (liquid tank) BT in which the developing solution LQ and the plating solution are stored is performed in certain cases.

In the case that operation of such additional procedures can be completed in a relatively short time period, in the processing devices PR2 to PR4 (PR5), processing of the substrate P is temporarily suspended at an appropriate timing, and it is possible to implement the additional operations and resume processing of the substrate P after completion of the additional operations, returning to normal operation. In this case, in the processing devices in which additional operations are implemented, conveyance of the substrate P is temporarily stopped or decelerated. Although two or more of the processing devices PR2 to PR4 (PR5) may be restricted so as not to perform their additional operations, simultaneous implementation of the additional operations may be permitted, so long as the additional operations have approximately the same stoppage time. The time period during which conveyance of the substrate P is temporarily stopped varies depending on the content of the additional operation, however, during the time period that such an additional operation is implemented, the other processing devices are enabled to continue with processing of the substrate P. For this purpose, it may be necessary to adjust beforehand an already stored length and a new storable length of the substrate P in each of the first storage device BF1 and the second storage device BF2 in FIGS. 1 and 4 before commencing with the additional operation, in accordance with the respective processing situations of the processing device that will perform the additional operation, and of the preceding and successive processing devices. The already stored length implies the storage length of the substrate P that is already stored in the storage devices BF1, BF2, whereas the new storable length implies the storage length of the substrate P that is capable of being newly stored henceforth by the storage devices BF1, BF2.

In the processing device PR2 (die coater type or ink jet type of coating device) or the processing device PR3 (exposure device EX), for example, an appropriate timing during which the additional operation is executed can be set immediately after the process (coating or exposure) with respect to one of the device forming regions W (see FIG. 5) arranged along the longitudinal direction of the substrate P has been completed. More specifically, the timing can be set to a point in time at which the marginal portion Sw before the process for the next device forming region W is initiated has arrived at the coating position (the position facing toward the heads DCH, IJH), or the exposure position (the position where the scanning lines L1 to L5 are to be formed), which is the processing position.

Moreover, the types of devices to be formed on the substrate P, as well as the size and arrangement of the device forming regions W and the like on the upstream side and the downstream side of the marginal portion Sw can be made different from each other, so as to enable a manufacturing line to cope with multi-product/small-volume production. For example, there may be a case in which, on the downstream side of the marginal portion Sw, circuit patterns for a display panel of a first screen size (32 inch or the like) are formed in one row in the longitudinal direction of the substrate P, and on the upstream side of the marginal portion Sw, circuit patterns for a display panel having a second screen size which are smaller than the first screen size is formed in two rows in the widthwise direction of the substrate P and aligned along the longitudinal direction, or a case in which the processing conditions and setting conditions in each of the processing devices PR2 to PR4 (PR5) differ between the upstream side and the downstream side of the marginal portion Sw. In particular, since the pattern to be drawn (exposed) varies in the processing device PR3, a switching operation is necessary to switch the drawing data. In a maskless exposure machine of a direct drawing type, as shown in FIGS. 4 and 6, together with a data transfer time period when the drawing data is switched, time is required for a setup operation including changing or adjusting various parameters (drawing magnification, inclination of the scanning line L, an exposure amount, etc.). Since such a setup operation interrupts the normal operation of the processing device PR3, the setup operation can be handled as one of the additional operations. Of course, in the other processing devices PR2, PR4 (PR5) as well, if it is necessary for the processing conditions to be made significantly different, an adjustment operation therefor becomes a setup operation, and can be treated as an additional operation. In the case that the processing device PR3 is a projection exposure device using a cylindrical mask, for example, a replacement operation of the cylindrical mask, as disclosed in Japanese Patent No. 5494621, is included within the setup operation.

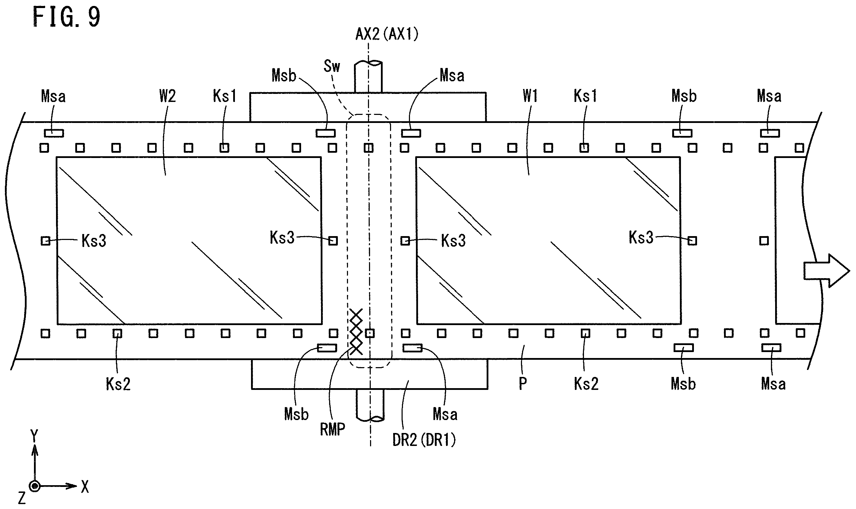

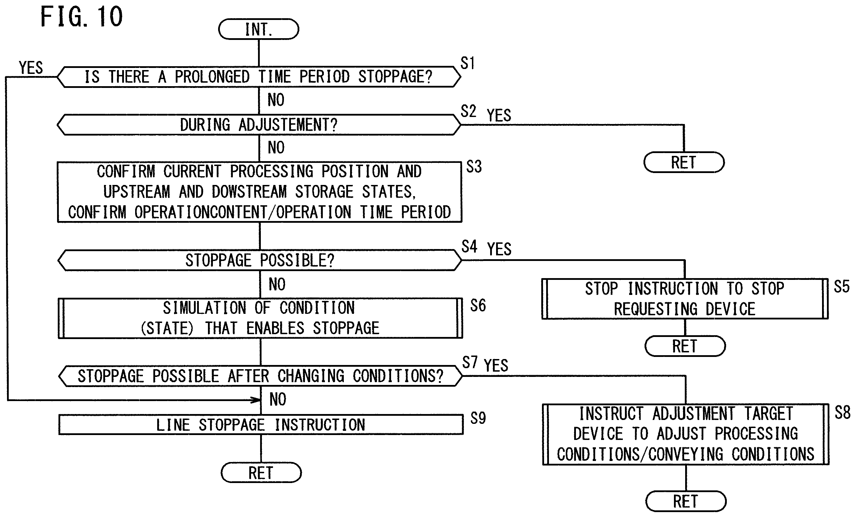

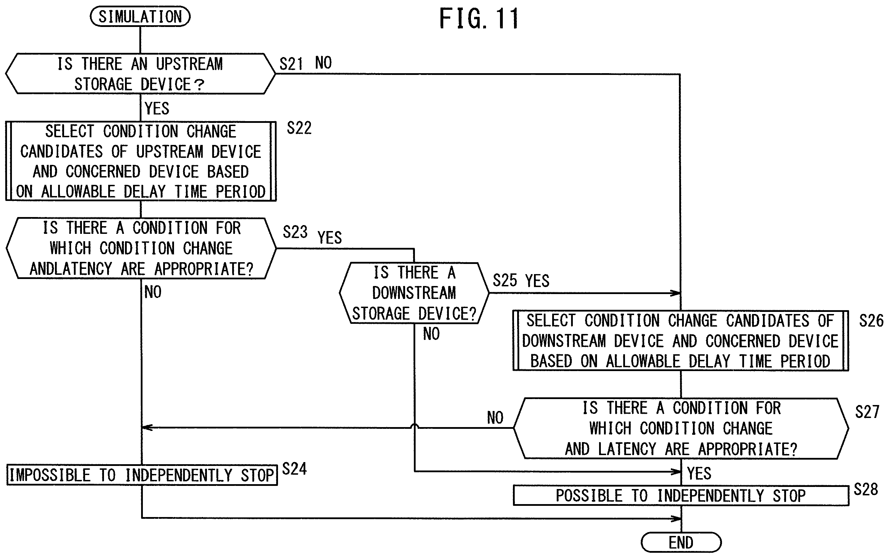

Thus, operations of the first embodiment will be described on the basis of the flowcharts of FIGS. 10 and 11, however, before giving such a description, the arrangement of the device forming regions W, etc., of the substrate P suitable for the first embodiment will be described with reference to FIG. 9. FIG. 9 shows a specific exemplary arrangement of a plurality of device forming regions W1, W2, ..., and alignment marks Ks1 to Ks3 that are formed on the substrate P of FIG. 5. Furthermore, information patterns Msa, Msb, which are formed on both sides in the widthwise direction of the substrate P, are provided in association with each of the device forming regions W1, W2, ..., on the substrate P. The positions of the information patterns Msa, Msb represent the process starting positions of the respective device forming regions W1, W2, ..., and regions (ranges) of the marginal portions Sw. The information patterns Msa, Msb are read by a reader unit, which is disposed in the vicinity of the rotating drum DR1 in the processing device (coating device) PR2 of FIG. 2, and in the vicinity of the rotating drum DR2 in the processing device (exposure device) PR3 of FIG. 4. In the case that the information patterns Msa, Msb are formed by a one-dimensional or a two-dimensional barcode, the barcodes can include information concerning a dimension of the marginal portions Sw in the longitudinal direction of the substrate P, a dimension in the longitudinal direction and a dimension in the lateral direction of the device forming regions W1, W2, ..., and information such as lot numbers of the device forming regions W1, W2, ..., and the like.

In the case of the first embodiment, by detecting the information patterns Msa, Msb with the reader unit, the processing device (coating device) PR2 of FIG. 2 is capable of performing a selective coating control so as not to apply the coating liquid (photosensitive functional fluid) LQc on the marginal portions Sw on the substrate P. Accordingly, in the case that the substrate P is made from transparent PET or PEN, when the marginal portions Sw of the substrate P are positioned within the exposure region (the rectangular region including the scanning lines L1 to L5 shown in FIG. 5) on the rotation drum DR2 in the processing device (exposure device) PR3, then via the transparent portion of the substrate P, and on the basis of photoelectric signals SDa from the reflected light monitoring system (light receiving unit 62 of FIG. 7) provided in each of the drawing units U1 to U5, the reference pattern RMP on the surface of the rotation drum DR2 can be detected. Consequently, the substrate P is temporarily stopped in a state in which the marginal portion Sw (regions uncoated by the photosensitive functional fluid) has entered into the exposure region, thereby enabling the calibration operation to be performed. In the case that calibration (baseline management) of the alignment microscopes AM1 to AM3 is necessary, when the marginal portions Sw (transparent portions) of the substrate P are brought into the positions of the detection regions Vw1 to Vw3 of the alignment microscopes AM1 to AM3, the substrate P is temporarily stopped or the conveying speed thereof is decelerated, and the reference pattern RMP on the rotary drum DR2 is detected.

[Flow of Operations]

Although the flowcharts of FIGS. 10 and 11 are primarily executed by the upper level control device 14 in FIG. 1, the process steps thereof may also be executed by the lower level control devices 18, 24, 80. Further, FIG. 10 is a flowchart of a process flow for stopping the processing devices PR2, PR3, PR4 (PR5) individually for a short time period, or for stopping the entire manufacturing line as a whole, on the basis of status information (an interrupt request) of the processing device PR2 transmitted from the lower level control device 18 to the upper level control device 14, status information (an interrupt request) of the processing device PR3 transmitted from the lower level control device 24 to the upper level control device 14, and status information (an interrupt request) of the processing device PR4 (PR5) transmitted from the lower level control device 80 to the upper level control device 14, etc. FIG. 11 is a flowchart for simulating a stoppage possibility of the processing devices PR2 to PR4 (PR5) determined in the flowchart of FIG. 10. Further, although the program of FIG. 10 is executed at a fixed time interval (interval) according to a determination of the upper level control device 14, the execution of the program may also be triggered by an interrupt request (stop request) from each of the lower level control devices 18, 24, 80.

In step S1 of FIG. 10, by receiving status information from the lower level control device 18 of the processing device PR2, status information from the lower level control device 24 of the processing device PR3, or status information from the lower level control device 80 of the processing device PR4 (PR5), it is determined whether or not any one of the processing devices PR2 to PR4 (PR5) has issued an interrupt request for a prolonged time period stoppage. Such a request for a prolonged time period stoppage is also generated primarily in the event of an emergency stoppage, for example, in the case that a malfunction (sudden failure, etc.) occurs in the processing devices. In step S1, in the case that the status information (interrupt request) is a request for the prolonged time period stoppage, since a maintenance operation such as replacement of components for fixing the malfunction of a processing device is necessary, in many cases, it is inevitable in many cases to stop the entire production line. Therefore, in response to a request for the prolonged time period stoppage, the routine proceeds to step S9 where stoppage of the manufacturing line is instructed.

In step S9, an appropriate stop timing and stop routine are instructed to each of the processing devices PR1 to PR5 (lower level control devices 18, 24, 80) so that the entire production line of FIG. 1 is safely and urgently stopped. For example, in the case that the processing device requiring an emergency stop is the processing device PR4 (PR5), and when the other processing devices PR2, PR3 are capable of continuing with their processing operations normally, the processing device PR2 is urgently stopped when the marginal portion Sw of the substrate Sw shown in FIG. 9, for example, faces toward the head main body 200A of the die coater head DCH and when the coating operation can be interrupted. Similarly, the processing device PR3 is urgently stopped when the marginal portion Sw of the substrate P shown in FIG. 9 faces toward the exposure region of the drawing units U1 to U5 and when the exposure operation can be interrupted. In this case, the respective storage states of the substrate P in each of the first storage device BF1 on the upstream side and the second storage device BF2 on the downstream side of the processing device (exposure device) PR3 are set so as to have a margin to absorb a large difference in the conveying speeds of the substrate P between the processing devices PR (for example, one of the speeds thereof is zero) within the time until the respective processing devices come to a complete stop.

The timing at which the processes in the processing devices PR2, PR3 are capable of being interrupted occurs when the marginal portion Sw as shown in FIG. 9 faces toward the coating position (die coater head unit) or the exposure position (scanning lines L1 to L5), and a maximum delay time period Td from when the instruction for the emergency stop is issued and until the processes are actually interrupted (the substrate P stops) is determined by $Td = Lss/Vpp$, where Lss denotes an interval distance of the marginal portions Sw in the longitudinal direction of the substrate P (substantially the length in the longitudinal direction of the device forming regions W), and Vpp denotes the conveying speed of the substrate P. Accordingly, at a point in time when an instruction for an emergency stop (prolonged stoppage) is issued, it is sufficient if one of the storage devices BF1, BF2 is storing, as an already stored length, the substrate P having a length corresponding to the maximum delay time period Td, and the other of the storage devices BF1 and BF2 is capable of storing, as a new storable length, the substrate P having a length corresponding to the maximum delay time period Td. The storage states of the storage devices BF1, BF2 are managed by the upper level control device 14. Further, in the case of an emergency stop, since it is difficult for the processing device PR4 (PR5) in which wet processing is performed to interrupt the process thereof just within the marginal portion Sw, conveyance of the substrate P is stopped immediately, and the guide rollers R5, R6 of FIG. 8 are moved in the +Z direction (upward), in order to be placed in a state in which the substrate P is pulled out from the developing solution LQ (or the plating solution).

Although it is not impossible to predict the timing at which an emergency stop state will occur from operation log information that is acquired internally by each of the processing devices PR2 to PR4 (PR5), it is generally difficult to predict the timing. Thus, during a period in which the entire production line is operating normally and the substrate P is being stably conveyed at the predetermined specified speed Vpp, it is advisable to manage the storage states in a manner so that each of the storage devices BF1, BF2 at least stores the substrate P having a length Lss corresponding to the maximum delay time period Td and possesses a margin (new storable length) capable of newly storing the substrate P of the length Lss.

In step S1, if it is determined that there is not a prolonged time period stoppage, it is determined that a request for an additional operation within a short time period has been issued, and the process proceeds to step S2. In step S2, it is determined whether or not adjustment is already taking place in order to transition any one of the processing devices PR2 to PR4 (PR5) into a stopped state on the basis of a request for an additional operation within a short time period that was previously issued. If it is determined in step S2 that an adjustment is in progress, the process flow of FIG. 10 ends. Further, if it is determined in step S2 that an adjustment is not in progress, then in step S3, in the case that a processing device PR (hereinafter also referred to as a stop requesting device PRd) for which a short time additional operation has been requested is the processing device PR2, PR3, then current processing position information of the substrate P being processed (the processing positions of the device forming regions W1, W2, ..., the marginal portions Sw, etc., in FIG. 9), storage information concerning the storage state (the already stored length and the new storable length, etc.) of the substrate P in the storage devices BF1, BF2 on the upstream or downstream sides of the stop requesting device PRd, and operation information concerning the operation time period (required stoppage time period) and the content of the additional operation transmitted from the lower level control device (18, 24, 80) of the stop requesting device PRd, and the waiting time period (allowable delay time period) during which it can be waited from issuance of the request until the additional operation is actually started are confirmed. In the case that the stop requesting device PRd is the processing device PR4 (PR5), then in step S3, storage information (the already stored length and the new storable length, etc.) concerning the storage state of the second storage device BF2, and the operation information (the operation content, the operation time period, the allowable delay time period) are confirmed. Since the coating operation cannot be continued when the coating liquid LQc filled in the die coater head DCH of the processing device PR2 runs out, the allowable delay time period in the processing device PR2, for example, is a time period until the coating liquid LQc runs out. The allowable delay time period in the processing device PR3, for example, is a time period during which it can be waited until the calibration operation is performed, or a time period during which it can be waited until a switching operation to the spare light source device is performed, or the like. The allowable delay time period in the processing device PR4 (PR5), for example, is a time period during which it can be waited until a maintenance operation such as refreshment or replacement of the developing solution LQ or the plating solution is performed.

In this instance, in the case that the stop requesting device PRd is the processing device PR2, then in step S3, in particular, the storage information is verified on the basis of the conveying speed Vpp of the substrate P and the operation information (the stoppage time period, the allowable delay time period). In order not to stop the entire manufacturing line (device manufacturing system 10) while the processing device PR2 (specific processing device) is temporarily stopped, it is acceptable if the other processing device PR3 and the processing device PR4 (PR5) except the processing device PR2 are capable of continuously conveying the substrate P. Thus, when the processing device PR2 is the stop requesting device PRd, the stoppage time period (interruption time period) of the processing device PR2 is set to TS2, and from a relationship of the current already stored length Lf1 of the first storage device BF1 with the conveying speed Vpp of the substrate P, it is verified whether the inequality $Lf1 > Vpp \cdot TS2$ is satisfied. Stated otherwise, it is verified whether the storage state (current already stored length Lfl) of the first storage device BF1 satisfies the required storage state (of being greater than or equal to $Vpp \cdot TS2$). In the case that the storage state of the first storage device BF1 satisfies the required storage state, the storage state of the first storage device BF1 transitions normally during the stoppage time period of the stop requesting device PRd (PR2). In this case, during the stoppage time period of the stop requesting device PRd (PR2), the storage length of the first storage device BF1 gradually becomes shorter at a constant speed (constant rate).

Further, in the case that the stop requesting device PRd is the processing device PR3, then in step S3, the storage information of both of the storage devices BF1, BF2 is verified (determined) on the basis of the conveying speed Vpp of the substrate P and the operation information (the stoppage time period, the allowable delay time period). In this case, since the processing device PR2 and the processing device PR4 (PR5) continue to operate, from the relationship between the stoppage time period (interruption time period) TS3 of the processing device PR3 and the conveying speed Vpp of the substrate P, it is verified (determined) with respect to the first storage device BF1 whether or not there is a new storable length greater than or equal to the length determined by $Vpp \cdot TS3$. From the relationship between the stoppage time period TS3 and the conveying speed Vpp of the substrate P, it is verified (determined) with respect to the second storage device BF2 whether the current already stored length Lf2 of the second storage device BF2 satisfies the inequality $Lf2 > Vpp \cdot TS3$, from the relationship thereof with the conveying speed Vpp of the substrate P. Stated otherwise, it is verified whether or not the storage state (new storable length) of the first storage device BF1 satisfies the required storage state (of being greater than or equal to $Vpp \cdot TS3$), and it is determined whether or not the storage state (already stored length Lf2) of the second storage device BF2 satisfies the required storage state (of being greater than or equal to $Vpp \cdot TS3$). In the case that the storage states of the storage devices BF1, BF2 satisfy the required storage state, the storage states of the storage devices BF1, BF2 transition normally during the stoppage time period of the stop requesting device PRd (PR3). In this case, during the stoppage time period of the stop requesting device PRd (PR3), the storage length of the first storage device BF1 gradually becomes longer at a constant speed (constant rate), and the storage length of the second storage device BF2 gradually becomes shorter at a constant speed (constant rate).

In the case that the stop requesting device PRd is the processing device PR4 (PR5), from the relationship between the stoppage time period (interruption time period) TS4 (TS5) of the processing device PR4 (PR5) and the conveying speed Vpp of the substrate P in relation to the second storage device BF2, it is verified whether or not there is a new storable length greater than or equal to the length determined by Vpp · TS4 (TS5). Stated otherwise, it is verified whether the storage state (new storable length) of the second storage device BF2 satisfies the required storage state (of being greater than or equal to Vpp · TS4 (TS5)). In the case that the storage state of the second storage device BF2 satisfies the required storage state, the storage state of the second storage device BF2 transitions normally during the stoppage time period of the stop requesting device PRd (PR4 (PR5)). In this case, during the stoppage time period of the stop requesting device PRd (PR4 (PR5)), the storage length of the second storage device BF2 gradually becomes longer at a constant speed (constant rate). Moreover, since there is no storage device between the processing device PR4 and the processing device PR5, it is necessary to make the conveying speed of the substrate P of the processing device PR4 and the processing device PR5 substantially the same. Accordingly, in the case that the stop requesting device PRd is the processing device PR4, and the processing device PR4 is stopped temporarily for the stoppage time period TS4, the processing device PR5 is also stopped for the stoppage time period TS4. Further, in the case that the stop requesting device PRd is the processing device PR5, and the processing device PR5 is stopped temporarily for the stoppage time period TS5, the processing device PR4 is also stopped for the stoppage time period TS5. Further, in the case that the stop requesting devices PRd are both of the processing devices PR4, PR5, and the processing devices PR4, PR5 are temporarily stopped together, the processing devices PR4, PR5 are stopped for a stoppage time period TS4 or TS5, whichever is longer.

In the following step S4, on the basis of the verified results in step S3, it is determined whether or not it is possible to stop the stop requesting device PRd. Stated otherwise, in the case that the stop requesting device PRd is to be stopped (suspended) in order to perform an additional operation, it is determined whether or not the storage states of the storage devices BF1, BF2 transition normally during the stoppage (interruption) time period. In the case that the stop requesting device PRd is the processing device PR2 or PR3, it is determined in step S4 whether or not the substrate P is capable of being stopped when the nearest marginal portion Sw on the substrate P has arrived at the coating position (processing position) or the exposure position (processing position). In the case that the storage states, such as the already stored length and the new storable length in the first storage device BF1 and the second storage device BF2, which were confirmed in step S3, have become the required state (required storage state), then since it is possible for the processing device PR2 or PR3 to be stopped at the marginal portion Sw of the substrate P, the process branches to YES at step S4, and proceeds to step S5, whereupon a stop instruction (stop permission) is granted to the stop requesting device PRd (PR2 or PR3). The processing device PR2 or PR3 that has received the stop instruction continues its processing until the nearest marginal portion Sw of the substrate P arrives, and thereafter, causes conveyance of the substrate P to stop at a point in time when the marginal portion Sw has reached the coating position or the exposure position, and then immediately implements the predetermined additional operation. More specifically, since the processing device PR2 and the processing device PR3 implement processes within a range that is shorter than the length of the marginal portion Sw in the longitudinal direction of the substrate P, at a point in time when the processing position (coating position or exposure position) of the stop requesting device PRd (PR2 or PR3) has reached the marginal portion Sw, conveyance and processing of the substrate P in the stop requesting device PRd can be temporarily stopped to allow the additional operation to be performed. Further, when the stop requesting device PRd is the processing device PR4 (PR5), in the case it is confirmed in step S3 that the storage state (new storable length) of the substrate P in the second storage device BF2 is in the required state (required storage state), since it is possible for the processing device PR4 (PR5) to be stopped, the process branches to YES at step S4, and proceeds to step S5, whereupon a stop instruction (stop permission) is granted to the stop requesting device PRd (PR4, PR5). Since the processing device PR4 (PR5) implements processing within a range that is longer than the length of the marginal portion Sw in the longitudinal direction of the substrate P, regardless of the processing position of the stop requesting device PRd (PR4 (PR5)), in the case it is confirmed that the storage state of the second storage device BF2 is in the required storage state, conveyance and processing of the substrate P in the stop requesting device PRd is immediately temporarily stopped to allow the additional operation to be performed.

In the case that the storage state (already stored length or new storable length) in the storage devices BF1, BF2 confirmed in step S3 is not in the required state (required storage state), when any one of the processing devices PR2 to PR4 (PR5) is stopped to allow the additional operation, then during the additional operation, the already stored length and the new storable length of the substrate P in the first storage unit BF1 or the second storage unit BF2 is insufficient, and as a result, the entire manufacturing line (all of the processing devices PR1 to PR5) is stopped. Thus, according to the first embodiment, it is determined at the timing of step S4 that it is impossible to stop, and a simulation of a condition (state) that enables stoppage is executed in step S6. In such a simulation, a search is conducted as to whether the storage state of the storage devices BF1, BF2 can be transitioned into a state in which stoppage is possible for the additional operation of the stop requesting device PRd, and more specifically, whether or not it is possible to find an appropriate condition that enables the already stored length or the new storable length to be improved, in the case that the processing conditions with respect to the substrate P and the conveying speed of the substrate P in each of the processing devices PR2 to PR4 (PR5) are changed. The simulation performed in step S6 will be described later with reference to FIG. 11.

In accordance with the simulation of step S6, when at least one candidate for an exemplary change of the processing conditions and an exemplary change in the conveying speed Vpp for each of the processing devices PR2 to PR4 (PR5) in order to secure the required already stored length and new storable length is given, then in the following step S7, when a predetermined time period (also referred to as an adjustment time period) has elapsed in a state in which the adjustment was made in accordance with either one or a combination of both of the exemplary changes of the processing conditions and the exemplary change in the conveying speed of the substrate P, a determination is made as to whether or not the stop requesting device has attained the state in which stoppage is possible. In step S7, with particular attention being paid to an allowable delay time period (waiting time period) from among the operation information (operation content, operation time period, allowable delay time period) exhibited from the stop requesting device PRd, a determination is made as to whether or not the adjustment time period is shorter than the allowable delay time period. As described above, the allowable delay time period (waiting time period) is the maximum time that the stop requesting device PRd can wait until starting the additional operation, and therefore, when the adjustment time period is longer than the allowable delay time period, the entire manufacturing line (all of the processing devices PR1 to PR5) must be stopped. Moreover, in the simulation of step S6, a restriction condition may be set in which an adjustment time period shorter than the allowable delay time period can be obtained, and based thereon, a search may be conducted for the exemplary change of the processing conditions and the exemplary change in the conveying speed. In such a case, at the stage of step S7, it is understood that it is possible for the stop requesting device PRd to be stopped after the adjustment time period during which processing is performed on the substrate P while changing various conditions.

The allowable delay time period (waiting time period) may be changed depending on the content of the additional operations of each of the processing devices PR2 to PR4 (PR5). In a situation in which it is determined in step S4 that the stop requesting device PRd cannot be immediately stopped, an adjustment time period is necessary for improving the already stored length and the new storable length of the substrate in the storage devices BF1, BF2, while processing of the substrate P by the processing devices PR2 to PR4 (PR5) is continued. The adjustment time period also varies significantly depending on the degree (degree of improvement) in the conveyance length of the substrate P until the already stored length and the new storable length, which are required, are obtained. In general, in the exposure device in the form of the processing device PR3, since the beam intensity from the light source is fixed, there is an upper limit to the conveying speed of the substrate P in order to impart a predetermined amount of exposure to the photosensitive layer of the substrate P at the time of pattern exposure. Therefore, taking into consideration a reduction in beam intensity due to deterioration of the light source, in the processing device PR3, the specified conveying speed Vpp is set to be lower than the upper limit speed, and the beam intensity is adjusted (diminished) so that a proper amount of exposure can be obtained at the specified conveying speed Vpp. Accordingly, in the exposure device in the form of the processing device PR3, although it is easy to set the conveying speed of the substrate P to be lower than the specified speed Vpp, it is difficult to set the conveying speed of the substrate P to be higher than the specified speed Vpp.

On the other hand, in the coating device in the form of the processing device PR2, and the wet processing device in the form of the processing device PR4, the adjustment range of the conveying speed of the substrate P can be set comparatively wide. In the case that the processing device PR2 performs a coating operation with the die coater head DCH, processing conditions (setting conditions) such as a gap between the substrate P and the slit portion 200B at the distal end of the head main body 200A illustrated in FIG. 3, and the pressed-out flow rate of the coating liquid LQc by the piston 201 are adjusted, whereby it is possible to apply the coating liquid LQc to the substrate P with an appropriate film thickness even if the conveying speed of the substrate P changes. Further, in the processing device PR4, by adjusting the interval (processing conditions) between the guide rollers R5, R6 in FIG. 8 in the X direction (the conveying direction of the substrate P) in accordance with a change in the conveying speed of the substrate P, since the liquid contact length (processing condition) of the processing liquid (developing solution LQ) with the substrate P can be changed, it is possible to maintain an appropriate liquid contact time period (development time period). In this manner, although the processing devices PR2, PR4 are capable of coping with a change in the conveying speed of the substrate P comparatively easily, it is preferable to avoid a sudden change in the conveying speed of the substrate P. In the case of a change in the conveying speed of the substrate P from the specified speed Vpp, it is preferable for the processing conditions (setting conditions) to be gradually adjusted, while gradually changing the speed by decreasing the rate of change.

Based on the above-described situation, the simulation of step S6 is performed, and in step S7, if it is determined that, by changing the conditions, the additional operation of the stop requesting device PRd can be started prior to elapse of the allowable delay time period (waiting time period), then in step S8, an instruction to adjust the processing (setting) conditions and the conveying conditions (speed change amount, etc.) of the substrate P is transmitted to the lower level control device (18, 24, 80) of the target processing device (adjustment target device). In accordance with step S8, adjustment of the conveying speed of the substrate P in at least one of the processing devices PR2 to PR4 (PR5) constituting the manufacturing line is started, and the insufficiency of the already stored length or the new storable length of the first storage device BF1 or the second storage device BF2 is gradually improved, so that before the allowable delay time period (waiting time period) elapses, the stop requesting device PRd is enabled to start the additional operation and the respective other processing devices can continue their processing without lowering the processing quality under the processing (setting) conditions and the conveying condition of the substrate P which have been changed. Moreover, in FIG. 10, the process flow proceeds in a manner so that, once an adjustment instruction is issued to the processing device that serves as the adjustment target in step S8, due to the determination of step S2, steps S3 to S7 are not executed again. However, step S2 may be omitted, and steps S3 to S8 may be executed at regular time intervals. In such a case, since the processing position information, the storage information, and the operation information, etc., acquired in step S3 are updated at each time interval, after step S8 has been executed once, in response to the determination in step S4 for each time interval, step S5 (issuance of a stop instruction to the stop requesting device PRd) is executed, and therefore, a more accurate control is made possible.

However, as a result of the simulation in step S6, cases may occur in which a suitable exemplary change (adjustment pattern) of the processing (setting) conditions and the conveying condition (speed) of the substrate P in each of the processing devices PR2 to PR4 cannot be found. In this case, in step S7, it is determined that adjustment is not possible, and similar to the previously described emergency stop sequence, step S9 is executed.

As described above, by executing steps S1 to S8 of the flow of operations shown in FIG. 10, even if a processing device is temporarily stopped for a short time period to enable an additional operation to be performed, it is possible to continue operation of the other processing devices, and a significant reduction in productivity of the electronic devices can be suppressed. Moreover, in the case of restoring the processing device which has been stopped to perform the additional operation, the processing (setting) conditions that were changed are gradually restored to their original state, so that the conveying speed of the substrate P arrives at the specified speed Vpp in any of the processing devices.

Next, an example of the simulation executed in step S6 will be described with reference to the flowchart of FIG. 11. In FIG. 11, in step S21, a determination is made as to whether or not there is a storage device for the substrate P on an upstream side of the stop requesting device PRd. As shown in FIGS. 1 and 4, according to the present embodiment, a storage device is not provided on the upstream side of the processing device PR2 or on the downstream side of the processing device PR4 (PR5). Accordingly, in the case that the stop requesting device PRd is the processing device PR2, the process proceeds to step S26 in accordance with the determination made in step S21. In the case that the stop requesting device PRd is the processing device PR3 or the processing device PR4, the process proceeds to step S22 in accordance with the determination made in step S21. Hereinafter, in order to avoid duplicative descriptions, the case in which the stop requesting device PRd is the processing device PR3 will be described first.

When the stop requesting device PRd is the processing device PR3, execution of step S22 signifies that either one or both of the new storable length of the substrate P in the first storage device BF1 on the upstream side of the processing device PR3, and the already stored length of the substrate P in the second storage device BF2 on the downstream side of the processing device PR3 are insufficient. In the case that the processing device PR3 is stopped, it is necessary for the new storable length capable of being stored henceforth by the first storage device BF1 at the point in time when the additional operation is started to be greater than or equal to the length determined by the multiplication of the conveying speed (specified speed Vpp) of the substrate P in the processing device PR2 on the upstream side, and the operation time period (stoppage time period TS3) of the additional operation. If the new storable length is insufficient, it is necessary to simulate whether or not the insufficiency thereof can be eliminated, by adjustment of the processing conditions and the substrate conveying speed of the processing device PR2 (and depending on the circumstances, the processing device PR3 itself) or the like, before the elapse of the allowable delay time period of the processing device PR3 which is the stop requesting device. Thus, in step S22, in the case that the new storable length of the first storage device BF1 on the upstream side is insufficient, candidates (combinations) for various changes in conditions between the processing device PR2 on the upstream side and the processing device PR3 (concerned device) which is the stop requesting device PRd are selected so as to resolve the insufficiency, under a condition in which the latency (adjustment time period) Tw1 (in seconds) until the insufficiency of the new storable length is resolved is made shorter than the allowable delay time period of the stop requesting device PRd. Moreover, in the previous step S21, although it was determined whether a storage device exists on the upstream side, a determination may be made as to whether or not the new storable length of the storage device on the upstream side is insufficient.

The candidates (combinations) for the various changes in conditions selected in step S22 are set so that the latency Tw1 becomes shorter than the allowable delay time period (waiting time period) during which it is waited until the processing device PR3 (stop requesting device PRd) begins the additional operation. In this instance, when the allowable delay time period (waiting time period) until the processing device PR3 (stop requesting device PRd) starts the additional operation is represented by Tdp3 (seconds), the amount of insufficiency of the new storable length in the first storage device BF1 is represented by $\Delta Ls1$, and the conveying speed of the substrate P in the processing device PR3 cannot be increased from the specified speed Vpp, then an optimum speed change characteristic V2(t) decreasing the conveying speed of the substrate P in the upstream side processing device PR2 from the specified speed Vpp is simulated so as to satisfy both of the following formulas (1) and (2).

$$Tdp3 > Tw1 \qquad \ldots(1)$$

$$Tw1 \cdot V2(t) \geq \Delta Ls1 \qquad \ldots(2)$$

At this time, the simulation is performed by setting several values for the conveying speed, which is lowered from the specified speed Vpp, and the rate of decrease in the speed. As a result, under the speed change characteristics V2(t) obtained as appropriate candidates, it is determined whether the processing conditions (the gap amount between the slit portion 200B and the substrate P, the speed at which the piston 201 is pressed down, etc.) of the die coater head DCH of the processing device PR2 are capable of being adjusted in conjunction therewith. Whether or not the coating process in the processing device PR2 can be continued while maintaining the processing quality is determined in step S23, by changing (adjusting) the speed change characteristic V2(t) and the processing conditions (setting conditions) that were sought in the foregoing manner. As a result of the simulation, the value for the latency Tw1 that satisfies the condition of formula (1) is recalculated. In accordance with steps S22 and S23, by changing the processing conditions of the processing device PR2 and the conveying speed of the substrate P while maintaining the processing quality, it is determined whether or not the storage state of the first storage device BF1 can be made to satisfy the required storage state within the allowable delay time period Tdp3.

As a result of the simulation in step S22, in the case that an appropriate speed change characteristic V2(t) cannot be found due to circumstances such as the fact that changes in the processing conditions of the die coater head DCH cannot be dealt with or the like, then according to the determination of step S23, the process proceeds to step S24, whereupon a determination is made that it is impossible to independently stop the stop requesting device PRd (processing device PR3) before the elapse of the allowable delay time period Tdp3 in order to perform the additional operation of the stop requesting device PRd (processing device PR3), and the simulation is brought to an end. If the determination of step S24 is obtained, it is determined that stoppage is impossible in step S7 of the previous FIG. 10, and the instruction of step S9 to stop the manufacturing line is performed.

On the other hand, in the case that, as a result of the simulation in step S22, if it is possible to cope with the changes in the processing conditions of the die coater head DCH, and an appropriate speed change characteristic V2(t) can be found, then in accordance with the determination of step S23, the process proceeds to step S25, and it is determined whether or not a storage device exists on the downstream side. In the case of the processing device PR3, the second storage device BF2 exists on the downstream side, and in the case that the processing device PR3 is stopped in order to perform an additional operation, at a point in time when the additional operation is started, it is necessary for the already stored length of the substrate P, which is already stored in the second storage device BF2, to be greater than or equal to the length determined by the multiplication of the conveying speed (specified speed Vpp) of the substrate P in the processing device PR4 (PR5) on the downstream side, and the operation time period (stoppage time period TS3) of the additional operation. However, at the point in time when step S6 of FIG. 10 (the simulation of FIG. 11) is executed, the already stored length in the second storage device BF2 is insufficient. Whether or not the insufficiency can be eliminated by adjusting the processing conditions (setting conditions) of the processing device PR4 and the conveying conditions of the substrate P before the elapse of the allowable delay time period (waiting time period) exhibited by the stop requesting device PRd (processing device PR3) is simulated in the following step S26. In order to resolve the insufficiency of the already stored length in the second storage device BF2, it is necessary to perform at least one of increasing the conveying speed of the substrate P in the processing device PR3 on the upstream side, or decreasing the conveying speed of the substrate P in the processing device PR4 (PR5) on the downstream side. As was described previously, because it is difficult to increase the conveying speed of the substrate P in the case that the processing device PR3 is the exposure device, in this instance, such a situation is coped with by gradually decreasing the conveying speed of the substrate P in the processing device PR4 (PR5).

In step S26 as well, similar to step S22, candidates (combinations) for various changes in conditions between the processing device PR4 (PR5) on the downstream side and the processing device PR3 (concerned device) are selected so as to resolve the insufficiency of the already stored length in the second storage device BF2, under a condition in which the latency (adjustment time period) Tw2 (in seconds) until the insufficiency of the already stored length is resolved is made shorter than the allowable delay time period (waiting time period) Tdp3. In this instance, when the amount of insufficiency of the already stored length in the second storage device BF2 is represented by $\Delta Ls2$, and the conveying speed of the substrate P in the processing device PR3 cannot be increased from the specified speed Vpp, then an optimum speed change characteristic V4(t) (V5(t)) for decreasing the conveying speed of the substrate P in the downstream side processing device PR4 (PR5) from the specified speed Vpp is simulated so as to satisfy both of the following formulas (3) and (4) .

$$Tdp3 > Tw2 \qquad \qquad ...(3)$$

$$Tw2 \cdot V4(t) \ (V5(t)) \geq \Delta Ls2 \qquad \qquad ...(4)$$

At this time, the simulation is performed by setting several values for the conveying speed, which is lowered from the specified speed Vpp, and the rate of decrease in the speed. As a result, under the speed change characteristics V4(t) (V5(t)) obtained as appropriate candidates, it is determined whether or not the processing conditions (a change in the liquid contact length by adjustment of the interval between the guide rollers R5, R6) of the processing device PR4 (PR5) are capable of being adjusted in conjunction therewith. Whether or not the development process (wet processing) in the processing device PR4 (PR5) can be continued while maintaining a predetermined processing quality is determined in step S27, by changing (adjusting) the speed change characteristics V4(t) (V5(t)) and the processing conditions (setting conditions) that were sought in the foregoing manner. As a result of the simulation, the value for the latency Tw2 that satisfies the condition of formula (3) is recalculated. In accordance with steps S26 and S27, by changing the processing conditions of the processing device PR4 (PR5) and the conveying speed of the substrate P while maintaining the processing quality, it is determined whether or not the storage state of the second storage device BF2 can be made to satisfy the required storage state within the allowable delay time period Tdp3.

As a result of the simulation in step S26, in the case that an appropriate speed change characteristic V4(t) (V5(t)) cannot be found due to circumstances such as the fact that changes in the processing conditions (liquid contact length) of the processing device PR4 (PR5) cannot be dealt with or the like, then according to the determination of step S27, the process proceeds to step S24, whereupon a determination is made that it is impossible to independently stop the stop requesting device PRd (processing device PR3) before the elapse of the allowable delay time period (waiting time period) Tdp3 in order to perform the additional operation of the stop requesting device PRd (processing device PR3), and the simulation is brought to an end. In the case of having passed through step S24, it is determined that stoppage is impossible in step S7 of the previous FIG. 10, and the instruction of step S9 to stop the manufacturing line is performed. Further, as a result of the simulation in step S26, in the case that an appropriate speed change characteristic V4(t) (V5(t)) is found by which it is possible to cope with the changes in the processing conditions (liquid contact length, etc.) of the processing device PR4 (PR5), then according to the determination of step S27, the process proceeds to step S28, whereupon a determination is made that it is possible to independently stop the stop requesting device PRd (processing device PR3) before the elapse of the allowable delay time period Tdp3, and the simulation is brought to an end. Moreover, in the previous step S25, if a storage device does not exist on the downstream side, the process proceeds to step S28. In the case of having passed through step S28, it is determined in step S7 of the previous FIG. 10 that it is possible for the stop requesting device PRd to be stopped before the elapse of the allowable delay time period (waiting time period), and the process proceeds to step S8.

In the above-described simulation of FIG. 11, a description was given in which the conveying speed of the substrate P in the processing device PR3 is not changed from the specified speed Vpp, however, depending on the configuration of the processing device PR3 (exposure device), it is possible for the substrate P to be conveyed through the processing device PR3 faster than the specified speed Vpp. For example, in the case of a configuration, i.e., a so-called tandem type exposure device, in which a plurality of rotation drums DR2 are arranged in the conveying direction of the substrate P, and a plurality of regions, which are divided in the longitudinal direction on the substrate P at positions of the respective rotation drums DR2, are exposed in each of a plurality of individual exposure heads and projection optical systems, or in the case of a configuration in which a plurality of exposure light sources are mounted, and illuminance is increased by synthesizing the beams from the plurality of light sources as necessary, it is also possible to increase the conveying speed of the substrate P relative to the specified speed Vpp. In such a case, in the simulation of steps S22 and S26, adjustment of the conveying speed of the substrate P in the processing device PR3 may be added as a change condition. When the conveying speed of the substrate P in the processing device PR3 is increased, the waiting times Tw1, Tw2 obtained as a result of the simulations of steps S22 and S26, and more specifically, the adjustment time period of each of the processing devices PR2 to PR4 (PR5) in preparation for stopping the additional operation of the processing device PR3, can be shortened.

Further, in the above description, although the stop requesting device PRd was the processing device PR3, the simulation of FIG. 11 can be similarly applied to the other processing devices PR2, PR4 (PR5). In the case that the stop requesting device PRd is the processing device PR2, and the simulation of step S6 (FIG. 11) is carried out in accordance with the determination in step S4 of FIG. 10, since there is no storage device on the upstream side, and the

EP 3 358 611 B1

first storage device BF1 is included on the downstream side, after completion of steps S21, S26, and S27 of FIG. 11, one of steps S24 and S28 is executed. Further, in the case that the stop requesting device PRd is the processing device PR4 (PR5), and the simulation of step S6 (FIG. 11) is carried out in accordance with the determination in step S4 of FIG. 10, since there is no storage device on the downstream side, and the second storage device BF2 is included on the upstream side, after completion of steps S21, S22, and S23 of FIG. 11, one of steps S24 and S28 is executed. Further, in the case that the stop requesting device PRd is the processing device PR2 or PR4 (PR5), adjustment of the conveying speed of the substrate P in the processing device PR3 can be added to the changes in conditions. In such a case, in the event that the conveying speed of the substrate P in the processing device PR3 is decreased from the specified speed Vpp, it is preferable for the rotational speed of the polygon mirror 66 shown in FIG. 6, and the clock pulse frequency for turning on/off the optical element for drawing (optical modulation element) 52 in accordance with the drawing data (pattern pixel data) to be decreased at the same ratio.

Further, according to the first embodiment, the stoppage time period during the additional operation of the stop requesting device PRd is designated in advance, and it is possible to set the already stored length and new storable length in each of the storage devices BF1, BF2 so as to be longer than the conveyance length of the substrate P that can be transported at the specified speed Vpp during the stoppage time. Therefore, the processing device in which the conveying speed Vpp of the substrate P has been changed from the specified speed Vpp is capable of being controlled so that the conveying speed of the substrate P is restored to the specified speed Vpp immediately after the stop requesting device PRd has started the additional operation.

Moreover, the storage state (already stored length, new storable length) of the first storage device BF1 and the second storage device BF2 may be obtained from the difference between the speeds of the substrate P conveyed into the storage devices BF1, BF2, and the speeds of the substrate P conveyed out from the storage devices BF1, BF2. Further, a position sensor may be provided for detecting the position of the respective dancer rollers 20, 22 in the Z direction, and the storage length of the storage devices BF1, BF2 may be obtained from the positions in the Z direction of the respective dancer rollers 20, 22.

Further, in FIGS. 10 and 11, although the processing device PR1 has not been described, since there is no storage device between the processing device PR1 and the processing device PR2, it is necessary to make the conveying speed of the substrate P of the processing device PR1 and the processing device PR2 substantially the same. Accordingly, in the case that the processing device PR2 is stopped temporarily for the stoppage time period TS2, the processing device PR1 is also stopped for the stoppage time period TS2. Stated otherwise, the processing device PR1 carries out conveyance and processing of the substrate P in conjunction with conveyance and processing of the substrate P in the processing device PR2.

[Modifications of First Embodiment]

The first embodiment described above may be modified in the following manner.

(Modification 1) Incidentally, in the patterning device (exposure device, inkjet drawing device) such as the processing device PR3, as was described with reference to FIGS. 5 and 9, by the image capturing elements of the alignment microscopes AM1 to AM3 and the like, and in accordance with movement of the substrate P in the longitudinal direction, it is necessary to capture images of the alignment marks (marks) Ks1 to Ks3 that traverse within the respective detection regions Vw1 to Vw3 from the measurement results by the encoder system (reading heads EC1a, EC1b), and to perform detection of such images at high speed. However, for example, due to the occurrence of misalignment, in which some damage or loss occurs in the initial alignment marks Ks1 to Ks3 that define the exposure (drawing) starting position of the device forming region W, there is a possibility that the exposure made with respect to the device forming region W may be defective. Further, in order to precisely measure the deformation of the entire device forming region W, the rotation drum DR2 may be rotated more slowly than the speed (specified speed Vpp) at the time of exposure, and the image detection accuracy of the respective alignment marks Ks1 to Ks3 (reproducibility, etc.) may be enhanced.

In such a case, the processing device PR3 may suspend and skip over the exposure operation with respect to one of the device forming regions W, or may carry out a retry operation of returning the substrate P in a reverse direction by a certain distance, and then conveying the substrate P again in the forward direction. In such a retry operation, since a substantial exposure operation by the processing device PR3 is stopped during the period in which reverse movement of the substrate P or the like takes place, the retry operation can also be included in one of the additional operations. In the case of such a retry operation, in the flow of operations of FIGS. 10 and 11, the length over which reverse conveyance of the substrate takes place is taken into account, with respect to the insufficiency of the already stored length and the new storable length in the respective storage devices BF1, BF2 obtained under the specified speed Vpp.

(Modification 2) In the above-described first embodiment, although it was assumed that the conveying speed of the substrate P passing through the processing devices PR2 to PR4 (PR5) is made uniform with the specified speed Vpp, the specified value of the conveying speed of the substrate P may be made slightly different in each of the processing devices PR2 to PR4 (PR5). In this case, the storage devices BF1, BF2 are operated so as to constantly absorb any surplus or deficiency of the substrate P caused by the difference in the conveying speeds of the substrate P in the preceding and subsequent processing devices. Therefore, the already stored length and the new storable length of the respective storage devices BF1, BF2, which are obtained on the basis of the information acquired in step S3, are changed quickly by the amount of substrate storage and substrate ejection for the purpose of differential absorption. In the simulation of FIG. 11, the interval at which the program of FIG. 10 is executed may be set to be short, so as to deal with such a rapid change.

According to the first embodiment and the modifications described above, in a device manufacturing system for manufacturing electronic devices (electronic circuits) by sequentially conveying the sheet shaped substrate to each of the plurality of processing devices, when an additional operation is performed that temporarily stops conveyance of the substrate in the first processing device (specific processing device) from among the plurality of processing devices, since it is possible to set the conditions for temporary stoppage of the first processing device while continuing the processing operation of the second processing device on the basis of the predicted stoppage time period or the allowable delay time period (waiting time period) Tdp until stoppage occurs, and the storage state (the already stored length or the new storable length) of the substrate in the storage device disposed between the first processing device and the adjacent second processing device, , the possibility that the other processing device (second processing device) will be stopped by being influenced by the temporary stoppage of the first processing device is reduced, and together with reducing the risk of stopping the entire manufacturing line, it is possible to maintain the performance of the processing devices by way of the additional operation, and the quality of the manufactured electronic devices can be maintained at high quality.

[Second Embodiment]

According to the above-described first embodiment, the entire production line is not stopped insofar as possible, even in the event that the respective processing devices PR2 to PR4 are temporarily stopped to perform additional operations. However, it is possible that the respective processing devices PR2 to PR4 gradually increase the processing error with respect to the set conditions due to temporal changes or the like, or stated otherwise, the processing quality in each of the processing devices gradually decreases. In the case that the substrate P is continuously processed through a plurality of different processing devices, as the processing error in any one of the processing devices increases, such errors accumulate, and there is a possibility that the quality of the manufactured devices may deteriorate, leading to stoppage of the entire manufacturing line as a whole. According to the second embodiment, each of the plurality of processing devices performs a control to dynamically adjust the processing conditions and the conveying condition of the substrate P, so as to maintain a final ultimate quality of the manufactured device, and prevent stoppage of the entire manufacturing line insofar as possible.

In the second embodiment as well, the device manufacturing system 10 and the substrate P (FIGS. 1 to 9) as described in the first embodiment are used. As described above, in order to cause a desired metal layer pattern to appear on the substrate P by the device manufacturing system 10, the respective processing devices PR1 to PR5 perform processes with respect to the substrate P in accordance with the setting conditions. For example, as processing conditions for the processing device PR1, processing conditions that define a voltage for emitting plasma and an irradiation time for irradiating the plasma and the like, and a conveying speed condition for the substrate P are set. The processing device PR1 performs a plasma surface treatment with respect to the substrate P while conveying the substrate P in accordance with the setting conditions. As setting conditions (first setting conditions) for the processing device PR2, processing conditions (first processing conditions) including a region condition that defines a region where the photosensitive functional layer is formed, and a film thickness condition that defines the film thickness of the photosensitive functional layer, and the like, and a conveying speed condition for the substrate P are set. The processing device PR2 performs a film forming process for forming the photosensitive functional layer on the substrate P while conveying the substrate P in accordance with the setting conditions.

As setting conditions (second setting conditions) for the processing device PR3, processing conditions (second processing conditions), which include an intensity condition that defines the intensity of the laser beam LB, a scanning speed condition that defines a scanning speed of the spotlight SP (rotational speed of the polygon mirror 66), an exposure frequency condition that defines a multiple exposure number, and a pattern condition (pattern data) that defines the pattern to be drawn, and the like, and a conveying speed condition for the substrate P are set. The processing device PR3 performs an exposure process with respect to the substrate P while conveying the substrate P in accordance with the setting conditions. As setting conditions (third setting conditions) for the processing device PR4, processing conditions (third processing conditions) including a temperature condition that defines the temperature of the developing solution LQ, a concentration condition that defines the concentration of the developing solution LQ, and an immersion time condition that defines an immersion time, and the like, and a conveying speed condition for the substrate P are set. The processing device PR4 performs a development process while conveying the substrate P in accordance with the setting conditions. As setting conditions for the processing device PR5, processing conditions including a temperature condition that defines the temperature of the etching solution, a concentration condition that defines the concentration, and an immersion time condition that defines an immersion time and the like, and a conveying speed condition for the substrate P are set. The processing device PR5 performs an etching process while conveying the substrate P in accordance with the setting conditions. Moreover, in the case that the processing device PR4 performs a plating process, then as setting conditions (third setting conditions) for the processing device PR4, processing conditions (third processing conditions) including a temperature condition that defines the temperature of the plating solution, a concentration condition that defines the concentration of the plating solution, and an immersion time condition that defines an immersion time and the like, and a conveying speed condition for the substrate P are set. Accordingly, the processing device PR4 performs a plating process while conveying the substrate P in accordance with the setting conditions.

The setting conditions for each of the processing devices PR1 to PR5 are preset so that the states of the actual processes (actual processing) implemented by each of the processing devices PR1 to PR5 become target processing states. The setting conditions of each of the processing devices PR1 to PR5 may be stored in a non-illustrated storage medium provided respectively in each of the processing devices PR1 to PR5, or may be stored in a non-illustrated storage medium of the upper level control device 14. Further, in the device manufacturing system 10, the substrate P is conveyed at a constant speed, and the conveying speed condition of the setting conditions set in each of the processing devices PR1 to PR5 is essentially the same speed (for example, a constant speed in a range of 5 mm/second to 50 mm/second).

Although the respective processing devices PR1 to PR5 carry out processing on the substrate P in accordance with the setting conditions, cases may occur in which the states of actual processes (actual processing) exceed an allowable range with respect to a target processing state, resulting in processing errors E. For example, the intensity of the laser beam LB emitted by the laser light source of the light source device 32 may become deteriorated due to aging or the like, or the temperature/concentration of the developing solution LQ or the etching solution may decrease, so that the actual processing state exceeds an allowable range with respect to the target processing state, resulting in processing errors E. For example, if the intensity of the laser beam LB decreases, the exposure amount decreases as well, and therefore, in the case of a photoresist, a portion of the region irradiated with the spotlight SP, and more specifically, the photosensitive functional layer (photoresist layer) on an outer peripheral part of the region that is irradiated with the spotlight SP is not reformed at a deep region. Therefore, a line width of the pattern formed on the photosensitive functional layer by the development process becomes thicker than the line width (target line width) of the desired pattern. Stated otherwise, a portion of the resist layer having been irradiated with light and reformed becomes dissolved by development, and the region of the remaining resist layer portion (non-reformed portion) remains after etching as a (conductive) pattern of the metal layer such as a circuit or wiring for the display panel, and therefore, when the amount of exposure decreases, the line width of the pattern becomes thick. As a result, the pattern of the metal layer appearing on the substrate P differs from the desired pattern.

In the case that the temperature/concentration of the developing solution LQ decreases or the immersion time of the developing solution LQ decreases, it is impossible to sufficiently remove the reformed portion of the photosensitive functional layer by the developing solution LQ. Therefore, in accordance with the latent image formed on the photosensitive functional layer by the processing device PR4, the line width of the pattern formed on the photosensitive functional layer deviates from the target line width. As a result, the pattern of the metal layer appearing on the substrate P does not become the desired pattern.

In the case that the temperature/concentration of the etching solution becomes decreased, or if the immersion time of the etching solution becomes short, etching of the metallic thin film (conductive thin film) formed in a lower layer of the photosensitive functional layer, using as a mask the photosensitive functional layer in which the pattern is formed, cannot be performed sufficiently. Therefore, the line width of the pattern of the metal layer that the processing device PR5 forms by etching deviates from the target line width. In greater detail, since portions where the metallic thin film is not removed by etching become patterns for circuits or wiring for the display panel, in the case that etching is not carried out sufficiently using as a mask the photosensitive functional layer having the pattern formed therein, the line width of the pattern becomes thick. As a result, the pattern of the metal layer appearing on the substrate P does not become the desired pattern.

Further, when the film thickness of the photosensitive functional layer (photoresist) becomes thick, it becomes difficult for a deep portion of the photosensitive functional layer in the region irradiated with the spotlight SP to be reformed, and therefore, in accordance with removal of the reformed portion by the developer LQ, the line width of the pattern formed in the photosensitive functional layer deviates from the target value. As a result, the pattern of the metal layer appearing on the substrate P does not become the desired pattern.

In the foregoing manner, in the event that any one of the states of actual processing implemented by the processing devices PR1 to PR5 with respect to the substrate P in accordance with the setting conditions exceeds an allowable range with respect to the target processing state and has a processing error E, a desired pattern of the metal layer cannot be made to appear on the substrate P, and the shape or size of the pattern varies. Thus, according to the second embodiment, in the case that at least one of the actual processing states implemented on the substrate P by each of the respective processing devices PR1 to PR5 exhibits a processing error E in excess of an allowable range with respect to the target processing state, then in accordance with the processing error E, the upper level control device 14 changes the setting conditions of the processing devices PR other than the processing device PR in which the processing error E is generated. The processing error E indicates the degree to which the shape or dimensions of the pattern formed on the substrate P varies with respect to the shape or dimensions of the target pattern.

In the case that the setting conditions that exhibit the processing error E are setting conditions of the processing device PR3, initially, the setting conditions of the processing device PR3 are changed in a manner so that the processing error E does not occur, or so that the processing error E falls within an allowable range. Then, in the case it is impossible to cope with the situation merely by changing the setting conditions of the processing device PR3, the setting conditions of the other processing devices PR (PR1, PR2, PR4, PR5) are further changed in a manner so that the processing error E does not occur, or so that the processing error E falls within an allowable range. At this time, after completion of the changes in the setting conditions of the other processing devices PR, the setting conditions of the processing device PR3 may be restored to their original state. Further, in the case that the setting conditions that exhibit the processing error E are of a processing device PR other than the processing device PR3, the setting conditions of the processing device PR3 are caused to be changed preferentially, in a manner so that the processing error E does not occur, or so that the processing error E falls within an allowable range.

The upper level control device 14 shown in FIG. 1 is provided with operating devices for setting in each of the processing devices PR1 to PR5 the setting conditions (recipe) so as to be target values for processing, for modifying the setting conditions, and for monitoring the processing situations of each of the processing devices PR1 to PR5. Such operating devices are constituted by input devices such as a keyboard, a mouse, a touch panel, and the like for inputting data, parameters, commands, and the like, and a monitor device (display) adapted to display setting conditions, the processing state, and an occurrence situation of processing errors E of the respective processing devices PR1 to PR5, candidates for processing devices PR in which setting conditions can be changed for correcting the processing errors E, information indicating the scope (correction amount, correction time period, etc.) of the correction, and information concerning adjustment of the conveying speed of the substrate P.

[Operations of Second Embodiment]

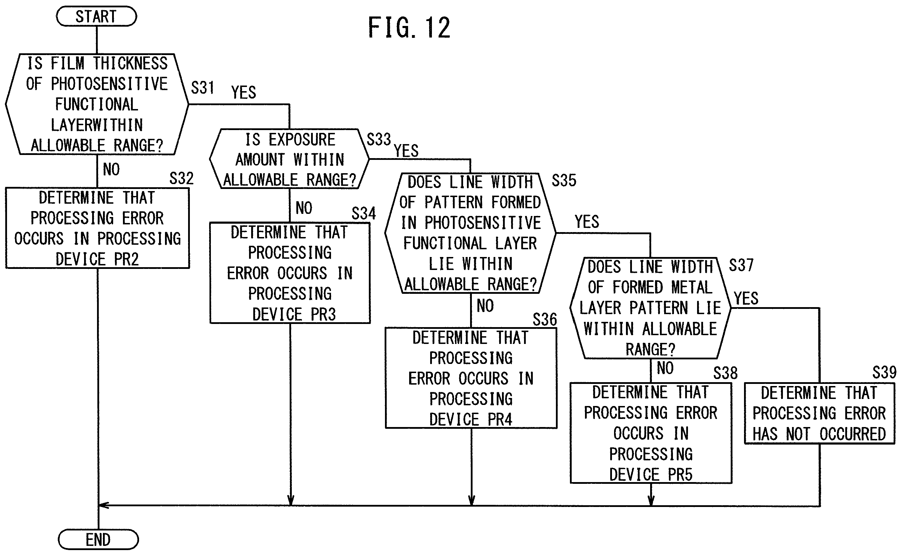

Hereinafter, a detailed description will be presented concerning operations of the device manufacturing system 10, in the case that any one of the actual processing states implemented by the processing devices PR1 to PR5 with respect to the substrate P in accordance with the setting conditions exceeds an allowable range therefor with respect to the target processing state, and includes a processing error E. FIG. 12 is a flowchart showing operations of the device manufacturing system 10 for determining a processing device PR in which a processing error E has occurred in excess of an allowable range. First, the upper level control device 14 determines whether or not the film thickness of the photosensitive functional layer lies within an allowable range (step S31). Stated otherwise, a determination is made as to whether or not the film thickness of the actually formed photosensitive functional layer lies within an allowable range, with respect to a film thickness condition (hereinafter referred to as a target film thickness condition) set so as to bring about the target processing state. Such a determination is carried out based on the film thickness measured by the film thickness measuring device 16a. More specifically, in step S31, it is detected whether or not the quality (fidelity (accuracy) or uniformity in shape and dimensions) of the pattern formed on the substrate P due to the setting conditions of the processing device PR2 has changed (decreased) in excess of an allowable range with respect to a target therefor. If it is determined in step S31 that the film thickness measured by the film thickness measuring device 16a does not lie within the allowable range with respect to the target film thickness, the upper level control device 14 determines that the allowable range is exceeded and that a processing error E (E2) has occurred in the processing device PR2 (step S32). Stated otherwise, a determination is made that the actual processing state implemented by the processing device PR2 has a processing error E2 in which the allowable range with respect to the target processing state is exceeded.

On the other hand, if it is determined in step S31 that the film thickness measured by the film thickness measuring device 16a lies within the allowable range, the upper level control device 14 determines whether or not the exposure amount of the laser beam LB irradiated onto the substrate P by the processing device PR3 lies within an allowable range with respect to a target exposure amount (step S33). Such a determination is carried out by determining whether or not the intensity of the laser beam LB as detected by the intensity sensor 37 lies within an allowable range with respect to an intensity condition (hereinafter referred to as a target intensity condition) set so as to bring about the target processing state. Stated otherwise, since the line width of the pattern formed on the photosensitive functional layer changes depending on the intensity of the laser beam LB, on the basis of the intensity of the laser beam LB which is indicative of the exposure amount, it is determined whether or not the exposure amount lies within the allowable range. Moreover, in step S33, it may be determined whether or not the exposure amount lies within the allowable range, with respect to other information indicative of the exposure amount, for example, a scanning speed condition (hereinafter referred to as a target scanning speed condition), which is set so that the scanning speed of the spotlight SP or the like becomes a target processing state. Further, whether or not the exposure amount lies within the allowable range may be determined based on a plurality of information items (the intensity of the laser beam LB and the scanning speed of the spotlight SP, etc.). More specifically, in step S33, it is detected whether or not the quality (fidelity or uniformity in shape and dimensions) of the pattern formed on the substrate P due to the setting conditions of the processing device PR3 has changed (decreased) in excess of an allowable range with respect to a target therefor. If it is determined in step S33 that the exposure amount does not lie within the allowable range with respect to the target exposure amount (processing condition set so as to obtain the target processing state), the upper level control device 14 determines that the allowable range is exceeded and that a processing error E (E3) has occurred in the processing device PR3 (step S34). Stated otherwise, a determination is made that the actual processing state implemented by the processing device PR3 has a processing error E3 in which the allowable range with respect to the target processing state is exceeded.

On the other hand, if it is determined in step S33 that the exposure amount lies within the allowable range, the upper level control device 14 determines whether or not the line width of the pattern formed in the photosensitive functional layer lies within the allowable range by the developing device PR4 performing the development process (step S35). The upper level control device 14 measures the line width of the pattern formed in the photosensitive functional layer on the basis of the image data captured by the imaging device 83 provided inside the processing device PR4. In principle, the setting conditions of the processing device PR4 are set so that the line width of the pattern formed in the photosensitive functional layer becomes the target line width. However, for example, in the case that the temperature, the concentration, or the immersion time of the developing solution LQ becomes less than or shorter than a temperature condition (hereinafter referred to as a target temperature condition), a concentration condition (hereinafter referred to as a target concentration condition), or an immersion time condition (hereinafter referred to as a target immersion time condition), which are set so as to bring about the target processing state, the line width of the pattern to be formed deviates from the target line width. More specifically, in step S35, it is detected whether or not the quality (fidelity or uniformity in shape and dimensions) of the pattern formed on the substrate P due to the setting conditions of the processing device PR4 has changed (decreased) in excess of an allowable range with respect to a target therefor. If it is determined in step S35 that the line width of the pattern formed in the photosensitive functional layer does not lie within the allowable range with respect to the target line width, the upper level control device 14 determines that the allowable range is exceeded and that a processing error E (E4) has occurred in the processing device PR4 (step S36). Stated otherwise, a determination is made that the actual processing state implemented by the processing device PR4 has a processing error E4 in which the allowable range with respect to the target processing state is exceeded.

On the other hand, if it is determined in step S35 that the line width of the pattern formed in the photosensitive functional layer lies within the allowable range, the upper level control device 14 determines whether or not the line width of the metal layer pattern appearing on the substrate P by the etching performed by the processing device PR5 lies within an allowable range (step S37). The upper level control device 14 measures the line width of the metal layer pattern on the basis of the image data captured by the imaging device 83 provided inside the processing device PR5. In principle, the setting conditions of the processing device PR5 are set so that the line width of the metal layer pattern becomes the target line width. However, for example, in the case that the temperature, the concentration, or the immersion time of the etching solution becomes less than or shorter than a temperature condition (hereinafter referred to as a target temperature condition), a concentration condition (hereinafter referred to as a target concentration condition), or an immersion time condition (hereinafter referred to as a target immersion time condition), which are set so as to bring about the target processing state, the line width of the pattern to be formed deviates from the target line width. More specifically, in step S37, it is detected whether or not the quality (fidelity or uniformity in shape and dimensions) of the pattern formed on the substrate P due to the setting conditions of the processing device PR5 has changed (decreased) in excess of an allowable range with respect to a target therefor. If it is determined in step S37 that the line width of the metal layer pattern does not lie within the allowable range with respect to the target line width, the upper level control device 14 determines that the allowable range is exceeded and that a processing error E (E5) has occurred in the processing device PR5 (step S38). Stated otherwise, a determination is made that the actual processing state implemented by the processing device PR5 has a processing error E5 in which the allowable range with respect to the target processing state is exceeded. On the other hand, if it is determined in step S37 that the line width of the metal layer pattern lies within the allowable range, it is determined that a processing error E has not occurred in the processing devices PR2 to PR5 (step S39).

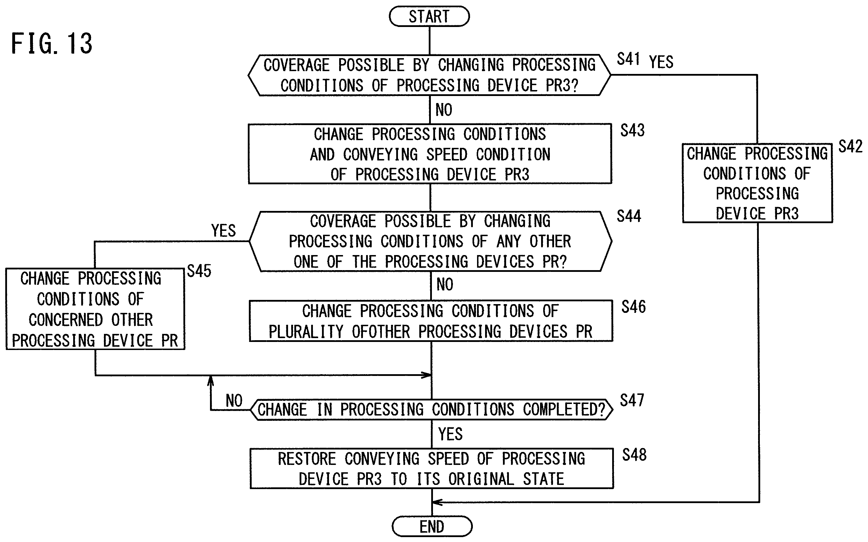

Operations of the device manufacturing system 10 will be described for a case in which it is determined in step S34 of FIG. 12 that a processing error E3 in excess of an allowable range has occurred in the processing device PR3. FIG. 13 is a flowchart showing operations of the device manufacturing system 10, in the case that the processing error E3 in excess of the allowable range occurs in the processing device PR3. In the case that the processing error E3 is generated in the processing device PR3, the upper level control device 14 determines whether or not it is possible to cover the processing error E3 by changing the processing conditions from among the setting conditions of the processing device PR3 (step S41). Stated otherwise, a determination is made as to whether or not the processing error E3 can be eliminated, or whether the processing error E3 can be kept within an allowable range, by changing the processing conditions. For example, if the exposure amount is insufficient beyond an allowable range with respect to the target exposure amount, it is necessary to increase the exposure amount up to the target exposure amount, and a determination is made whether or not the target exposure amount can be realized by changing the processing conditions. Since the exposure amount is determined by the intensity of the laser beam LB and the scanning speed of the spotlight SP, in step S41, it is determined whether or not, by changing the intensity condition and the scanning speed condition, the actual exposure amount can be raised up to the target exposure amount.

If it is determined in step S41 that coverage is possible by changing the processing conditions, the upper level control device 14 changes the processing conditions (intensity condition, scanning speed condition, pattern condition, etc.) of the setting conditions of the processing device PR3 in accordance with the processing error E3 (step S42). On the other hand, if it is determined in step S41 that coverage is not possible merely by changing the processing conditions, the upper level control device 14 changes the processing conditions and the conveying speed condition of the processing device PR3 in accordance with the processing error E3 (step S43). For example, in the case that the actual exposure amount is insufficient beyond the allowable range with respect to the target exposure amount, together with changing the processing conditions, the conveying speed condition is changed in a manner so that the conveying speed of the substrate P becomes slower. By slowing down the conveying speed condition, the exposure amount can be increased. Here, among the processing errors E3, a processing error that can be covered by changing the processing conditions is designated by E3a, and a processing error that can be covered by changing the conveying speed condition is designated by E3b. Accordingly, E3 = E3a + E3b. In the case that the processing error E3 can be covered merely by changing the processing conditions, E3a = E3 and E3b = 0. Further, in the case that the processing conditions cannot be changed, for example, in the case where the currently set intensity condition is a maximum intensity or the like, the situation is coped with by changing only the conveying speed condition in accordance with the processing error E3. In this case, E3a = 0 and E3b = E3.

In this instance, although the processing devices PR1 to PR5 convey the substrate P at a constant speed, since the processing device PR3 is disposed between the first storage device BF1 and the second storage device BF2, it is possible to independently change the conveying speed of the substrate P inside the device PR3. Stated otherwise, the difference between the conveying speed of the processing device PR3 and the conveying speed of the processing devices PR other than the processing device PR3 can be absorbed by the first storage device BF1 and the second storage device BF2. When the conveying speed of the substrate P inside the processing device PR3 conveys the substrate more slowly than a certain speed, the stored amount of the substrate P in the first storage device BF1 gradually increases, whereas the stored amount in the second storage device BF2 gradually decreases. Conversely, when the conveying speed of the substrate P inside the processing device PR3 conveys the substrate more rapidly than the certain speed, the stored amount of the substrate P in the first storage device BF1 gradually decreases, whereas the stored amount in the second storage device BF2 gradually increases. If the stored length of the first storage device BF1 or the second storage device BF2 becomes less than or equal to a predetermined storage length, since the substrate P is no longer abundant in the first storage device BF1 or the second storage device BF2, it becomes impossible to independently change the conveying speed of the substrate P inside the processing device PR3. Further, the first storage device BF1 or the second storage device BF2 is incapable of storing the substrate P of a length which is longer than a predetermined length. Therefore, even though it is possible to temporarily change the conveying speed of the substrate P inside the processing device PR3, the conveying speed of the substrate P cannot be changed for a certain period of time or more.

Therefore, in order to maintain the storage length of the first storage device BF1 and the second storage device BF2 within a predetermined range, it is necessary to restore the conveying speed of the substrate P in the processing device PR3 to its original state. For this purpose, when the processing conditions and the conveying speed condition of the processing device PR3 are changed in step S43, the upper level control device 14 changes the processing conditions of any one of the other processing devices PR, whereby a determination is made as to whether or not a processing error E3b, which is generated in the case that the conveying speed condition of the processing device PR3 is restored to its original state, is capable of being covered (compensated) (step S44). Stated otherwise, when the conveying speed of the processing device PR3 is restored to its original state, the exposure amount is reduced, and therefore, it is determined whether or not the line width of the pattern can be made the target line width by compensating for any malfunction caused thereby with other processing devices PR.

If it is determined in step S44 that coverage is possible by changing the processing conditions of any one of the processing devices PR in accordance with the processing error E3b, the processing conditions of the other processing device PR, which are determined to be capable of being covered, are changed in accordance with the processing error E3b generated when the conveying speed condition of the processing device PR3 is restored to its original state (step S45), and the process proceeds to step S47. For example, in the case that the processing device PR which was determined to be capable of being covered by changing the processing conditions is the processing device PR2, the processing conditions (film thickness condition and the like) of the processing device PR2 are changed in accordance with the processing error E3b (for example, an insufficient exposure amount) that was generated when the conveying speed condition of the processing device PR3 was restored to its original state. In the case that the processing error E3 is an insufficient exposure amount, then as the film thickness becomes thinner, deep portions of the photosensitive functional layer are reformed even if the amount of exposure is small, and therefore, by narrowing the thickness of the film thickness condition, it is possible to cover the processing error E3b (insufficient exposure amount), which is generated when the conveying speed condition of the processing device PR3 is restored to its original state. As a result, by the development process, the line width of the pattern formed in the photosensitive functional layer as well as the line width of the appearing metal layer can be made the target line width.

In the case that the processing device PR which was determined to be capable of being covered by changing the processing conditions is the processing device PR4, the processing conditions (temperature condition, concentration condition, immersion time condition) of the processing device PR4 are changed in accordance with the processing error E3b that was generated when the conveying speed condition of the processing device PR3 was restored to its original state. For example, as the temperature and concentration of the developing solution LQ become higher, or the immersion time that the substrate P is immersed in the developing solution LQ becomes longer, the areas in which the photosensitive functional layer is dissolved and removed widen, and therefore, the photosensitive functional layer can be removed up to a deep portion thereof. Accordingly, in the case that the processing error E3 is an insufficient exposure amount, then by increasing or lengthening at least one of the temperature condition, the density condition, and the immersion time condition, it is possible to cover the processing error E3b (insufficient exposure amount), which is generated when the conveying speed condition of the processing device PR3 is restored to its original state, and the line width of the pattern can be made the target line width. The lower level control device 80 of the processing device PR4 controls the heaters H1, H2 of the processing device PR4 in accordance with the temperature condition, and moves the movable member 84 of the processing device PR4 in accordance with the immersion time condition. Further, in the processing tank BT of the processing device PR4, a circulation system is provided for recovering the developing solution LQ in the processing tank BT together with supplying a new developing solution LQ to the processing tank BT, and the lower level control device 80 of the processing device PR4 changes the concentration of the developing solution LQ supplied to the processing tank BT in accordance with the concentration condition.

In the case that the processing device PR which was determined to be capable of being covered by changing the processing conditions is the processing device PR5, the processing conditions (temperature condition, concentration condition, immersion time condition) of the processing device PR5 are changed in accordance with the processing error E3b that was generated when the conveying speed condition of the processing device PR3 was restored to its original state. For example, the metallic thin film formed in a lower layer of the photosensitive functional layer is etched with the photosensitive functional layer in which the pattern was formed serving as a mask. However, as the temperature/concentration of the etching solution becomes higher, or as the immersion time during which the substrate P is immersed in the etching solution becomes longer, the portion to be etched widens. Accordingly, in the case that the processing error E3 is an insufficient exposure amount, then by increasing or lengthening at least one of the temperature condition, the density condition, and the immersion time condition of the etching solution, it is possible to cover the processing error E3b (insufficient exposure amount), which is generated when the conveying speed condition of the processing device PR3 is restored to its original state, and the line width of the pattern can be made the target line width. The lower level control device 80 of the processing device PR5 controls the heaters H1, H2 of the processing device PR5 in accordance with the temperature condition, and moves the movable member 84 of the processing device PR5 in accordance with the immersion time condition. Further, in the processing tank BT of the processing device PR5, a circulation system is provided for recovering the etching solution in the processing tank BT together with supplying a new etching solution to the processing tank BT, and the lower level control device 80 of the processing device PR5 changes the concentration of the etching solution supplied to the processing tank BT in accordance with the concentration condition.

In this instance, it may also be considered to cover the processing error E3b generated in the processing device PR3 by changing the processing conditions of the processing devices PR other than the processing device PR3 from the start, without necessarily changing the conveying speed condition of the processing device PR3. However, in the processing device PR3 (a patterning device such as the exposure device EX), when the processing conditions change, it is possible to instantaneously change the processing state of actual processing in accordance with the change in the processing conditions. However, in the other processing devices (primarily, the wet processing devices) apart from the processing device PR3, even if the processing conditions are changed, a certain amount of time is required until the state of actual processing arrives at the target processing state determined by the processing conditions after the change, and it is not possible for the processing error E3b generated in the processing device PR3 to be covered rapidly. For example, even if the processing conditions (film thickness conditions, etc.) of the processing device PR2 are changed, the film thickness of the photosensitive functional layer formed on the substrate P changes gradually over time. Further, even if the processing conditions (temperature condition, concentration condition, immersion time condition) of the processing devices PR4, PR5 are changed, the temperature and concentration of the developing solution LQ and the etching solution and the immersion time gradually change over time. Therefore, until the actual processing states of the other processing devices PR arrive at the target processing state determined by the processing conditions after change thereof, the processing error E3b is dealt with by gradually changing the conveying speed of the substrate P in the processing device PR3. After the processing conditions of the other processing devices PR have been changed, the processing state of actual processing by the other processing devices PR gradually approach the target processing state determined by the processing conditions after change thereof, and therefore, in accordance therewith, the upper level control device 14 gradually restores the conveying speed condition of the substrate P inside the processing device PR3. The upper level control device 14 causes the conveying speed condition of the substrate P inside the processing device PR3 to gradually approach the conveying speed condition before the change was made, on the basis of the detection results of the film thickness measuring device 16a, the temperature sensor Ts, the concentration sensor Cs, and the position sensor 87, etc.

Moreover, if there are a plurality of the processing devices PR which are capable of covering the processing error E3b generated when the conveying speed condition of the processing device PR3 is restored to its original state, the processing conditions of the processing device PR that is nearer to the processing device PR3 may be changed. For example, in the case that the processing devices PR which are capable of covering the processing error E3b generated when the conveying speed condition of the processing device PR3 is restored to its original state are the processing device PR2 and the processing device PR5, the processing conditions of the processing device PR2 which is nearer to the processing device PR3 may be changed. Further, in step S44, a determination has been made as to whether or not the processing error E3b, which is generated when the conveying speed of the processing device PR3 is restored to its original state, can be covered by the other processing devices PR. However, a determination may be made as to whether or not the other processing devices PR are capable of covering the processing error E3 generated in the processing device PR3, and more specifically, the processing error E3 that is generated when the processing conditions and the conveying speed condition of the processing device PR3 are returned to their original states. At this time, in step S45, by changing the processing conditions of the other processing devices PR which were determined to be capable of covering, the processing error E3 generated in the processing device PR3 is covered. In this case, after the processing conditions of the other processing devices PR have been changed, the processing state of actual processing by the other processing devices PR gradually approach the target processing state determined by the processing conditions after change thereof, and therefore, in accordance therewith, the upper level control device 14 gradually restores the processing conditions in addition to the conveying speed condition of the processing device PR3.

On the other hand, if it is determined in step S44 that the processing error E3b (for example, an insufficient exposure amount) generated when the conveying speed condition of the processing device PR3 is restored to its original state cannot be covered merely by changing the processing conditions of any one of the processing devices PR, then the upper level control device 14 changes the processing conditions of the plurality of other processing devices PR in accordance with the processing error E3b generated when the conveying speed condition of the processing device PR3 is restored to its original state (step S46), and the process proceeds to step S47. In this case, since with the elapse of time, the processing states of the actual processing of the plurality of other processing devices PR approach the target processing states determined by the processing conditions after change thereof, the upper level control device 14 gradually restores the conveying speed condition of the substrate P inside the processing device PR3 to its original state.

Moreover, the processing conditions of the plurality of other processing devices PR may be changed in accordance with the processing error E3 generated in the processing device PR3. In this case, after having changed the processing conditions of the plurality of other processing devices PR, the processing state of actual processing gradually approaches the target processing state determined by the processing conditions after change thereof, and therefore, in accordance therewith, the upper level control device 14 gradually restores the processing conditions in addition to the conveying speed condition of the processing device PR3.

Upon proceeding to step S47, the upper level control device 14 determines whether or not the change in the processing conditions is completed. Stated otherwise, a determination is made as to whether or not the state of actual processing by the processing devices PR whose processing conditions have been changed in step S45 or S46 have become the target processing state determined by the processing conditions after change thereof. Such a determination is carried out on the basis of detection results of the film thickness measuring device 16a, the temperature sensor Ts, the concentration sensor Cs, and the position sensor 87, etc. If it is determined in step S47 that the change in the processing conditions has not been completed, the process remains at step S47, whereas if it is determined that the change in the processing conditions has been completed, the conveying speed condition of the processing device PR3 is restored to its original state (step S48). In the case that the processing error E3 generated in the processing device PR3 is covered by the other processing devices PR, the processing conditions in addition to the conveying speed condition of the processing device PR3 are restored to their original state.

In the case that, in step S46, it is not possible to cover the processing error E3b of the processing device PR3, even if the processing conditions of the plurality of other processing devices PR are changed, a determination is made as to whether or not it is possible to change the conveying speed condition of the plurality of other processing devices PR, and if such a change is possible, the conveying speed conditions of all of the processing devices PR1 to PR5 may be changed so as to be the same. For example, the conveying speed conditions of the processing devices PR1, PR2, PR4, PR5 may be changed so as to be the same as the conveying speed condition of the processing device PR3 that was changed in step S43.

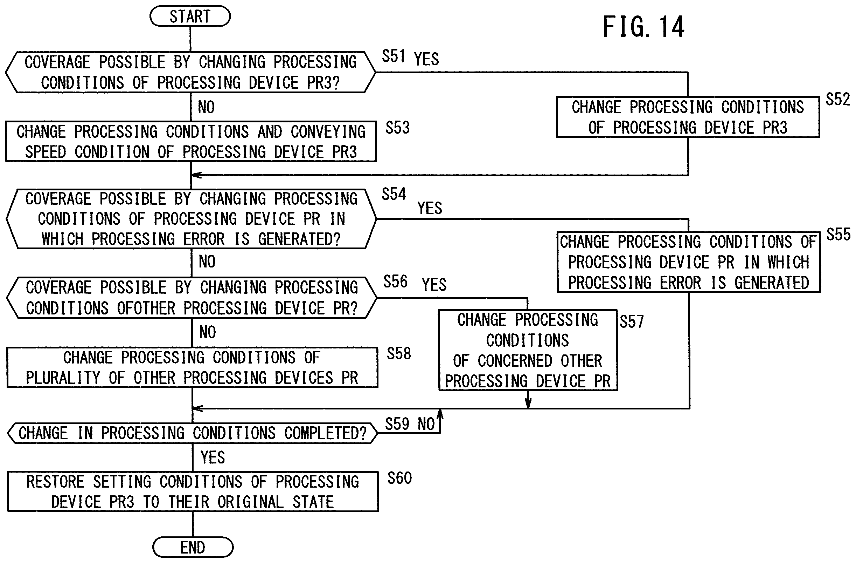

Next, operations of the device manufacturing system 10 will be described for a case in which it is determined in steps S32, S36, or S38 of FIG. 12 that a processing error E (E2, E4, or E5) in excess of an allowable range has occurred in a processing device PR (PR2, PR4, or PR5) apart from the processing device PR3. FIG. 14 is a flowchart showing operations of the device manufacturing system 10, in the case that a processing error E in excess of the allowable range occurs in the processing devices PR other than the processing device PR3. In the case that the processing error E (E2, E4, or E5) is generated in the processing devices PR other than the processing device PR3, the upper level control device 14 determines whether or not it is possible to cover the processing error E (E2, E4, or E5) by changing the processing conditions of the processing device PR3 (step S51). For example, in the case that the other processing device PR in which the processing error E has occurred is the processing device PR2, and the film thickness of the actually formed photosensitive functional layer is thicker than the target film thickness condition, the line width of the pattern formed in the photosensitive functional layer in the processing device PR4 is increased, and therefore, a determination is made as to whether or not, by changing the processing conditions of the processing device PR3, the exposure amount can be increased and the line width of the pattern formed in the photosensitive functional layer can be made the target line width. Further, in the case that the other processing device PR in which the processing error E has occurred is the processing device PR4 or PR5, and the temperature, concentration, or immersion time of the actual developing solution LQ or the etching solution is lower or shorter than the target temperature condition, concentration condition, or immersion time condition, the line width of the pattern formed in the photosensitive functional layer or the metal layer pattern is increased, and therefore, a determination is made as to whether or not, by changing the processing conditions of the processing device PR3, the exposure amount can be increased and the line width of the pattern formed in the photosensitive functional layer or the metal layer pattern can be made the target line width.

If it is determined in step S51 that the situation can be coped with by changing the processing conditions of the processing device PR3, the upper level control device 14 changes the processing conditions (intensity condition, scanning speed condition, pattern condition, etc.) of the processing device PR3 in accordance with the processing error E (E2, E4, or E5) (step S52). On the other hand, if it is determined in step S51 that the situation cannot be coped with by changing the processing conditions, the upper level control device 14 changes the processing conditions and the conveying speed condition of the processing device PR3 in accordance with the processing error E (E2, E4, or E5) (step S53). Moreover, in the case that the processing conditions cannot be changed, for example, in the case where the currently set intensity condition is a maximum intensity or the like, the situation is coped with by changing only the conveying speed condition in accordance with the processing error E (E2, E4, or E5).

Next, the upper level control device 14 determines whether or not it is possible to cover the processing error E (E2, E4, or E5) even in the case that the setting conditions of the processing device PR3 are restored to their original state, by changing the processing conditions of the processing device PR (PR2, PR4, or PR5) in which the processing error E (E2, E4, or E5) is generated (step S54). Stated otherwise, a determination is made as to whether or not the processing error E that occurred can be eliminated even in the case that the setting conditions of the processing device PR3 are restored to their original state, by changing the processing conditions of the processing device PR in which the processing error E is generated. For example, in the case that the processing device PR in which the processing error E occurred is the processing device PR2, and the film thickness of the actually formed photosensitive functional layer exhibits the processing error E2 with respect to the target film thickness condition, a determination is made as to whether or not the film thickness condition can be changed in accordance with the processing error E2. Further, in the case that the other processing device PR that generated the processing error E is the processing device PR4 or PR5, and the temperature, concentration, or immersion time of the actual developing solution LQ or the etching solution exhibits the processing error E4 or E5 with respect to the target temperature condition, the concentration condition, or the immersion time condition, a determination is made as to whether or not the temperature condition, the concentration condition, or the immersion time condition can be changed in accordance with the processing error E4 or E5.

If it is determined in step S54 that by changing the processing conditions of the processing device PR in which the processing error E is generated, the processing error E can be covered even in the case that the setting conditions of the processing device PR3 are returned to their original state, the upper level control device 14 changes the processing conditions of the processing device PR in which the processing error E is generated (step S55). For example, in the case that the processing device PR in which the processing error E occurred is the processing device PR2, and the film thickness of the actually formed photosensitive functional layer is thick relative to the target film thickness, the film thickness condition is made thinner in accordance with the processing error E2. Further, in the case that the processing device PR that generated the processing error E is the processing device PR4 or PR5, and the processing condition of at least one of the temperature, the concentration, and the immersion time of the actual developing solution LQ or the etching solution is lower or shorter than the target temperature condition, the concentration condition, or the immersion time condition, at least one of the temperature condition, the concentration condition, and the immersion time condition is made higher or longer in accordance with the processing error E4 or E5. In this case, since the processing state of actual processing of the processing device PR in which the processing error E is generated changes together with the elapse of time, in accordance therewith, the upper level control device 14 gradually restores the setting conditions of the processing device PR3 to their original state.

On the other hand, if it is determined in step S54 that the processing error E (E2, E4, or E5) cannot be eliminated, even if the processing conditions of the processing device PR (PR2, PR4, or PR5) in which the processing error E (E2, E4, or E5) is generated are changed, the upper level control device 14 determines whether it is possible to cover the processing error E by changing the processing conditions of the other processing devices PR (excluding the processing device PR3) (step S56). For example, in the case that the processing device PR in which the processing error E occurred is the processing device PR2, and the film thickness of the actually formed photosensitive functional layer exceeds the allowable range with respect to the target film thickness condition and exhibits the processing error E2, a determination is made as to whether or not the processing error E2 can be covered by changing the processing conditions of the processing device PR4 or PR5. For example, in the case that the film thickness of the actually formed photosensitive functional layer is thicker than the target film thickness condition, the line width of the pattern becomes thick, and therefore, a determination is made as to whether or not the pattern line width can be made the target line width by increasing or lengthening the temperature, the concentration, or the immersion time of the developing solution LQ or the etching solution.

If it is determined in step S56 that the situation can be coped with by changing the processing conditions of the other processing devices PR, the upper level control device 14 changes the processing conditions of the other processing devices PR in accordance with the processing error E (step S57), and the process proceeds to step S59. For example, in the case that the processing device PR in which the processing error E occurred is the processing device PR2, and the film thickness of the actually formed photosensitive functional layer is thick relative to the target film thickness, at least one of the processing conditions from among the temperature condition, the concentration condition, and the immersion time of the processing device PR4 or PR5 is made higher or longer in accordance with the processing error E2. In this case, since with the elapse of time, the processing states of the actual processing of the other processing devices PR are made to approach the target processing states determined by the processing conditions after change thereof, in accordance therewith, the upper level control device 14 gradually restores the setting conditions of the processing device PR3 to their original state.

On the other hand, if it is determined in step S56 that the situation cannot be coped with by changing the processing conditions of the other processing devices PR, the upper level control device 14 changes the processing conditions of a plurality of other processing devices PR apart from the processing device PR3 in accordance with the processing error E (step S58), and the process proceeds to step S59. In this case, since with the elapse of time, the processing states of actual processing of the plurality of other processing devices PR are made to approach the target processing states determined by the processing conditions after change thereof, in accordance therewith, the upper level control device 14 gradually restores the setting conditions of the processing device PR3 to their original state.

Upon proceeding to step S59, the upper level control device 14 determines whether or not the change in the processing conditions is completed. Stated otherwise, a determination is made as to whether or not the state of actual processing by the processing devices PR whose processing conditions have been changed in step S55, S57, or S58 have become the target processing state determined by the processing conditions after change thereof. Such a determination is carried out on the basis of detection results of the film thickness measuring device 16a, the temperature sensor Ts, the concentration sensor Cs, and the position sensor 87, etc. If it is determined in step S59 that the change in the processing conditions has not been completed, the process remains at step S59, whereas if it is determined that the change in the processing conditions has been completed, the setting conditions of the processing device PR3 are restored to their original state (step S60).

Moreover, in the case that only the processing conditions of the processing device PR3 are changed in step S52, the operations shown in FIG. 14 may be ended in the same manner as the operations shown in FIG. 13. Stated otherwise, in this case, the operations of steps S54 to S60 are unnecessary. Further, in step S60, although the setting conditions of the processing device PR3 have been restored to their original state, only the conveying speed condition of the processing device PR3 may be restored to its original state. In this case, in step S55, S57, or S58, the processing conditions are changed in accordance with processing errors that occur only in the case that the conveying speed condition of the processing device PR3 is restored to its original state.

In the foregoing manner, in the case that the actual processing state (actual processing results) by the processing device PR of any one of the processing devices PR2 to PR5 has a processing error E with respect to a target processing state (design value), the setting conditions of the other processing devices PR are dynamically changed in accordance with the processing error E, and therefore, it is possible to continuously manufacture electronic devices of stable quality without stopping the manufacturing line. Further, as the processing devices PR, in a patterning device such as an exposure device (drawing device) EX or an inkjet printing device, superimposed exposure or superimposed printing is performed with respect to a pattern of an underlying layer that is already formed on the substrate P. Overlaying precision is particularly important when creating a layered structure (gate electrode layer, insulating device, semiconductor layer, source/drain electrode layer) of a thin film transistor or the like. For example, in a layered structure of a thin film transistor, the relative overlaying accuracy between layers, and the fidelity (line width reproducibility) of the pattern dimensions depend on the performance (positioning accuracy, exposure amount, ink discharge amount, etc.) of the patterning device. The performance of the patterning device generally deteriorates gradually, unless there is a sudden significant deterioration due to some serious trouble. According to the second embodiment, the state of the patterning device, which deteriorates gradually in performance in this manner, is monitored, and the processing conditions of the other processing devices PR are adjusted. Therefore, in the case that the performance of the patterning device varies within an allowable range, or even if it falls outside of the allowable range, ultimately, it is possible to maintain the dimensional (line width) accuracy of the pattern that is formed on the substrate P within the target range.

Moreover, in the second embodiment, by arranging the first storage device BF1 and the second storage device BF2 before and after the processing device PR3, it is possible to freely change the conveying speed of the substrate P in the processing device PR3. However, for example, the first storage device BF1 and the second storage device BF2 may be arranged before and after the processing device PR2 or the processing device PR4, and the conveying speed of the substrate P in the processing device PR2 or the processing device PR4 may be freely changed. Further, for example, by arranging the first storage device BF1 and the second storage device BF2 before and after a plurality of the processing devices PR, the conveying speed of the substrate P in the plurality of processing devices PR can be freely changed. In this manner, changing of the conveying speed condition in each of the plurality of processing devices PR signifies that the actual processing states of the respective processing devices PR are changed. For example, concerning the processing device PR2, even if processing conditions including the film thickness condition are not changed, by slowing down the conveying speed condition, the film thickness of the photosensitive functional layer formed therein can be made thicker. Conversely, by speeding up the conveying speed condition, the film thickness of the photosensitive functional layer formed therein can be made thinner. Further, concerning the processing devices PR4, PR5, even if processing conditions such as the immersion time condition or the like are not changed, by slowing down the conveying speed condition, as a result, the time period during which the substrate P is immersed in the developing solution LQ or the etching solution is lengthened. Conversely, by speeding up the conveying speed condition, as a result, the time period during which the substrate P is immersed in the developing solution LQ or the etching solution is shortened. In this case as well, settings for the conveying speed condition in the respective processing devices PR are changed, in a manner so that the storage length of each of the first storage device BF1 and the second storage device BF2 falls within a predetermined range.

Further, although it is determined in step S33 of FIG. 12 whether or not the exposure amount is within an allowable range, it may also be determined whether or not the line width of the pattern formed in the photosensitive functional layer lies within an allowable range. In this case, if it is determined that the line width of the pattern is not within the allowable range, then in step S34, a determination is made that the processing error E3 is generated in the processing device PR3, and when it is determined that the line width of the pattern lies within the allowable range, the process may skip over step S35 and proceed to step S37. Accordingly, in this case, the operations of steps S35 and S36 are unnecessary. The line width of the pattern also varies depending on the conditions of the development process. However, it is considered that the line width of the pattern changes significantly depending on the state of actual processing performed in the processing device PR3. Therefore, based on the line width of the pattern formed in the photosensitive functional layer, it is determined whether or not the processing error E3 has occurred in the processing device PR3.

Further, the change in the line width of the pattern formed in the photoresist layer after development thereof is relatively sensitive to changes in the exposure amount and changes in the thickness of the resist layer, and exhibits linearity. In contrast thereto, the photosensitive functional layer, which is made of a photosensitive silane coupling material or the like, switches from a non-reformed state to a reformed state, depending on whether or not a constant exposure amount (illuminance) is imparted thereto irrespective of its thickness. Therefore, in practical terms, it is difficult to correct the line width by adjusting the thickness of the photosensitive functional layer or adjusting the exposure amount. However, in the case that an exposure amount greater than necessary is imparted thereto, there is a tendency for the line width of the portion to be modified to become somewhat thick. Accordingly, in the case of using a photosensitive functional layer such as a photosensitive silane coupling material or the like, based on a line width measurement value of the metallic pattern precipitated after the plating process, the condition of the plating process is effectively corrected and the line width itself of the pattern when the photosensitive functional layer is exposed is effectively corrected (i.e., the drawing data is effectively corrected) with respect to the design value.

As described above, according to the second embodiment of the present invention, among the plurality of processing devices PR, in the event there is a processing device PR in which a processing error E occurs in an actual processing state with respect to a target processing state, the setting conditions of other processing devices PR are changed in accordance with the processing error E, whereby it is possible to continuously manufacture electronic devices without requiring stoppage of the manufacturing line. More specifically, during a process of sequentially forming a layered structure and a pattern shape of electronic devices on the sheet substrate P by the plurality of processing devices PR, even in the case that the actual processing results by the specified processing device PR causes processing errors to be generated with respect to preset setting conditions (design values), not only is the specified processing device PR itself controlled to suppress the processing errors, but other processing devices PR located upstream or downstream with respect to the specified processing device PR dynamically change the processing conditions so as to cancel out or suppress defects caused by the processing errors. Consequently, it is possible to significantly reduce the probability of an interruption in processing by the processing devices PR, as well as a temporary stoppage of the entire manufacturing line caused by processing errors occurring in certain processes in the manufacturing line.

Further, the second embodiment of the present invention is not necessarily limited to a manufacturing line in which three different processing devices PR (processing units) are arranged in the conveying direction (longitudinal direction) of the substrate P, and the embodiment is applicable insofar as at least two processing devices PR (processing units), which carry out sequential processing on the substrate P, are arranged in a line. In such a case, the processing conditions of the two processing devices PR are dynamically adjusted, or alternatively, the conveying speed of the substrate P in each of the two processing devices PR is temporarily changed so that defects (a line width change or the like) caused by processing errors that have occurred with respect to preset setting conditions are cancelled or suppressed between the two processing devices PR. In this case, the two processing devices PR (processing units) to which the second embodiment is applied are not necessarily required to be disposed one behind the other in the conveying direction (longitudinal direction) of the substrate P, and a configuration may be provided in which at least one other processing device PR (processing unit) is arranged between the two processing devices PR (processing unit) to which the second embodiment is applied. For example, in the case that a development process is carried out after the exposure process, according to the second embodiment, the substrate P is immediately delivered to a developing unit through an exposure unit. However, in the case that development is carried out after a post-baking treatment in which the photoresist layer after exposure thereof is heated at a relatively high temperature, a heating device (heating unit) or the like for the post-baking treatment may correspond to the other processing device PR.

Moreover, in the above-described second embodiment, in order to simplify the description, an exemplary case was presented in which only one processing device PR exhibits a processing error E where the actual processing state thereof exceeds the allowable range with respect to the target processing state. However, two or more processing devices PR may exist which exhibit processing errors E where the processing state of actual processing thereof exceeds the allowable range with respect to the target processing state. In this case as well, as described above, in the case that the processing devices PR in which processing errors E occur do not include the processing device PR3, the setting conditions of the processing device PR3 are preferentially changed. Further, in the case that the processing devices PR in which processing errors E are generated include the processing device PR3, initially, the setting conditions of the processing device PR3 are changed.

Further, in order to make the description easy to understand, the device manufacturing system 10 according to the embodiments of the present invention has been described separately for the first embodiment and the second embodiment. Accordingly, the configuration, functions, characteristics, performance, and properties and the like possessed by the device manufacturing system 10 described in the second embodiment can also be cited and applied to the first embodiment as necessary. Conversely, the configuration, functions, characteristics, performance, and properties and the like possessed by the device manufacturing system 10 described in the first embodiment can also be cited and applied to the second embodiment as necessary. Accordingly, the first embodiment and the second embodiment may be combined together in a manner so that the first embodiment and the second embodiment are implemented in the device manufacturing system 10 (manufacturing line). In accordance with such a combination, since the performance and precision of the processing devices can be stably maintained over a prolonged time period, it is possible to accurately cover processing errors due to process variations occurring at locations amongst the plurality of processing steps, and the production line can be operated over a long time.

[Modifications of Second Embodiment]

The second embodiment described above may be modified in the following manner.

(Modification 1) In the above-described second embodiment, each of the plurality of processing devices PR (PR1 to PR5) installed in the device manufacturing system (manufacturing line) 10 shown in FIG. 1 is capable of adjusting, during the processing operations, the conveying speed of the sheet substrate P passing through the respective processing devices, corresponding to an adjustment of the processing conditions and setting conditions of the respective processing devices PR. However, a configuration may be provided in which the conveying speed of the substrate P passing through the respective processing devices PR is kept constant in each of the processing devices PR, and an excess or shortage of a conveyed amount (conveyed length) of the substrate P due to the difference in conveying speeds of the substrate P between the processing devices PR is absorbed by the first storage device BF1 or the second storage device BF2 disposed between the processing devices PR. In the case of such a configuration, an allowable range of the difference in the conveying speeds of the substrate P between the processing devices PR is determined in general by the total length Lf of the substrate P to be continuously processed, and the maximum storage length of the first storage device BF1 or the second storage device BF2.

For example, the conveying speed of the substrate P in the processing device PR2 on the upstream side of the first storage device BF1 is designated by Va, the conveying speed of the substrate P in the processing device PR3 (a patterning device such as the exposure device EX) on the downstream side of the first storage device BF1 (i.e., on the upstream side of the second storage device BF2) is designated by Vb, and the conveying speed of the substrate P in the processing device PR4 (or the processing device PR5) on the downstream side of the second storage device BF2 is designated by Vc. In this case, a required storage length Lac1 of the first storage device BF1 required during continuous processing of the substrate P having a total length Lf is given by Lac1 = Lf (1 - Vb/Va) if the conveying speeds Va, Vb satisfy the relationship Va > Vb, and is given by Lac1 = Lf (1 - Va/Vb) if the conveying speeds Va, Vb satisfy the relationship Vb > Va. Similarly, a required storage length Lac2 of the second storage device BF2 required during continuous processing of the substrate P having a total length Lf is given by Lac2 = Lf (1 - Vc/Vb) if the conveying speeds Vb, Vc satisfy the relationship Vb > Vc, and is given by Lac2 = Lf (1 - Vb/Vc) if the conveying speeds Vb, Vc satisfy the relationship Vc > Vb.

Thus, after the target conveying speeds Va, Vb, Vc of the substrate P as appropriately set under the processing conditions for each of the processing devices PR2 to PR4 are determined, the required storage length Lac1 of the first storage device BF1 and the required storage length Lac2 of the second storage device BF2 are obtained in accordance with the aforementioned calculations, and the maximum storage lengths of each of the first storage device BF1 and the second storage device BF2 are adjusted, so as to ensure the required storage lengths Lac1, Lac2. Adjustment of the maximum storage lengths is possible by making the number of times (the number of dancer rollers 20, 22 that support the substrate P) that the substrate is folded back by the plurality of dancer rollers 20 inside the first storage device BF1, and the plurality of dancer rollers 22 inside the second storage device BF2 shown in FIG. 4 different from each other. Reducing the number of times that the substrate P is folded back by the dancer rollers 20 and 22 reduces the possibility of damage, and the possibility of foreign matter becoming attached to the thin film layer or the pattern for electronic devices formed on the substrate P, and therefore is desirable. Further, the positions of the individual dancer rollers 20, 22 are made capable of being changed corresponding to the maximum storage length. Stated otherwise, actuators are provided inside the first storage device BF1 and the second storage device BF2, which enable each of the dancer rollers 20, 22 to be moved individually in the Z direction and adjust the position thereof. The actuators are controlled by the upper level control device 14 or the lower level control device 24.

Moreover, the first storage device BF1 shown in FIG. 4 (the same also applies to the second storage device BF2) can be configured to be removable as a single unit or additively installed in tandem (in series). Accordingly, in the case that the required storage length Lac1 (Lac2) obtained by the above-described calculations becomes long, by connecting together a plurality of the first storage devices BF1 (second storage devices BF2) in tandem, the maximum storage length of the substrate P can easily be increased. Thereafter, the distal end of the substrate P which is drawn out from the supply roll FR1 is passed sequentially through the processing devices PR1 to PR5 and the storage devices BF1, BF2 and is wound up onto the collection roll FR2, and after having set the storage lengths of the substrate P in the storage devices BF1, BF2 to their initial states, the processing operations (conveyance of the substrate P in accordance with the conveying speeds Va, Vb, Vc) by the processing devices PR1 to PR5 are initiated. In the case of Modification 1 as well, during the period in which each of the processing devices PR2 to PR4 continuously conveys the substrate P at the set constant conveying speeds Va, Vb, Vc, when it is detected that the quality of the pattern formed on the substrate P changes (decreases), for example, on the basis of image data analysis results of the pattern by the imaging device 83 in FIG. 8, for example the upper level control device 14 appropriately determines whether or not to change the processing conditions (setting conditions) of each of the processing devices PR2 to PR4 other than the conveying speed, specifies the processing devices PR whose processing conditions can be changed, and calculates the conditions to be changed. The upper level control device 14 issues instructions to the specified processing devices PR concerning the content of the setting conditions to be changed, the timing of the change, and the like. Consequently, it is possible to maintain the quality (fidelity and uniformity of shape and dimensions, etc.) of the pattern for electronic devices and the like formed on the substrate P within a predetermined allowable range over the total length Lf of the substrate P.

(Modification 2) In the case that the first storage device BF1 (second storage device BF2) is not additively installed, since the maximum storage length of the single storage device BF1 (second storage device BF2) is finite, if the total length Lf of the substrate P continuously processed is long, or the ratio Va:Vb (Vb:Vc) of the conveying speed is large, then during continuous processing over the total length Lf, the storage length of the substrate P in the first storage device BF1 (second storage device BF2) becomes full, or the storage length becomes zero. Thus, according to Modification 2, on the basis of the maximum storage lengths Lm1, Lm2 of the first storage device BF1 and the second storage device BF2, which are determined in advance, the conveying speeds Va, Vb, Vc of the substrates P in the respective processing devices PR2 to PR4 are preset beforehand, in a manner so as to implement continuous processing on the substrate P over the total length Lf without delay (temporary stoppage). More specifically, the respective conveying speeds Va, Vb, Vc are preset beforehand in a manner so that the maximum storage length Lm1 of the first storage device BF1 satisfies the condition Lm1 ≥ Lf(1 - Vb/Va) or Lm1 ≥ Lf(1 - Va/Vb), and the maximum storage length Lm2 of the second storage device BF2 satisfies the condition Lm2 ≥ Lf(1 - Vc/Vb) or Lm2 ≥ Lf(1 - Vb/Vc).

In addition, the respective processing devices PR2 to PR4 adjust the setting conditions of each of the devices in advance, so as to implement optimum processing at the set conveying speeds Va, Vb, Vc of the substrate P. During the period in which the substrate P is subjected to continuous processing over the total length Lf thereof, and more specifically, during the period in which each of the processing devices PR2 to PR4 continues to convey the substrate P at the set constant conveying speeds Va, Vb, Vc, in the case it is detected that the quality of the pattern formed on the substrate P tends to deteriorate, it is possible to process the substrate P while the upper level control device 14 determines whether or not to change the processing conditions (setting conditions) of each of the processing devices PR2 to PR4 other than the conveying speed, specifies the processing devices PR capable of changing the processing conditions, and calculates the conditions to be changed. Consequently, it is possible to maintain the quality (fidelity and uniformity of shape and dimensions, etc.) of the pattern for electronic devices and the like formed on the substrate P within a predetermined allowable range over the total length Lf of the substrate P.

Further, as in Modification 1 and Modification 2, after having preset the conveying speeds Va, Vb, Vc of the substrates P in each of the processing devices PR2 to PR4, and continuous processing over the total length Lf of the substrate P is started, for example, in the case that the quality of the pattern appearing after the processing device PR4 (PR5) fluctuates with respect to the target value due to variations in thickness of the resist layer applied by the processing device PR2, the various processing conditions (setting conditions) in each of the processing device PR3 and the processing device PR4 (PR5) are adjusted. At that time, as in the above-described second embodiment, it is also possible to transition to a control method in which a mode is incorporated for finely adjusting the conveying speeds Vb, Vc of the substrate P that were set beforehand in the processing device PR3 and the processing device PR4. Moreover, although Modification 1 and Modification 2 have been described on the premise of there being three processing devices PR2, PR3, PR4 (PR5) and two storage devices BF1, BF2, the present invention can be similarly applied to a manufacturing system constituted by two processing devices PR with one storage device disposed therebetween. Further, in Modification 1 and Modification 2, if possible, it is desirable to set the conveying speeds Va, Vb, Vc of the substrate P in each of the processing devices PR2 to PR4 to be equal to each other within a predetermined error range (for example, within ± a few percent).

In the above-described Modification 1 and Modification 2, when patterns for electronic devices are formed on the substrate P while conveying the elongate flexible sheet substrate P along the longitudinal direction, selectively or uniformly forming a coating (the photosensitive functional layer) on the surface of the substrate P under a conveying step of conveying the substrate sequentially through a first processing step (for example, a film forming step performed by the processing device PR2), and a second processing step (for example, an exposure step performed by the processing device PR3, and a developing step or plating step performed by the processing device PR4, PR5) which implement mutually different processes with respect to the substrate, and also under first processing conditions set in the processing device PR of the first processing step, ; causing a pattern to appear on the substrate P by implementing a process of creating a reformed portion corresponding to the pattern in the coating layer and removing either one of the reformed portion and a non-reformed portion, or by implementing a process of depositing a material for the electronic devices on either one of the reformed portion or the non-reformed portion under second processing conditions set in the processing device PR of the second processing step; determining whether or not it is possible to change at least one of the first processing conditions and the second processing conditions in accordance with a tendency in the case that the pattern having appeared in the second processing step exhibits the tendency to fluctuate with respect to a target shape or dimensions (a tendency to deteriorate in quality), are performed, whereby it is possible to implement a device manufacturing method in which the possibility of stoppage of the entire manufacturing line is reduced. More specifically, this implies that, in the case it is determined that at least one of the first processing conditions and the second processing conditions can be changed, it is possible to notify in advance that operations of the manufacturing line for which the quality of patterns formed on the substrate P is maintained are capable of being continued. Therefore, it is possible to avoid a situation in which an operator of a manufacturing site prematurely stops the manufacturing line. These features also apply to the aforementioned second embodiment.

[Modifications of First and Second Embodiments]

The above-described first and second embodiments (including the modifications thereof) may be further modified in the following manner.

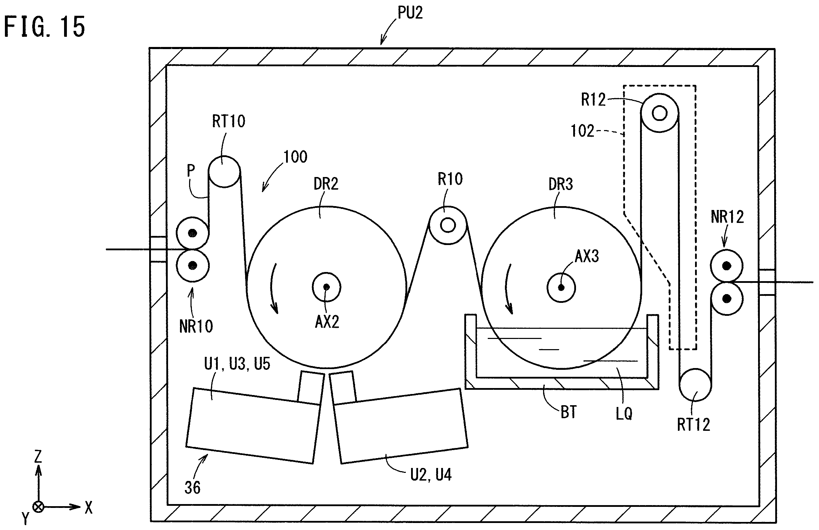

(Modification 1) In Modification 1, as shown in FIG. 15, the processing device PR3 and the processing device PR4 are configured as a single processing unit PU2. Stated otherwise, the processing unit PU2 is a device for performing a processing step (second processing step) for an exposure process and a development process while the substrate P, which was conveyed thereto from the processing device PR2, is conveyed in the conveying direction (+X direction). By the exposure process, a latent image (modified portion) corresponding to the pattern is formed in the photosensitive functional layer, and either one of the reformed portion or the non-reformed portion is dissolved and removed by the development process, whereby the pattern appears in the photosensitive functional layer. The processing unit PU2 may be a device for performing a processing step for an exposure process and a plating process, and in this case, by the plating process, a material (metal) for the electronic devices such as palladium ions or the like is precipitated on either one of the reformed portion or the non-reformed portion.

In the configuration of the processing unit PU2 shown in FIG. 15, constituent features thereof which are the same as those of the above-described first and second embodiments are denoted with the same reference characters, and descriptions thereof are omitted. In addition, illustrations concerning constituent features that are not particularly necessary for describing the present Modification 1 are omitted. The processing unit PU2 is equipped with a conveying unit 100, an exposure head 36, a processing tank BT, and a drying unit 102. Although not illustrated, the processing unit PU2 also includes the light source device 32, the light introduction optical system 34, the intensity sensor 37, the alignment microscopes AM (AM1 to AM3), the heaters H1, H2, the heater driving unit 82, the temperature sensor Ts, the concentration sensor Cs, the imaging device 83, and the like. Further, the processing unit PU2 is controlled by a non-illustrated lower level control device. The first storage device BF1 is disposed between the processing device PR2 and the processing unit PU2, and the second storage device BF2 is disposed between the processing unit PU2 and the processing device PR5.

The conveying unit 100 includes a drive roller NR10, a tension adjusting roller RT10, a rotation drum DR2, a guide roller R10, a rotation drum DR3, a guide roller R12, a tension adjusting roller RT12, and a drive roller NR12, disposed in this order from the upstream side (-X direction side) of the conveying direction of the substrate P. The drive roller NR10 conveys the substrate P toward the guide roller DR2 by being rotated while sandwiching both surfaces of the substrate P that is fed out from the processing device PR2 via the first storage device BF1. The rotation drum DR2 rotates about the central axis AX2 while supporting a portion of the substrate P in the longitudinal direction along the outer peripheral surface, and conveys the substrate P to the guide roller R10. The guide roller R10 guides the substrate P, which is delivered thereto from the rotation drum DR2, to the rotation drum DR3.

The rotation drum DR3 includes a central axis AX3 which extends in the Y direction, and a cylindrically shaped outer peripheral surface having a fixed radius from the central axis AX3. The rotation drum DR3 guides the substrate P to the guide roller R12 by rotating about the central axis AX3, while supporting a portion of the substrate P along the outer peripheral surface (circumferential surface) in the longitudinal direction. The rotation drum DR3 supports the substrate P over approximately half the circumferential surface of the outer peripheral surface on a lower side (a side in the -Z direction, that is, the direction in which gravity acts). The guide roller R12 conveys the substrate P that was delivered thereto toward the drive roller NR12. The drive roller NR12 conveys the substrate P to the side of the processing device PR5 by being rotated while sandwiching the front and rear surfaces of the substrate P that was delivered thereto. The tension adjusting rollers RT10, RT12 apply a predetermined tension with respect to the substrate P conveyed between the drive roller NR10 and the drive roller NR12. The tension adjusting roller RT10 is biased in the +Z direction, whereas the tension adjusting roller RT12 is biased in the -Z direction.

The drive rollers NR10, NR12 and the rotation drums DR2, DR3 are rotated due to a rotational torque applied from rotating drive sources (motors or speed reducers and the like) controlled by the lower level control device of the processing unit PU2. The conveying speed of the substrate P inside the processing unit PU2 is regulated by the rotational speeds of the drive rollers NR10, NR12 and the rotation drums DR2, DR3. Further, rotational speed signals (conveying speed information of the substrate P), which are transmitted from non-illustrated encoders provided on the drive rollers NR10, NR12 and the rotation drums DR2, DR3, are transmitted to the upper level control device 14 through the lower level control device of the processing unit PU2.

The rotation drum DR3 is disposed above the processing tank BT so that a portion of the circumferential surface thereof is immersed in a developing solution LQ stored in the processing tank BT. Accordingly, the substrate P, which is supported by the rotation drum DR3, can be immersed in the developing solution LQ. Further, the rotation drum DR3 (or the processing tank BT) can be moved in the Z direction. When the rotation drum DR3 is moved in the +Z direction (or the processing tank BT is moved in the -Z direction), the surface area over which the circumferential surface of the rotation drum DR3 is immersed in the development fluid LQ stored in the processing tank BT is reduced, whereas when the rotation drum DR3 is moved in the -Z direction (or the processing tank BT is moved in the +Z direction), the surface area over which the circumferential surface of the rotation drum DR3 is immersed in the development fluid LQ stored in the processing tank BT is increased. Consequently, by moving the rotation drum DR3 (or the processing tank BT) in the Z direction, the time period (immersion time) that the substrate P remains immersed in the development fluid LQ can be changed. Although not illustrated, a driving mechanism adapted to adjust an interval (i.e., the interval between the central axis AX3 of the rotation drum DR3 and the surface of the development fluid LQ inside the processing tank BT) in the Z direction between the rotation drum DR3 and the processing tank BT is provided on the rotation drum DR3 (or the processing tank BT). The driving mechanism is driven by a control of the lower level control device of the processing unit PU2. The guide roller R12 is disposed in the drying unit 102, and the drying unit 102 removes the development fluid LQ that adheres to the substrate P, which is conveyed from the rotation drum DR3 to the tension adjusting roller RT12 via the guide roller R12.

Moreover, in the case that the photosensitive functional layer is a silane coupling agent or a photosensitive reducing agent, then within the processing tank BT of the processing unit PU2, instead of the developing solution LQ, for example, a plating solution containing a material (metal) for an electronic device such as palladium ions or the like is stored. Stated otherwise, in this case, the processing unit PU2 is a device that performs an exposure process and a plating process. By immersing the substrate P in the plating solution, the material for the electronic device is precipitated in accordance with the latent image (reformed portions) formed in the photosensitive functional layer, and a pattern is formed in the substrate P. In the case of a positive type, the portions irradiated with ultraviolet rays are reformed, and the material for the electronic device is precipitated on non-reformed portions on which the ultraviolet rays are not irradiated. In the case of a negative type, the portions irradiated with ultraviolet rays are reformed, and the material for the electronic device is precipitated on the reformed portions. Consequently, a metal layer (conductive) pattern appears on the substrate P. In this instance as well, the interval in the Z direction between the rotation drum DR3 and the processing tank BT is adjusted and the amount of plating solution (fluid surface height) inside the processing tank BT is adjusted, whereby the immersion time of the substrate P in the plating solution can be adjusted and the concentration of palladium metal nuclei precipitated on the surface of the substrate P can be adjusted.

The processing unit PU2 carries out the exposure process and the development process (or the plating process) in accordance with setting conditions (second setting conditions). As setting conditions for the processing unit PU2, processing conditions (second processing conditions), which include an intensity condition that defines the intensity of the laser beam LB, a scanning speed condition that defines a scanning speed of the spotlight SP (rotational speed of the polygon mirror 66), an exposure frequency condition that defines a multiple exposure number, a pattern condition (pattern data) that defines the pattern to be drawn, a temperature condition that defines a temperature for the developing solution LQ (or the plating solution), a concentration condition that defines a concentration of the developing solution LQ (or the plating solution), and an immersion time condition that defines the immersion time, and the like, and a conveying speed condition for the substrate P are set. The exposure process is performed in accordance with the intensity condition, the scanning speed condition, the exposure frequency condition, the pattern condition, and the like. The development process (or the plating process) is performed in accordance with the temperature condition, the concentration condition, the immersion time condition, and the like. The setting conditions are set in advance, in a manner so that the actual processing state implemented by the processing unit PU2 becomes the target processing state.

Concerning changes in the setting conditions, since they have already been described above in connection with the second embodiment, they will not be described in detail. However, in the case that at least one of the actual processing states implemented on the substrate P in each of the respective processing devices PR1, PR2, PR5 and the processing unit PU2 exhibits a processing error E in excess of an allowable range with respect to the target processing state, then in accordance with the processing error E, the upper level control device 14 changes the setting conditions of the processing devices PR in which the processing error E is generated or the setting conditions of devices other than the processing unit PU2. Although it goes without saying, the reason therefor is that, in the event that any one of the states of actual processing implemented by the processing devices PR1, PR2, PR5 and the processing unit PU2 with respect to the substrate P in accordance with the setting conditions exceeds an allowable range with respect to the target processing state and has a processing error E, a desired pattern of the metal layer cannot be made appear on the substrate P.

In the case that the setting conditions that exhibit the processing error E are setting conditions of the processing unit PU2, initially, the setting conditions of the processing unit PU2 are changed in a manner so that the processing error E does not occur, or so that the processing error E falls within an allowable range. Then, in the case it is impossible to cope with the situation merely by changing the setting conditions of the processing unit PU2, the setting conditions of the other processing devices PR (PR2 , PR5) are further changed in a manner so that the processing error E does not occur, or so that the processing error E falls within an allowable range. At this time, after completion of the changes in the setting conditions of the other processing devices PR, at least the conveying speed condition of the processing unit PU2 may be restored to their original state. Further, in the case that the setting conditions that exhibit the processing error E belong to a processing device PR other than the processing unit PU2, the setting conditions of the processing unit PU2 are caused to be changed preferentially, in a manner so that the processing error E does not occur, or so that the processing error E falls within an allowable range. Moreover, although the first storage device BF1 and the second storage device BF2 are disposed before and after the processing unit PU2, they may be disposed before and after one of the other processing devices PR.

Moreover, as illustrated in FIG. 15, in the case of the processing unit PU2, in which the exposure processing section (the rotation drum DR2, the exposure head 36, etc.) and the wet processing section (the rotation drum DR3, the processing tank BT, etc.) are integrally provided, the conveying speed of the sheet substrate P inside the processing unit PU2 is constant, and the conveying speed of the sheet substrate P cannot be made temporarily different between the exposure processing section and the wet processing section. Therefore, in the case it is desired to temporarily change the conveying speed of the sheet substrate P, the storage devices BF1, BF2 shown in FIG. 4 are provided at the position of the guide roller R10. Stated otherwise, the first storage device BF1 and the second storage device BF2 are disposed before and after the processing unit PU2, together with one storage device having a configuration similar to that of the first storage device BF1 (second storage device BF2) being disposed between the rotation drum DR2 and the rotation drum DR3. Further, the first storage device BF1 may be disposed between the processing device PR2 and the rotation drum DR2, and the second storage device BF2 may be disposed between the rotation drum DR2 and the rotation drum DR3. Furthermore, the first storage device BF1 may be disposed between the rotation drum DR2 and the rotation drum DR3, and the second storage device BF2 may be disposed between the rotation drum DR3 and the processing device PR5.

(Modification 2) In Modification 2, the processing device PR2 and the processing device PR3 are configured as a single processing unit PU1. Stated otherwise, the processing unit PU1 is a device for performing a processing step (first processing step) for a film forming process and an exposure process while the substrate P, which was conveyed thereto from the processing device PR1, is conveyed in the conveying direction (+X direction). By the film forming process, a photosensitive functional fluid is selectively or uniformly coated on the surface of the substrate P, thereby selectively or uniformly forming the photosensitive functional layer on the surface of the substrate P. In addition, by the exposure process, a latent image (reformed portion) corresponding to the pattern is formed in the photosensitive functional layer.

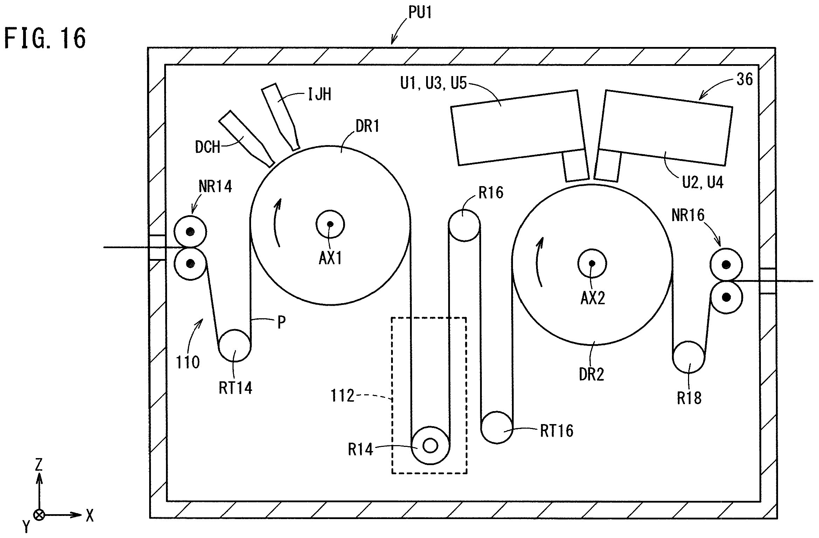

FIG. 16 is a diagram illustrating the configuration of the processing unit PU1. Constituent features which are the same as those of the above-described first and second embodiments are denoted with the same reference characters, and descriptions thereof are omitted. In addition, illustrations concerning constituent features that are not particularly necessary for describing the present Modification 2 are omitted. The processing unit PU1 is equipped with a conveying unit 110, a die coater head DCH, an ink jet head IJH, a drying device 112, and an exposure head 36. Although not illustrated, the processing unit PU1 also includes the light source device 32, the light introduction optical system 34, the intensity sensor 37, the alignment microscopes AM (AM1 to AM3), the film thickness measuring device 16a, and the like. Further, the processing unit PU1 is controlled by a non-illustrated lower level control device. The first storage device BF1 is disposed between the processing device PR1 and the processing unit PU1, and the second storage device BF2 is disposed between the processing unit PU1 and the processing device PR4.

The conveying unit 110 includes a drive roller NR14, a tension adjusting roller RT14, a rotation drum DR1, guide rollers R14, R16, a tension adjusting roller RT16, a rotation drum DR2, a guide roller R18, and a drive roller NR16, disposed in this order from the upstream side (-X direction side) of the conveying direction of the substrate P. The drive roller NR14 conveys the substrate P toward the guide roller DR1 by being rotated while sandwiching both surfaces of the substrate P that is fed out from the processing device PR1 via the first storage device BF1. The rotation drum DR1 rotates about the central axis AX1 while supporting a portion of the substrate P in the longitudinal direction along the outer peripheral surface (outer circumferential surface), and conveys the substrate P to the side in the +X direction. The guide rollers R14, R16 convey the substrate P, which is delivered thereto from the rotation drum DR1, to the rotation drum DR2.

The rotation drum DR2 rotates about the central axis AX2 while supporting a portion of the substrate P in the longitudinal direction along the outer peripheral surface, and conveys the substrate P to the guide roller R18. The guide roller R18 conveys the substrate P, which is delivered thereto from the rotation drum DR2, to the drive roller NR16. The drive roller NR16 conveys the substrate P to the side of the processing device PR4 by being rotated while sandwiching the front and rear surfaces of the substrate P that was delivered thereto. The tension adjusting rollers RT14, RT16 apply a predetermined tension with respect to the substrate P conveyed between the drive roller NR14 and the drive roller NR16. The tension adjusting rollers RT14, RT16 are biased in the -Z direction.

The drive rollers NR14, NR16 and the rotation drums DR1, DR2 are rotated due to a rotational torque applied from rotating drive sources (motors or speed reducers and the like) controlled by the lower level control device of the processing unit PU1. The conveying speed of the substrate P inside the processing unit PU1 is regulated by the rotational speeds of the drive rollers NR14, NR16 and the rotation drums DR1, DR2. Further, rotational speed signals (conveying speed information of the substrate P), which are transmitted from non-illustrated encoders provided on the drive rollers NR14, NR16 and the rotation drums DR1, DR2, are transmitted to the upper level control device 14 through the lower level control device of the processing unit PU1.

The guide roller R14 is provided in the drying device 112, and the drying device 112 removes the solute (solvent or water) included in the photosensitive functional fluid by blowing drying air such as hot air or dry air with respect to the substrate P, which is conveyed from the rotation drum DR1 to the guide roller R16 via the guide roller R14, and thereby dries the photosensitive functional fluid. In this manner, the photosensitive functional layer is formed.

The processing unit PU1 carries out the film forming process and the exposure process in accordance with setting conditions (first setting conditions). As setting conditions for the processing unit PU1, processing conditions (first processing conditions), which include a region condition that defines a region where the photosensitive functional layer is formed, a film thickness condition that defines the film thickness of the photosensitive functional layer, an intensity condition that defines the intensity of the laser beam LB, a scanning speed condition that defines a scanning speed of the spotlight SP (rotational speed of the polygon mirror 66), an exposure frequency condition that defines a multiple exposure number, and a pattern condition (pattern data) that defines the pattern to be drawn, and the like, and a conveying speed condition for the substrate P are set. The film forming process is performed in accordance with the region condition, the film thickness condition, and the like. The exposure process is performed in accordance with the intensity condition, the scanning speed condition, the exposure frequency condition, the pattern condition, and the like. The setting conditions are set in advance, in a manner so that the actual processing state implemented by the processing unit PU1 becomes the target processing state.

Concerning changes in the setting conditions, since they have already been described above in connection with the second embodiment, they will not be described in detail. However, in the case that at least one of the actual processing states implemented on the substrate P in each of the respective processing devices PR1, PR4, PR5 and the processing unit PU1 exhibits a processing error E in excess of an allowable range with respect to the target processing state, then in accordance with the processing error E, the upper level control device 14 changes the setting conditions of the processing devices PR in which the processing error E is generated or the setting conditions of other devices other than the processing unit PU1. Although it goes without saying, the reason therefor is that, in the event that any one of the states of actual processing implemented by the processing devices PR1, PR4, PR5 and the processing unit PU1 with respect to the substrate P in accordance with the setting conditions exceeds an allowable range with respect to the target processing state and has a processing error E, a desired pattern of the metal layer cannot be made appear on the substrate P.

In the case that the setting conditions that exhibit the processing error E are setting conditions of the processing unit PU1, initially, the setting conditions of the processing unit PU1 are changed in a manner so that the processing error E does not occur, or so that the processing error E falls within an allowable range. Then, in the case it is impossible to cope with the situation merely by changing the setting conditions of the processing unit PU1, the setting conditions of the other processing devices PR (PR4 , PR5) are further changed in a manner so that the processing error E does not occur, or so that the processing error E falls within an allowable range. At this time, after completion of the changes in the setting conditions of the other processing devices PR, at least the conveying speed condition of the processing unit PU1 may be restored to their original state. Further, in the case that the setting conditions that exhibit the processing error E belong to a processing device PR other than the processing unit PU1, the setting conditions of the processing unit PU1 are caused to be changed preferentially, in a manner so that the processing error E does not occur, or so that the processing error E falls within an allowable range. Moreover, although the first storage device BF1 and the second storage device BF2 are disposed before and after the processing unit PU1, they may be disposed before and after one of the other processing devices PR.

In the above-described Modification 2, as shown in FIG. 16, the processing unit PU1 is constituted, in which the coating processing section (the rotation drum DR1, the die coater head DCH, the ink jet head IJH, etc.), the drying processing section (the drying device 112, etc.), and the exposure processing section (the rotation drum DR2, the exposure head 36, etc.), are integrally provided, and therefore, the conveying speed of the substrate P is the same at all locations inside the processing unit PU1. However, in the case that the conveying speeds of the substrate P are to be made temporarily different in each of the coating processing section, the drying processing section, and the exposure processing section, for example, the storage devices BF1, BF2 shown in FIG. 4 are provided at the position of the drying processing section (the drying device 112, etc.). Stated otherwise, the first storage device BF1 and the second storage device BF2 are disposed before and after the processing unit PU1, together with one storage device having a configuration similar to that of the first storage device BF1 (second storage device BF2) being disposed between the rotation drum DR1 and the rotation drum DR2. Further, the first storage device BF1 may be disposed between the rotation drum DR1 and the rotation drum DR2, and the second storage device BF2 may be disposed between the rotation drum DR2 and the processing device PR4. Furthermore, the first storage device BF1 may be disposed between the processing device PR1 and the rotation drum DR1, and the second storage device BF2 may be disposed between the rotation drum DR1 and the rotation drum DR2.

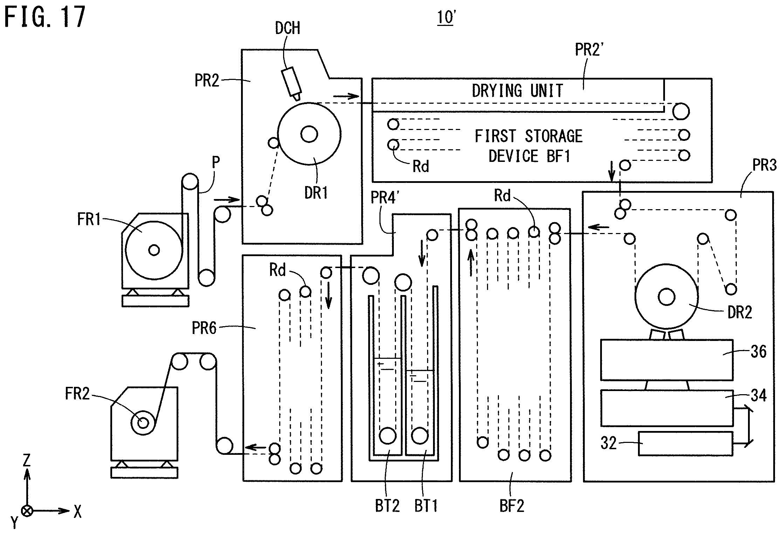

(Modification 3) FIG. 17 shows a schematic configuration of a device manufacturing system 10' according to a third modification of the device manufacturing system 10 of FIG. 1 which is constituted on the premise of the first and second embodiments. In the third modification, a compact manufacturing line is constructed by changing the conveying path of the substrate P and the arrangement of the respective processing devices in the device manufacturing system 10 of FIG. 1. Concerning the substrate P and the respective processing devices shown in FIG. 17, constituent features thereof which are the same as those shown in the previous FIGS. 2 through 9 are denoted with the same reference characters, and descriptions thereof are omitted. In addition, illustrations concerning constituent features that are not particularly necessary for describing the present Modification 3 are omitted.

As shown in FIG. 17, according to Modification 3, in the device manufacturing system 10', the conveying path of the substrate P is folded back on itself, and several processing devices are disposed in a three-dimensional manner (in a vertical relationship), so as to arrange the supply roll FR1 and the collection roll FR2 for the substrate P alongside one another on one side of the device manufacturing system 10'. The device manufacturing system 10' according to Modification 3 is equipped with a processing device PR2 configured as a coating device by a die coater head DCH and a rotation drum DR1, a processing device PR2' including a first storage device BF1 and configured as a drying device (corresponding to the drying device 16 of FIG. 2) for drying the substrate P after coating, a processing device PR3 configured as an exposure device by a light source device 32, a light introduction optical system 34, an exposure head 36, and a rotary drum DR2, and the like, a second storage device BF2, a processing device PR4' configured as a wet processing device and including a vertical fluid tank BT1 in which a developing solution or a plating solution is stored, and a vertical cleaning tank BT2 in which pure water or the like for cleaning is stored, and a processing device PR6 also equipped with a function as a storage unit, and configured as a drying device for drying the substrate P after wet processing.

The sheet-like substrate P that is delivered out from the supply roll FR1 is conveyed at a predetermined speed in a state of being supported by the rotating drum DR1 of the processing device PR2, and the coating liquid LQc is applied thereon by the die coater head DCH. After application thereof, the substrate P is delivered substantially horizontally in the +X direction, dried in a drying device (drying unit) inside the processing device PR2' arranged in an upper part of the device manufacturing system 10', and then passes over a large number of dancer rollers Rd inside the first storage device BF1, and is delivered to the processing device PR3 which is arranged on a side in the -Z direction of the processing device PR2'. The plurality of dancer rollers Rd inside the first storage device BF1 are arranged to apply a tension, and to fold back the substrate P so that the substrate P is substantially parallel to the XY plane (floor surface). The processing device PR3 conveys the substrate P, which is delivered in the -Z direction, so as to be wound around approximately the lower half of the rotation drum DR2, and thereafter, releases the substrate P in the +Z direction. Therefore, the exposure head 36, which performs pattern exposure on the substrate P, is disposed downwardly (on a side in the -Z direction) of the rotary drum DR2. The substrate P which was exposed in the processing device PR3 is delivered to the second storage device BF2 which is arranged on a side in the -X direction of the processing device PR3, passes over a plurality of dancer rollers Rd, and is delivered to the processing device PR4' which is arranged on a side in the -X direction of the second storage device BF2. The processing device PR4' passes the substrate P that was delivered thereto sequentially through the fluid tank BT1 in which the developing solution or the plating solution is stored, and the cleaning tank BT2 in which pure water or the like for cleaning is stored, and thereafter, delivers the substrate P to the processing device PR6 which is arranged on a side in the -X direction of the processing device PR4'. The substrate P, which passes over the plurality of dancer rollers Rd and is dried in the processing device PR6, is wound up onto the recovery roll FR2.

As shown in FIG. 17, by arranging the processing device (coating device) PR2, the drying device (drying unit) inside the processing device PR2 ', the first storage device BF1 inside the processing device PR2', the processing device (exposure device) PR3, the second storage device BF2, the processing device (wet processing device) PR4', and the processing device (drying unit) PR6 not in a row, but three dimensionally in the vertical direction (Z direction), it is possible to suppress the overall length of the manufacturing system, and to make the installation floor area (footprint) compact. The method of managing the device manufacturing system 10, or the device manufacturing method according to the first embodiment and the second embodiment described above can also be applied to the device manufacturing system 10' as shown in the third modification shown in FIG. 17.

In the configuration of FIG. 17, although the processing device PR2' is divided spatially into the drying device (drying unit) and the first storage device BF1, both of the devices may be used without being spatially separated. Furthermore, in the case that heated air having a temperature of less than or equal to 100° C for drying the substrate P is fed into the drying unit of the processing device PR2' and into the processing device PR6, a temperature adjusting device (including a heater, a blower fan, a filter, etc.) that makes such heated air may be used in common by the processing device PR2' and the processing device PR6. Further, in the case that a post-baking (post-exposure baking) treatment, which applies heat having a temperature of less than or equal to 100° C to the resist layer on the substrate P, is carried out after the exposure process by the processing device PR3, a drying unit can be disposed between the processing device PR3 and the second storage device BF2, or alternatively, inside of the second storage device BF2.

(Modification 4) According to the first embodiment and the second embodiment described above, for example, when the stop requesting device PRd generates a stop request, at that point in time, information of the storage state in relation to the new storable length and the already stored length of the substrate P in the first storage device BF1 on the upstream side or the second storage device BF2 on the downstream side is obtained, and a determination is made as to whether or not it is possible to temporarily stop the exposure device EX in order to perform the additional operation. However, an opposite determination may be performed. More specifically, information of the storage state in relation to the new storable length and the already stored length of the substrate P in the storage device (BF1, BF2) on the upstream side or the downstream side of the stop requesting device PRd may be sequentially updated and generated, and from the condition of the storage state which is sequentially updated, the time period over which the stop requesting device PRd is capable of being stopped may be predictively calculated, and a determination may be made as to whether or not the additional operation required by the stop requesting device PRd is completed during the predicted stoppage time period. According to such a modification, a manufacturing system can be constructed, in which an information generating unit (the upper level control device 14, etc.) is provided, which is adapted to sequentially generate storage information concerning the storage state of the substrate P in the storage unit (BF1, BF2) disposed between the first processing device and the second processing device, and a control device (the upper level control device 14 or the like) is provided, which predictively calculates, on the basis of the storage information from the information generating unit, a duration over which stoppage is possible in the case that processing operations performed on the substrate P are stopped by a stoppage target processing device of at least one of the first processing device and the second processing device , and which stops the processing operations of the stoppage target processing device in the case that an additional operation by the stoppage target processing device can be executed within the predicted duration over which stoppage is possible.

**Claims**

1. A manufacturing system (10) adapted to continuously implement processes on an elongate flexible sheet substrate (P) by a plurality of processing devices while conveying the sheet substrate (P) in a longitudinal direction, comprising:

   a storage unit (BF1) disposed between a first processing device (PR2) and a second processing device (PR3) adjacent to the first processing device (PR2) from among the plurality of processing devices; and
   a control device (14) adapted to determine whether or not a storage state of the sheet substrate in the storage unit (BF1) satisfies a required storage state determined by a predicted stoppage time period of the first processing device (PR2), when, in the first processing device (PR2), processing with respect to the sheet substrate (P), or conveyance of the sheet substrate (P) is temporarily stopped,
   wherein, in the case it is determined that the storage state of the storage unit (BF1) does not satisfy the required storage state, the control device (14) determines whether or not the storage state of the storage unit (BF1) can be made to satisfy the required storage state within an allowable delay time period during which it is waited until conveyance of the sheet substrate (P) by the first processing device (PR2) is stopped, by changing the conveying speed of the sheet substrate (P) of at least one from among the first processing device (PR2) and the second processing device (PR3).

2. The manufacturing system according to claim 1, wherein:

   the second processing device and the storage unit are arranged on an upstream side of the first processing device along the direction of conveyance of the sheet substrate; and
   even if the first processing device is temporarily stopped for the stoppage time period, in the case that the storage unit is capable of storing the sheet substrate delivered from the second processing device during the stoppage time period, the control device determines that the storage state of the storage unit satisfies the required storage state.

3. The manufacturing system according to claim 1, wherein:
   the second processing device and the storage unit are arranged on a downstream side of the first processing device along the direction of conveyance of the sheet substrate; and
   even if the first processing device is temporarily stopped for the stoppage time period, in the case that the storage unit is storing the sheet substrate of a length capable of being supplied to the second processing device during the stoppage time period, the control device determines that the storage state of the storage unit satisfies the required storage state.

4. The manufacturing system according to any one of claims 1 to 3, wherein, in the case that the control device has determined that the storage state of the storage unit satisfies the required storage state, conveyance and processing of the sheet substrate in the second processing device is continued, while conveyance and processing of the sheet substrate in the first processing device is temporarily stopped for the stoppage time period.

5. The manufacturing system according to claim 1, wherein the control device determines whether or not the storage state of the storage unit can be made to satisfy the required storage state within the allowable delay time period, by increasing the conveying speed of the first processing device or decreasing the conveying speed of the second processing device, while changing processing conditions of at least one of the first processing device and the second processing device so as to suppress a deterioration in processing quality.

6. The manufacturing system according to claim 1 or 5, wherein:

   the second processing device and the storage unit are arranged on an upstream side of the first processing device along the direction of conveyance of the sheet substrate; and
   the control device determines whether or not, within the allowable delay time period, the storage state of the storage unit can be placed in a state in which the sheet substrate, which is delivered from the second processing device during the stoppage time period in the case that the first processing device is temporarily stopped, is capable of being stored in the storage unit.

7. The manufacturing system according to claim 1 or 5, wherein:
the second processing device and the storage unit are arranged on a downstream side of the first processing device along the direction of conveyance of the sheet substrate; and
the control device determines whether or not, within the allowable delay time period, the storage state of the storage unit can be placed in a state in which the sheet substrate, which is of a length capable of being supplied to the second processing device during the stoppage time period in the case that the first processing device is temporarily stopped, is capable of being stored in the storage unit.

8. The manufacturing system according to any one of claims 1 and 5 to 7, wherein, in the case that the control device has determined that the storage state of the storage unit can be made to satisfy the required storage state within the allowable delay time period, conveyance and processing of the sheet substrate in the second processing device is continued, while conveyance and processing of the sheet substrate in the first processing device is temporarily stopped for the stoppage time period, at a stage at which the storage state of the storage unit has been placed in the required storage state.

9. The manufacturing system according to claim 4 or 8, wherein:

a device forming region on which a pattern is formed is arranged on the sheet substrate in a state of being contiguous with and sandwiched between marginal portions along the longitudinal direction;
the first processing device performs processing in a range that is shorter than the length of the marginal portions in the longitudinal direction; and
when the marginal portions are brought into a processing position where the first processing device performs processing on the sheet substrate, the control device executes a temporary stoppage of conveyance and processing of the sheet substrate in the first processing device.

10. The manufacturing system according to claim 4 or 8, wherein:

a device forming region on which a pattern is formed is arranged on the sheet substrate in a state of being contiguous with and sandwiched between marginal portions along the longitudinal direction;
the second processing device performs processing in a range that is longer than a length of the marginal portions in the longitudinal direction; and
in the case that the control device has determined that the storage state of the storage unit satisfies the required storage state, or at a stage at which the storage state of the storage unit has been placed in the required storage state, the control device immediately executes a temporary stoppage of conveyance and processing of the sheet substrate in the first processing device.

11. The manufacturing system according to any one of claims 1 and 5 to 8, wherein, in the case that the control device has determined that the storage state of the storage unit cannot be made to satisfy the required storage state within the allowable delay time period, processing by the plurality of processing devices is stopped, while conveyance of the sheet substrate flowing through the plurality of processing devices is entirely stopped.

12. The manufacturing system according to any one of claims 1 to 3, wherein one of the first processing device and the second processing device is a patterning device configured to form a pattern of an electronic device on the sheet substrate.

13. A manufacturing system (10) adapted to continuously implement processes on an elongate flexible sheet substrate (P) by a plurality of processing devices while conveying the sheet substrate (P) in a longitudinal direction, comprising:

a first processing device (PR2) adapted to selectively or uniformly form a photosensitive thin film on a surface of the sheet substrate (P) while conveying the sheet substrate (P);
a second processing device (PR3) adapted to irradiate the photosensitive thin film on the surface of the sheet substrate (P) with light energy corresponding to a predetermined pattern, while conveying the sheet substrate (P) on which the photosensitive thin film is formed, to thereby form a latent image corresponding to the pattern on the photosensitive thin film;
a third processing device (PR4) for causing the pattern to appear on the sheet substrate while conveying the sheet substrate (P) on which the latent image is formed, by selectively developing the photosensitive thin film corresponding to the latent image, or selectively plating the photosensitive thin film corresponding to the latent image;

a first storage unit (BF1) disposed between the first processing device (PR2) and the second processing device (PR3), and which is capable of storing the sheet substrate (P) over a predetermined length;

a second storage unit (BF2) disposed between the second processing device (PR3) and the third processing device (14), and which is capable of storing the sheet substrate (P) over a predetermined length; and

a control device (14) adapted to determine whether or not a storage state of the sheet substrate in at least one of the storage units adjacent to at least one of the processing devices for which temporary stoppage of processing is requested satisfies a required storage state determined by a predicted stoppage time period, in the case that at least one from among the first processing device (PR2), the second processing device (PR3), and the third processing device (PR4) requests temporary stoppage of own processing,

wherein, in the case it is determined that the storage state of the storage units do not satisfy the required storage state, the control device determines whether or not the storage state of the at least one of the storage units that is adjacent to the at least one of the processing devices for which temporary stoppage of processing is requested can be made to satisfy the required storage state within an allowable delay in time period during which it is waited until processing by the at least one of the processing devices for which temporary stoppage of processing is requested is stopped, by changing the conveying speed of the sheet substrate (P) of at least one from among the first processing device (PR2), the second processing device (PR3), and the third processing device (PR4).

14. The manufacturing system according to claim 13, wherein, in the case that the processing device for which temporary stoppage of processing is requested is the second processing device, the control device determines that the storage state of at least one of the storage units satisfies the required storage state, when the first storage unit is in a state capable of storing the sheet substrate delivered thereto from the first processing device during the stoppage time period in which the second processing device is temporarily stopped, and the second storage unit is in a state of storing the sheet substrate of a length capable of being supplied to the third processing device during the stoppage time period.

15. The manufacturing system according to claim 13, wherein, in the case that the processing device for which temporary stoppage of processing is requested is the first processing device, the control device determines that the storage state of at least one of the storage units satisfies the required storage state, when the first storage unit is in a state of storing the sheet substrate of a length capable of being supplied to the second processing device during the stoppage time period in which the first processing device is temporarily stopped.

16. The manufacturing system according to any one of claims 13 to 15, wherein, in the case that the processing device for which temporary stoppage of processing is requested is the third processing device, the control device determines that the storage state of at least one of the storage units satisfies the required storage state, when the second storage unit is in a state capable of storing the sheet substrate delivered from the second processing device during the stoppage time period in which the third processing device is temporarily stopped.

17. The manufacturing system according to any one of claims 13 to 15, wherein, in the case that the control device has determined that the storage state of the storage units satisfy the required storage state, while conveyance and processing of the sheet substrate in the specific at least one of the processing devices for which temporary stoppage of processing is requested is temporarily stopped for the stoppage time period, conveyance and processing of the sheet substrate in each of the processing devices except the specific processing device is continued.

18. The manufacturing system according to any one of claims 13 to 17, wherein the control device determines whether or not the storage state of at least one of the storage units adjacent to the at least one of the processing devices for which temporary stoppage of processing is requested can be made to satisfy the required storage state within the allowable delay time period, by increasing or decreasing the conveying speed of at least one from among the first processing device, the second processing device, and the third processing device, while changing processing conditions of at least one from among the first processing device, the second processing device, and the third processing device so as to suppress a deterioration in processing quality.

19. The manufacturing system according to claim 13 or 18, wherein, in the case that the processing device for which temporary stoppage of processing is requested is the second processing device, the control device determines whether or not, within the allowable delay time period, the storage state of the first storage unit can be placed in a state capable of storing the sheet substrate delivered thereto from the first processing device even if the second processing device is temporarily stopped during the stoppage time period, and whether or not, within the allowable delay time period, the storage state of the second storage unit can be placed in a state of storing the sheet substrate of a length capable of being supplied to the third processing device even if the second processing device is temporarily stopped during the stoppage time period.

20. The manufacturing system according to any one of claims 13 to 18, wherein, in the case that the processing device for which temporary stoppage of processing is requested is the first processing device, the control device determines whether or not, within the allowable delay time period, the storage state of the first storage unit can be placed in a state capable of storing the sheet substrate of a length capable of being supplied to the second processing device even if the first processing device is temporarily stopped during the stoppage time period.

21. The manufacturing system according to claims 13 or 18, wherein, in the case that the processing device for which temporary stoppage of processing is requested is the third processing device, the control device determines whether or not, within the allowable delay time period, the storage state of the second storage unit can be placed in a state capable of storing the sheet substrate delivered thereto from the second processing device even if the third processing device is temporarily stopped during the stoppage time period.

22. The manufacturing system according to claims 13 or 18, wherein, in the case that the control device has determined that the storage state of at least one of the storage units can be made to satisfy the required storage state within the allowable delay time period, and at a stage at which the storage states of the storage units have been placed in the required storage state, while conveyance and processing of the sheet substrate in at least one of the specific processing devices for which temporary stoppage of processing is requested is temporarily stopped during the stoppage time period, conveyance and processing of the sheet substrate in each of the processing devices except the specific processing device is continued.

23. The manufacturing system according to any one of claims 19 to 22, wherein:

a device forming region on which a pattern is formed is arranged on the sheet substrate in a state of being contiguous with and sandwiched between marginal portions along the longitudinal direction; the first processing device and the second processing device perform processing in a range that is shorter than a length of the marginal portions in the longitudinal direction; and the third processing device performs processing in a range that is longer than a length of the marginal portions in the longitudinal direction; and the control device:

in the case that the processing device for which temporary stoppage of processing is requested is the third processing device, and in the case it is determined that the storage state of the storage units satisfies the required storage state, or at a stage at which the storage state of the storage units has been placed in the required storage state, executes a temporary stoppage of conveyance and processing of the sheet substrate in the third processing device; and in the case that the processing device for which temporary stoppage of processing is requested is the first processing device or the second processing device, and when the marginal portions are brought into a processing position where the processing device for which temporary stoppage of processing is requested performs processing on the sheet substrate, executes a temporary stoppage of conveyance and processing of the sheet substrate in the processing device for which temporary stoppage of processing is requested.

24. The manufacturing system according to any one of claims 19 to 22, wherein, in the case that the control device has determined that the storage states of the storage units cannot be made to satisfy the required storage state within the allowable delay time period, processing by the plurality of processing devices is stopped, while conveyance of the sheet substrate flowing through the first processing device, the second processing device, and the third processing device is entirely stopped.

25. The manufacturing system according to any one of claims 13 to 15, wherein the first processing device includes a die coater head unit adapted to apply a liquid that becomes the photosensitive thin film onto the sheet substrate, and the first processing device requests the temporary stoppage when a replenishing operation of the liquid to the die coater head unit is required.

26. The manufacturing system according to any one of claims 13 to 15, wherein the second processing device includes a calibration mechanism adapted to calibrate a position error when irradiating the surface of the sheet substrate with light energy, and the second processing device requests the temporary stoppage when a calibration operation by the calibration mechanism is required.

**Patentansprüche**

1. Herstellungssystem (10), das dazu eingerichtet ist, kontinuierlich Prozesse an einem länglichen flexiblen Foliensubstrat (P) durch eine Vielzahl von Verarbeitungsvorrichtungen durchzuführen, während das Foliensubstrat (P) in einer Längsrichtung gefördert wird, aufweisend:

   eine Speichereinheit (BF1), die zwischen einer ersten Verarbeitungsvorrichtung (PR2) und einer zweiten Verarbeitungsvorrichtung (PR3) benachbart zu der ersten Verarbeitungsvorrichtung (PR2) aus der Vielzahl von Verarbeitungsvorrichtungen angeordnet ist; und
   eine Steuervorrichtung (14), die dazu eingerichtet ist, zu bestimmen, ob ein Speicherzustand des Foliensubstrats in der Speichereinheit (BF1) einen erforderlichen Speicherzustand erfüllt oder nicht, der durch eine vorhergesagte Stoppzeitperiode der ersten Verarbeitungsvorrichtung (PR2) bestimmt wird, wenn in der ersten Verarbeitungsvorrichtung (PR2) eine Verarbeitung in Bezug auf das Foliensubstrat (P) oder eine Förderung des Foliensubstrats (P) vorübergehend gestoppt wird,
   wobei in dem Fall, dass bestimmt wird, dass der Speicherzustand der Speichereinheit (BF1) den erforderlichen Speicherzustand nicht erfüllt, die Steuervorrichtung (14) bestimmt, ob der Speicherzustand der Speichereinheit (BF1) dazu gebracht werden kann oder nicht, den erforderlichen Speicherzustand innerhalb einer zulässigen Verzögerungszeitperiode zu erfüllen, während der gewartet wird, bis die Förderung des Foliensubstrats (P) durch die erste Verarbeitungsvorrichtung (PR2) gestoppt wird, durch Ändern der Fördergeschwindigkeit des Foliensubstrats (P) von mindestens einer aus der ersten Verarbeitungsvorrichtung (PR2) und der zweiten Verarbeitungsvorrichtung (PR3).

2. Herstellungssystem gemäß Anspruch 1, wobei:

   die zweite Verarbeitungsvorrichtung und die Speichereinheit auf einer stromaufwärtigen Seite der ersten Verarbeitungsvorrichtung entlang der Förderrichtung des Foliensubstrats angeordnet sind; und
   selbst wenn die erste Verarbeitungsvorrichtung für die Stoppzeitperiode vorübergehend gestoppt wird, in dem Fall, dass die Speichereinheit in der Lage ist, das von der zweiten Verarbeitungsvorrichtung während der Stoppzeitperiode zugeführte Foliensubstrat zu speichern, die Steuervorrichtung bestimmt, dass der Speicherzustand der Speichereinheit den erforderlichen Speicherzustand erfüllt.

3. Herstellungssystem gemäß Anspruch 1, wobei:

   die zweite Verarbeitungsvorrichtung und die Speichereinheit auf einer stromabwärtigen Seite der ersten Verarbeitungsvorrichtung entlang der Förderrichtung des Foliensubstrats angeordnet sind; und
   selbst wenn die erste Verarbeitungsvorrichtung für die Stoppzeitperiode vorübergehend gestoppt wird, in dem Fall, dass die Speichereinheit das Foliensubstrat einer Länge speichert, die in der Lage ist, der zweiten Verarbeitungsvorrichtung während der Stoppzeitperiode zugeführt zu werden, die Steuervorrichtung bestimmt, dass der Speicherzustand der Speichereinheit den erforderlichen Speicherzustand erfüllt.

4. Herstellungssystem gemäß einem der Ansprüche 1 bis 3, wobei in dem Fall, dass die Steuervorrichtung bestimmt hat, dass der Speicherzustand der Speichereinheit den erforderlichen Speicherzustand erfüllt, die Förderung und Verarbeitung des Foliensubstrats in der zweiten Verarbeitungsvorrichtung fortgesetzt wird, während die Förderung und Verarbeitung des Foliensubstrats in der ersten Verarbeitungsvorrichtung für die Stoppzeitperiode vorübergehend gestoppt wird.

5. Herstellungssystem gemäß Anspruch 1, wobei die Steuervorrichtung bestimmt, ob der Speicherzustand der Speichereinheit dazu gebracht werden kann oder nicht, den erforderlichen Speicherzustand innerhalb der zulässigen Verzögerungszeitperiode zu erfüllen, indem die Fördergeschwindigkeit der ersten Verarbeitungsvorrichtung erhöht oder die Fördergeschwindigkeit der zweiten Verarbeitungsvorrichtung verringert wird, während die Verarbeitungsbedingungen von mindestens einer der ersten Verarbeitungsvorrichtung und der zweiten Verarbeitungsvorrichtung so geändert werden, dass eine Verschlechterung der Verarbeitungsqualität unterdrückt wird.

6. Herstellungssystem gemäß Anspruch 1 oder 5, wobei:

die zweite Verarbeitungsvorrichtung und die Speichereinheit auf einer stromaufwärtigen Seite der ersten Verarbeitungsvorrichtung entlang der Förderrichtung des Foliensubstrats angeordnet sind; und

die Steuervorrichtung bestimmt, ob innerhalb der zulässigen Verzögerungszeitperiode der Speicherzustand der Speichereinheit in einen Zustand versetzt werden kann oder nicht, in dem das Foliensubstrat, das von der zweiten Verarbeitungsvorrichtung während der Stoppzeitperiode in dem Fall, dass die erste Verarbeitungsvorrichtung vorübergehend gestoppt wird, zugeführt wird, in der Speichereinheit gespeichert werden kann.

7.  Herstellungssystem gemäß Anspruch 1 oder 5, wobei:

die zweite Verarbeitungsvorrichtung und die Speichereinheit auf einer stromabwärtigen Seite der ersten Verarbeitungsvorrichtung entlang der Förderrichtung des Foliensubstrats angeordnet sind; und

die Steuervorrichtung bestimmt, ob innerhalb der zulässigen Verzögerungszeitperiode der Speicherzustand der Speichereinheit in einen Zustand versetzt werden kann oder nicht, in dem das Foliensubstrat, das von einer Länge ist, die in der Lage ist, der zweiten Verarbeitungsvorrichtung während der Stoppzeitperiode in dem Fall, dass die erste Verarbeitungsvorrichtung vorübergehend gestoppt wird, zugeführt zu werden, in der Lage ist, in der Speichereinheit gespeichert zu werden.

8.  Herstellungssystem gemäß einem der Ansprüche 1 und 5 bis 7, wobei in dem Fall, dass die Steuervorrichtung bestimmt hat, dass der Speicherzustand der Speichereinheit dazu gebracht werden kann, den erforderlichen Speicherzustand innerhalb der zulässigen Verzögerungszeitperiode zu erfüllen, die Förderung und Verarbeitung des Foliensubstrats in der zweiten Verarbeitungsvorrichtung fortgesetzt wird, während die Förderung und Verarbeitung des Foliensubstrats in der ersten Verarbeitungsvorrichtung für die Stoppzeitperiode vorübergehend gestoppt wird, in einem Stadium, in dem der Speicherzustand der Speichereinheit in den erforderlichen Speicherzustand versetzt worden ist.

9.  Herstellungssystem gemäß Anspruch 4 oder 8, wobei
ein ein Bauelement bildender Bereich, an dem ein Muster gebildet wird, auf dem Foliensubstrat in einem Zustand angeordnet ist, in dem er angrenzt an und eingeschichtet ist zwischen Randabschnitten entlang der Längsrichtung;
die erste Verarbeitungsvorrichtung die Verarbeitung in einem Bereich durchführt, der kürzer als die Länge der Randabschnitte in Längsrichtung ist; und
wenn die Randabschnitte in eine Verarbeitungsposition gebracht werden, in der die erste Verarbeitungsvorrichtung die Verarbeitung an dem Foliensubstrat durchführt, die Steuervorrichtung einen vorübergehenden Stopp der Förderung und Verarbeitung des Foliensubstrats in der ersten Verarbeitungsvorrichtung ausführt.

10. Herstellungssystem gemäß Anspruch 4 oder 8, wobei:

ein ein Bauelement bildender Bereich, an dem ein Muster gebildet wird, auf dem Foliensubstrat in einem Zustand angeordnet ist, in dem er angrenzt an und eingeschichtet ist zwischen Randabschnitten entlang der Längsrichtung;
die zweite Verarbeitungsvorrichtung die Verarbeitung in einem Bereich durchführt, der länger als eine Länge der Randabschnitte in Längsrichtung ist; und
in dem Fall, dass die Steuervorrichtung bestimmt hat, dass der Speicherzustand der Speichereinheit den erforderlichen Speicherzustand erfüllt, oder in einem Stadium, in dem der Speicherzustand der Speichereinheit in den erforderlichen Speicherzustand versetzt worden ist, die Steuervorrichtung sofort einen vorübergehenden Stopp der Förderung und Verarbeitung des Foliensubstrats in der ersten Verarbeitungsvorrichtung ausführt.

11. Herstellungssystem gemäß einem der Ansprüche 1 und 5 bis 8, bei dem in dem Fall, dass die Steuervorrichtung bestimmt hat, dass der Speicherzustand der Speichereinheit nicht dazu gebracht werden kann, den erforderlichen Speicherzustand innerhalb der zulässigen Verzögerungszeitperiode zu erfüllen, die Verarbeitung durch die Vielzahl von Verarbeitungsvorrichtungen gestoppt wird, während die Förderung des durch die Vielzahl von Verarbeitungsvorrichtungen fließenden Foliensubstrats vollständig gestoppt wird.

12. Herstellungssystem gemäß einem der Ansprüche 1 bis 3, wobei eine der ersten Verarbeitungsvorrichtung und der zweiten Verarbeitungsvorrichtung eine Musterungsvorrichtung ist, die dazu konfiguriert ist, ein Muster einer elektronischen Vorrichtung auf dem Foliensubstrat zu bilden.

13. Herstellungssystem (10), das dazu eingerichtet ist, kontinuierlich Prozesse an einem länglichen flexiblen Foliensubstrat (P) durch eine Vielzahl von Verarbeitungsvorrichtungen durchzuführen, während das Foliensubstrat (P) in einer Längsrichtung gefördert wird, aufweisend:

eine erste Verarbeitungsvorrichtung (PR2), die dazu eingerichtet ist, selektiv oder gleichmäßig einen lichtempfindlichen Dünnfilm auf einer Fläche des Foliensubstrats (P) auszubilden, während das Foliensubstrat (P) gefördert wird;

eine zweite Verarbeitungsvorrichtung (PR3), die dazu eingerichtet ist, den lichtempfindlichen Dünnfilm auf der Fläche des Foliensubstrats (P) mit Lichtenergie zu bestrahlen, die einem vorbestimmten Muster entspricht, während das Foliensubstrat (P), auf dem der lichtempfindliche Dünnfilm ausgebildet ist, gefördert wird, so dass dadurch ein latentes Bild gebildet wird, das dem Muster auf dem lichtempfindlichen Dünnfilm entspricht;

eine dritte Verarbeitungsvorrichtung (PR4) zum Verursachen, dass das Muster auf dem Foliensubstrat erscheint, während das Foliensubstrat (P), auf dem das latente Bild gebildet wird, gefördert wird, indem der lichtempfindliche Dünnfilm, der dem latenten Bild entspricht, selektiv entwickelt oder der lichtempfindliche Dünnfilm, der dem latenten Bild entspricht, selektiv plattiert wird;

eine erste Speichereinheit (BF1), die zwischen der ersten Verarbeitungsvorrichtung (PR2) und der zweiten Verarbeitungsvorrichtung (PR3) angeordnet ist und die in der Lage ist, das Foliensubstrat (P) über eine vorbestimmte Länge zu speichern;

eine zweite Speichereinheit (BF2), die zwischen der zweiten Verarbeitungsvorrichtung (PR3) und der dritten Verarbeitungsvorrichtung (14) angeordnet ist, und die in der Lage ist, das Foliensubstrat (P) über eine vorbestimmte Länge zu speichern; und

eine Steuervorrichtung (14), die dazu eingerichtet ist, zu bestimmen, ob ein Speicherzustand des Foliensubstrats in mindestens einer der Speichereinheiten, die benachbart zu der mindestens einen der Verarbeitungsvorrichtungen ist, für die ein vorübergehender Stopp der Verarbeitung angefordert wird, einen erforderlichen Speicherzustand erfüllt oder nicht, der durch eine vorhergesagte Stoppzeitperiode bestimmt wird, in dem Fall, dass mindestens eine von der ersten Verarbeitungsvorrichtung (PR2), der zweiten Verarbeitungsvorrichtung (PR3) und der dritten Verarbeitungsvorrichtung (PR4) einen vorübergehenden Stopp der eigenen Verarbeitung anfordert,

wobei in dem Fall, dass bestimmt wird, dass der Speicherzustand der Speichereinheiten den erforderlichen Speicherzustand nicht erfüllt, die Steuervorrichtung bestimmt, ob der Speicherzustand der mindestens einen der Speichereinheiten, die benachbart zu der mindestens einen der Verarbeitungsvorrichtungen ist, für die ein vorübergehender Stopp der Verarbeitung angefordert wird, dazu gebracht werden kann oder nicht, den erforderlichen Speicherzustand innerhalb einer zulässigen Verzögerung in der Zeitperiode zu erfüllen, während der gewartet wird, bis die Verarbeitung durch die mindestens eine der Verarbeitungsvorrichtungen, für die ein vorübergehender Stopp der Verarbeitung angefordert wird, gestoppt wird, durch Ändern der Fördergeschwindigkeit des Foliensubstrats (P) von mindestens einer aus der ersten Verarbeitungsvorrichtung (PR2), der zweiten Verarbeitungsvorrichtung (PR3) und der dritten Verarbeitungsvorrichtung (PR4).

14. Herstellungssystem gemäß Anspruch 13, wobei in dem Fall, dass die Verarbeitungsvorrichtung, für die ein vorübergehender Stopp der Verarbeitung angefordert wird, die zweite Verarbeitungsvorrichtung ist, die Steuervorrichtung bestimmt, dass der Speicherzustand der mindestens einen der Speichereinheiten den erforderlichen Speicherzustand erfüllt, wenn die erste Speichereinheit in einem Zustand ist, in dem sie in der Lage ist, das von der ersten Verarbeitungsvorrichtung dorthin zugeführte Foliensubstrat zu speichern, während der Stoppzeitperiode, in der die zweite Verarbeitungsvorrichtung vorübergehend gestoppt wird, und die zweite Speichereinheit in einem Zustand ist, in dem sie das Foliensubstrat einer Länge speichert, die in der Lage ist, der dritten Verarbeitungsvorrichtung während der Stoppzeitperiode zugeführt zu werden.

15. Herstellungssystem gemäß Anspruch 13, wobei in dem Fall, dass die Verarbeitungsvorrichtung, für die ein vorübergehender Stopp der Verarbeitung angefordert wird, die erste Verarbeitungsvorrichtung ist, die Steuervorrichtung bestimmt, dass der Speicherzustand der mindestens einen der Speichereinheiten den erforderlichen Speicherzustand erfüllt, wenn die erste Speichereinheit in einem Zustand ist, in dem sie das Foliensubstrat einer Länge speichert, die in der Lage ist, der zweiten Verarbeitungsvorrichtung während der Stoppzeitperiode zugeführt zu werden, in der die erste Verarbeitungsvorrichtung vorübergehend gestoppt wird.

16. Herstellungssystem gemäß einem der Ansprüche 13 bis 15, wobei in dem Fall, dass die Verarbeitungsvorrichtung, für die ein vorübergehender Stopp der Verarbeitung angefordert wird, die dritte Verarbeitungsvorrichtung ist, die Steuervorrichtung bestimmt, dass der Speicherzustand der mindestens einen der Speichereinheiten den erforderlichen Speicherzustand erfüllt, wenn die zweite Speichereinheit in einem Zustand ist, in dem sie in der Lage ist, das von der zweiten Verarbeitungsvorrichtung während der Stoppzeitperiode, in der die dritte Verarbeitungsvorrichtung vorübergehend gestoppt wird, zugeführte Foliensubstrat zu speichern.

17. Herstellungssystem gemäß einem der Ansprüche 13 bis 15, wobei in dem Fall, dass die Steuervorrichtung bestimmt hat, dass der Speicherzustand der Speichereinheiten den erforderlichen Speicherzustand erfüllt, während die Förderung und Verarbeitung des Foliensubstrats in der spezifischen mindestens einen der Verarbeitungsvorrichtungen, für die ein vorübergehender Stopp der Verarbeitung angefordert wird, für die Stoppzeitperiode vorübergehend gestoppt wird, die Förderung und Verarbeitung des Foliensubstrats in jeder der Verarbeitungsvorrichtungen mit Ausnahme der spezifischen Verarbeitungsvorrichtung fortgesetzt wird.

18. Herstellungssystem gemäß einem der Ansprüche 13 bis 17, wobei die Steuervorrichtung bestimmt, ob der Speicherzustand mindestens einer der Speichereinheiten, die benachbart zu der mindestens einen der Verarbeitungsvorrichtungen ist, für die ein vorübergehender Stopp der Verarbeitung angefordert wird, dazu gebracht werden kann, den erforderlichen Speicherzustand innerhalb der zulässigen Verzögerungszeitperiode zu erfüllen oder nicht, durch Erhöhen oder Verringern der Fördergeschwindigkeit von mindestens einer aus der ersten Verarbeitungsvorrichtung, der zweiten Verarbeitungsvorrichtung und der dritten Verarbeitungsvorrichtung, während die Verarbeitungsbedingungen von mindestens einer aus der ersten Verarbeitungsvorrichtung, der zweiten Verarbeitungsvorrichtung und der dritten Verarbeitungsvorrichtung so geändert werden, dass eine Verschlechterung der Verarbeitungsqualität unterdrückt wird.

19. Herstellungssystem gemäß Anspruch 13 oder 18, wobei in dem Fall, dass die Verarbeitungsvorrichtung, für die ein vorübergehender Stopp der Verarbeitung angefordert wird, die zweite Verarbeitungsvorrichtung ist, die Steuervorrichtung bestimmt, ob innerhalb der zulässigen Verzögerungszeitperiode der Speicherzustand der ersten Speichereinheit in einen Zustand versetzt werden kann oder nicht, in dem sie in der Lage ist, das von der ersten Verarbeitungsvorrichtung dorthin zugeführte Foliensubstrat zu speichern, selbst wenn die zweite Verarbeitungsvorrichtung während der Stoppzeitperiode vorübergehend gestoppt wird, und ob der Speicherzustand der zweiten Speichereinheit innerhalb der zulässigen Verzögerungszeitperiode in einen Zustand versetzt werden kann oder nicht, in dem sie das Foliensubstrat einer Länge speichert, die in der Lage ist, der dritten Verarbeitungsvorrichtung zugeführt zu werden, selbst wenn die zweite Verarbeitungsvorrichtung während der Stoppzeitperiode vorübergehend gestoppt wird.

20. Herstellungssystem gemäß einem der Ansprüche 13 bis 18, wobei in dem Fall, dass die Verarbeitungsvorrichtung, für die ein vorübergehender Stopp der Verarbeitung angefordert wird, die erste Verarbeitungsvorrichtung ist, die Steuervorrichtung bestimmt, ob der Speicherzustand der ersten Speichereinheit innerhalb der zulässigen Verzögerungszeitperiode in einen Zustand versetzt werden kann oder nicht, in dem sie in der Lage ist, das Foliensubstrat einer Länge zu speichern, die der zweiten Verarbeitungsvorrichtung zugeführt werden kann, selbst wenn die erste Verarbeitungsvorrichtung während der Stoppzeitperiode vorübergehend gestoppt wird.

21. Herstellungssystem gemäß den Ansprüchen 13 oder 18, wobei in dem Fall, dass die Verarbeitungsvorrichtung, für die ein vorübergehender Stopp der Verarbeitung angefordert wird, die dritte Verarbeitungsvorrichtung ist, die Steuervorrichtung bestimmt, ob der Speicherzustand der zweiten Speichereinheit innerhalb der zulässigen Verzögerungszeitperiode in einen Zustand versetzt werden kann oder nicht, in dem sie in der Lage ist, das von der zweiten Verarbeitungsvorrichtung dorthin zugeführte Foliensubstrat zu speichern, selbst wenn die dritte Verarbeitungsvorrichtung während der Stoppzeitperiode vorübergehend gestoppt wird.

22. Herstellungssystem gemäß den Ansprüchen 13 oder 18, wobei in dem Fall, dass die Steuervorrichtung bestimmt hat, dass der Speicherzustand mindestens einer der Speichereinheiten dazu gebracht werden kann, den erforderlichen Speicherzustand innerhalb der zulässigen Verzögerungszeitperiode zu erfüllen, und in einem Stadium, in dem die Speicherzustände der Speichereinheiten in den erforderlichen Speicherzustand versetzt worden sind, während die Förderung und Verarbeitung des Foliensubstrats in mindestens einer der spezifischen Verarbeitungsvorrichtungen, für die ein vorübergehender Stopp der Verarbeitung angefordert wird, während der Stoppzeitperiode vorübergehend gestoppt wird, die Förderung und Verarbeitung des Foliensubstrats in jeder der Verarbeitungsvorrichtungen mit Ausnahme der spezifischen Verarbeitungsvorrichtung fortgesetzt wird.

23. Herstellungssystem gemäß einem der Ansprüche 19 bis 22, wobei:

ein ein Bauelement bildender Bereich, an dem ein Muster gebildet wird, auf dem Foliensubstrat in einem Zustand angeordnet ist, in dem er angrenzt an und eingeschichtet ist zwischen Randabschnitten entlang der Längsrichtung;
die erste Verarbeitungsvorrichtung und die zweite Verarbeitungsvorrichtung die Verarbeitung in einem Bereich durchführen, der kürzer als eine Länge der Randabschnitte in Längsrichtung ist; und

die dritte Verarbeitungsvorrichtung die Verarbeitung in einem Bereich durchführt, der länger als eine Länge der Randabschnitte in Längsrichtung ist; und
die Steuervorrichtung:

in dem Fall, dass die Verarbeitungsvorrichtung, für die ein vorübergehender Stopp der Verarbeitung angefordert wird, die dritte Verarbeitungsvorrichtung ist, und in dem Fall, dass bestimmt wird, dass der Speicherzustand der Speichereinheiten den erforderlichen Speicherzustand erfüllt, oder in einem Stadium, in dem der Speicherzustand der Speichereinheiten in den erforderlichen Speicherzustand versetzt worden ist, einen vorübergehenden Stopp der Förderung und Verarbeitung des Foliensubstrats in der dritten Verarbeitungsvorrichtung ausführt; und
in dem Fall, dass die Verarbeitungsvorrichtung, für die ein vorübergehender Stopp der Verarbeitung angefordert wird, die erste Verarbeitungsvorrichtung oder die zweite Verarbeitungsvorrichtung ist, und wenn die Randabschnitte in eine Verarbeitungsposition gebracht werden, in der die Verarbeitungsvorrichtung, für die ein vorübergehender Stopp der Verarbeitung angefordert wird, die Verarbeitung an dem Foliensubstrat durchführt, einen vorübergehenden Stopp der Förderung und Verarbeitung des Foliensubstrats in der Verarbeitungsvorrichtung, für die ein vorübergehender Stopp der Verarbeitung angefordert wird, ausführt.

24. Herstellungssystem gemäß einem der Ansprüche 19 bis 22, wobei dem in dem Fall, dass die Steuervorrichtung bestimmt hat, dass die Speicherzustände der Speichereinheiten nicht dazu gebracht werden können, den erforderlichen Speicherzustand innerhalb der zulässigen Verzögerungszeitperiode zu erfüllen, die Verarbeitung durch die Vielzahl von Verarbeitungsvorrichtungen gestoppt wird, während die Förderung des Foliensubstrats, das durch die erste Verarbeitungsvorrichtung, die zweite Verarbeitungsvorrichtung und die dritte Verarbeitungsvorrichtung fließt, vollständig gestoppt wird.

25. Herstellungssystem gemäß einem der Ansprüche 13 bis 15, wobei die erste Verarbeitungsvorrichtung eine Düsenbeschichtungs-Kopfeinheit enthält, die dazu eingerichtet ist, eine Flüssigkeit, die der lichtempfindliche Dünnfilm wird, auf das Foliensubstrat aufzutragen, und die erste Verarbeitungsvorrichtung den vorübergehenden Stopp anfordert, wenn ein Nachfüllvorgang der Flüssigkeit zu der Düsenbeschichtungs-Kopfeinheit erforderlich ist.

26. Herstellungssystem gemäß einem der Ansprüche 13 bis 15, wobei die zweite Verarbeitungsvorrichtung einen Kalibriermechanismus enthält, der dazu eingerichtet ist, einen Positionsfehler zu kalibrieren, wenn die Fläche des Foliensubstrats mit Lichtenergie bestrahlt wird, und die zweite Verarbeitungsvorrichtung den vorübergehenden Stopp anfordert, wenn ein Kalibriervorgang durch den Kalibriermechanismus erforderlich ist.

## Revendications

1. Système de fabrication (10) adapté pour mettre en œuvre en continu des processus sur un substrat en feuille souple allongé (P) par une pluralité de dispositifs de traitement tout en transportant le substrat en feuille (P) dans une direction longitudinale, comprenant :

une unité de stockage (BF1) disposée entre un premier dispositif de traitement (PR2) et un deuxième dispositif de traitement (PR3) adjacent au premier dispositif de traitement (PR2) parmi la pluralité de dispositifs de traitement ; et
un dispositif de commande (14) adapté pour déterminer si oui ou non un état de stockage du substrat en feuille dans l'unité de stockage (BF1) satisfait à un état de stockage requis déterminé par une période de temps d'arrêt prévue du premier dispositif de traitement (PR2), lorsque, dans le premier dispositif de traitement (PR2), le traitement par rapport au substrat en feuille (P), ou le transport du substrat en feuille (P) est arrêté temporairement,
dans lequel, dans le cas où il est déterminé que l'état de stockage de l'unité de stockage (BF1) ne satisfait pas à l'état de stockage requis, le dispositif de commande (14) détermine si oui ou non l'état de stockage de l'unité de stockage (BF1) peut être réalisé pour satisfaire à l'état de stockage requis au sein d'une période de temps d'attente acceptable pendant laquelle on patiente jusqu'à ce que le transport du substrat en feuille (P) par le premier dispositif de traitement (PR2) soit arrêté, en changeant la vitesse de transport du substrat en feuille (P) d'au moins l'un parmi le premier dispositif de traitement (PR2) et le deuxième dispositif de traitement (PR3).

2. Système de fabrication selon la revendication 1, dans lequel :

le deuxième dispositif de traitement et l'unité de stockage sont agencés sur un côté amont du premier dispositif de traitement le long de la direction de transport du substrat en feuille ; et

même si le premier dispositif de traitement est arrêté temporairement pour la période de temps d'arrêt, dans le cas où l'unité de stockage est capable de stocker le substrat en feuille délivré depuis le deuxième dispositif de traitement pendant la période de temps d'arrêt, le dispositif de commande détermine que l'état de stockage de l'unité de stockage satisfait à l'état de stockage requis.

3. Système de fabrication selon la revendication 1, dans lequel :

le deuxième dispositif de traitement et l'unité de stockage sont agencés sur un côté aval du premier dispositif de traitement le long de la direction de transport du substrat en feuille ; et

même si le premier dispositif de traitement est arrêté temporairement pour la période de temps d'arrêt, dans le cas où l'unité de stockage stocke le substrat en feuille d'une longueur apte à être fournie au deuxième dispositif de traitement pendant la période de temps d'arrêt, le dispositif de commande détermine que l'état de stockage de l'unité de stockage satisfait à l'état de stockage requis.

4. Système de fabrication selon l'une quelconque des revendications 1 à 3, dans lequel, dans le cas où le dispositif de commande a déterminé que l'état de stockage de l'unité de stockage satisfait à l'état de stockage requis, le transport et le traitement du substrat en feuille dans le deuxième dispositif de traitement sont poursuivis, tandis que le transport et le traitement du substrat en feuille dans le premier dispositif de traitement sont arrêtés temporairement pour la période de temps d'arrêt.

5. Système de fabrication selon la revendication 1, dans lequel le dispositif de commande détermine si oui ou non l'état de stockage de l'unité de stockage peut être réalisé pour satisfaire à l'état de stockage requis au sein de la période de temps d'attente acceptable, en augmentant la vitesse de transport du premier dispositif de traitement ou en diminuant la vitesse de transport du deuxième dispositif de traitement, tout en changeant des conditions de traitement d'au moins un parmi le premier dispositif de traitement et le deuxième dispositif de traitement de façon à supprimer une détérioration dans la qualité de traitement.

6. Système de fabrication selon la revendication 1 ou 5, dans lequel :

le deuxième dispositif de traitement et l'unité de stockage sont agencés sur un côté amont du premier dispositif de traitement le long de la direction de transport du substrat en feuille ; et

le dispositif de commande détermine si oui ou non, au sein de la période de temps d'attente acceptable, l'état de stockage de l'unité de stockage peut être placé dans un état où le substrat en feuille, qui est délivré depuis le deuxième dispositif de traitement pendant la période de temps d'arrêt dans le cas où le premier dispositif de traitement est arrêté temporairement, est apte à être stocké dans l'unité de stockage.

7. Système de fabrication selon la revendication 1 ou 5, dans lequel :

le deuxième dispositif de traitement et l'unité de stockage sont agencés sur un côté aval du premier dispositif de traitement le long de la direction de transport du substrat en feuille ; et

le dispositif de commande détermine si oui ou non, au sein de la période de temps d'attente acceptable, l'état de stockage de l'unité de stockage peut être placé dans un état où le substrat en feuille, qui est d'une longueur apte à être fournie au deuxième dispositif de traitement pendant la période de temps d'arrêt dans le cas où le premier dispositif de traitement est arrêté temporairement, est apte à être stocké dans l'unité de stockage.

8. Système de fabrication selon l'une quelconque des revendications 1 et 5 à 7, dans lequel, dans le cas où le dispositif de commande a déterminé que l'état de stockage de l'unité de stockage peut être réalisé pour satisfaire à l'état de stockage requis au sein de la période de temps d'attente acceptable, le transport et le traitement du substrat en feuille dans le deuxième dispositif de traitement sont poursuivis, tandis que le transport et le traitement du substrat en feuille dans le premier dispositif de traitement sont arrêtés temporairement pour la période de temps d'arrêt, à un stade où l'état de stockage de l'unité de stockage a été placé dans l'état de stockage requis.

9. Système de fabrication selon la revendication 4 ou 8, dans lequel :

une zone formant dispositif sur laquelle un motif est formé est agencée sur le substrat en feuille dans un état contigu avec et en sandwich entre des parties marginales le long de la direction longitudinale ;

le premier dispositif de traitement effectue le traitement dans une plage qui est plus courte que la longueur des parties marginales dans la direction longitudinale ; et

lorsque les parties marginales sont mises dans une position de traitement où le premier dispositif de traitement effectue un traitement sur le substrat en feuille, le dispositif de commande exécute un arrêt temporaire de transport et de traitement du substrat en feuille dans le premier dispositif de traitement.

10. Système de fabrication selon la revendication 4 ou 8, dans lequel :
une zone formant dispositif sur laquelle un motif est formé est agencée sur le substrat en feuille dans un état contigu avec et en sandwich entre des parties marginales le long de la direction longitudinale :

le deuxième dispositif de traitement effectue le traitement dans une plage qui est plus longue qu'une longueur des parties marginales dans la direction longitudinale ; et
dans le cas où le dispositif de commande a déterminé que l'état de stockage de l'unité de stockage satisfait à l'état de stockage requis, ou à un stade auquel l'état de stockage de l'unité de stockage a été placé dans l'état de stockage requis, le dispositif de commande exécute immédiatement un arrêt temporaire de transport et de traitement du substrat en feuille dans le premier dispositif de traitement.

11. Système de fabrication selon l'une quelconque des revendications 1 et 5 à 8, dans lequel, dans le cas où le dispositif de commande a déterminé que l'état de stockage de l'unité de stockage ne peut pas être réalisé pour satisfaire à l'état de stockage requis au sein de la période de temps d'attente acceptable, le traitement par la pluralité de dispositifs de traitement est arrêté, tandis que le transport du substrat en feuille circulant à travers la pluralité de dispositifs de traitement est arrêté complètement.

12. Système de fabrication selon l'une quelconque des revendications 1 à 3, dans lequel un parmi le premier dispositif de traitement et le deuxième dispositif de traitement est un dispositif de création de motif configuré pour former un motif d'un dispositif électronique sur le substrat en feuille.

13. Système de fabrication (10) adapté pour mettre en œuvre en continu des processus sur un substrat en feuille souple allongé (P) par une pluralité de dispositifs de traitement tout en transportant le substrat en feuille (P) dans une direction longitudinale, comprenant :

un premier dispositif de traitement (PR2) adapté pour former sélectivement ou uniformément un film mince photosensible sur une surface du substrat en feuille (P) tout en transportant le substrat en feuille (P) ;
un deuxième dispositif de traitement (PR3) adapté pour irradier le film mince photosensible sur la surface du substrat en feuille (P) avec une énergie lumineuse correspondant à un motif prédéterminé, tout en transportant le substrat en feuille (P) sur lequel le film mince photosensible est formé, pour ainsi former une image latente correspondant au motif sur le film mince photosensible ;
un troisième dispositif de traitement (PR4) pour amener le motif à apparaître sur le substrat en feuille tout en transportant le substrat en feuille (P) sur lequel l'image latente est formée, en développant sélectivement le film mince photosensible correspondant à l'image latente, ou en revêtant sélectivement le film mince photosensible correspondant à l'image latente ;
une première unité de stockage (BF1) disposée entre le premier dispositif de traitement (PR2) et le deuxième dispositif de traitement (PR3), et qui est apte à stocker le substrat en feuille (P) sur une longueur prédéterminée ;
une seconde unité de stockage (BF2) disposée entre le deuxième dispositif de traitement (PR3) et le troisième dispositif de traitement (14), et qui est apte à stocker le substrat en feuille (P) sur une longueur prédéterminée ; et
un dispositif de commande (14) adapté pour déterminer si oui ou non un état de stockage du substrat en feuille dans au moins une des unités de stockage adjacente à au moins un des dispositifs de traitement pour qui un arrêt temporaire de traitement est requis satisfait à un état de stockage requis déterminé par une période de temps d'arrêt prévue, dans le cas où au moins un parmi le premier dispositif de traitement (PR2), le deuxième dispositif de traitement (PR3) et le troisième dispositif de traitement (PR4) requiert un arrêt temporaire de son propre traitement,
dans lequel, dans le cas où il est déterminé que l'état de stockage des unités de stockage ne satisfait pas à l'état de stockage requis, le dispositif de commande détermine si oui ou non l'état de stockage de l'au moins une des unités de stockage qui est adjacente à l'au moins un des dispositifs de traitement pour qui un arrêt temporaire de traitement est requis peut être réalisé pour satisfaire à l'état de stockage requis au sein d'un temps d'attente acceptable dans une période de temps pendant laquelle on patiente jusqu'à ce que le traitement par l'au moins un des dispositifs de traitement pour qui un arrêt temporaire de traitement est requis soit arrêté, en changeant la vitesse de transport du substrat en feuille (P) d'au moins un parmi le premier dispositif de traitement (PR2), le deuxième dispositif de traitement (PR3) et le troisième dispositif de traitement (PR4).

14. Système de fabrication selon la revendication 13, dans lequel, dans le cas où le dispositif de traitement pour qui un arrêt temporaire de traitement est requis est le deuxième dispositif de traitement, le dispositif de traitement détermine que l'état de stockage de l'au moins une des unités de stockage satisfait à l'état de stockage requis, lorsque la première unité de stockage est dans un état capable de stocker le substrat en feuille qui lui est délivré depuis le premier dispositif de traitement pendant la période de temps d'arrêt où le deuxième dispositif de traitement est arrêté temporairement, et la seconde unité de traitement est dans un état de stockage du substrat en feuille d'une longueur apte à être fournie au troisième dispositif de traitement pendant la période de temps d'arrêt.

15. Système de fabrication selon la revendication 13, dans lequel, dans le cas où le dispositif de traitement pour qui un arrêt temporaire de traitement est requis est le premier dispositif de traitement, le dispositif de commande détermine que l'état de stockage d'au moins une des unités de stockage satisfait à l'état de stockage requis, lorsque la première unité de stockage est dans un état de stockage du substrat en feuille d'une longueur apte à être fournie au deuxième dispositif de traitement pendant la période de temps d'arrêt où le premier dispositif de traitement est arrêté temporairement.

16. Système de fabrication selon l'une quelconque des revendications 13 à 15, dans lequel, dans le cas où le dispositif de traitement pour qui un arrêt temporaire de traitement est requis est le troisième dispositif de traitement, le dispositif de commande détermine que l'état de stockage d'au moins une des unités de stockage satisfait à l'état de stockage requis, lorsque la seconde unité de stockage est dans un état apte à stocker le substrat en feuille délivré depuis le deuxième dispositif de traitement pendant la période de temps d'arrêt où le troisième dispositif de traitement est arrêté temporairement.

17. Système de fabrication selon l'une quelconque des revendications 13 à 15, dans lequel, dans le cas où le dispositif de traitement a déterminé que l'état de stockage des unités de stockage satisfait à l'état de stockage requis, tandis que le transport et le traitement du substrat en feuille dans l'au moins un spécifique des dispositifs de traitement pour qui un arrêt temporaire de traitement est requis est arrêté temporairement pour la période de temps d'arrêt, le transport et le traitement du substrat en feuille dans chacun des dispositifs de traitement à l'exception du dispositif de traitement spécifique sont poursuivis.

18. Système de fabrication selon l'une quelconque des revendications 13 à 17, dans lequel le dispositif de commande détermine si oui ou non l'état de stockage d'au moins une des unités de stockage adjacente à l'au moins un des dispositifs de traitement pour qui un arrêt temporaire de traitement est requis peut être réalisé pour satisfaire à l'état de stockage requis au sein de la période de temps d'attente acceptable, en augmentant ou en diminuant la vitesse de transport d'au moins un parmi le premier dispositif de traitement, le deuxième dispositif de traitement et le troisième dispositif de traitement, tout en changeant des conditions de traitement d'au moins un parmi le premier dispositif de traitement, le deuxième dispositif de traitement et le troisième dispositif de traitement de façon à supprimer une détérioration dans la qualité de traitement.

19. Système de fabrication selon la revendication 13 ou 18, dans lequel, dans le cas où le dispositif de traitement pour qui un arrêt temporaire de traitement est requis est le deuxième dispositif de traitement, le dispositif de commande détermine si oui ou non, au sein de la période de temps d'attente acceptable, l'état de stockage de la première unité de stockage peut être placé dans un état apte à stocker le substrat en feuille qui lui est délivré depuis le premier dispositif de traitement même si le deuxième dispositif de traitement est arrêté temporairement pendant la période de temps d'arrêt, et si oui ou non, au sein de la période de temps d'attente acceptable, l'état de stockage de la seconde unité de stockage peut être placé dans un état de stockage du substrat en feuille d'une longueur apte à être fournie au troisième dispositif même si le deuxième dispositif de traitement est arrêté temporairement pendant la période de temps d'arrêt.

20. Système de fabrication selon l'une quelconque des revendications 13 à 18, dans lequel, dans le cas où le dispositif de traitement pour qui un arrêt temporaire de traitement est requis est le premier dispositif de traitement, le dispositif de commande détermine si oui ou non, au sein de la période de temps d'attente acceptable, l'état de stockage de la première unité de stockage peut être placé dans un état apte à stocker le substrat en feuille d'une longueur apte à être fournie au deuxième dispositif de traitement même si le premier dispositif de traitement est arrêté temporairement pendant la période de temps d'arrêt.

21. Système de fabrication selon les revendications 13 ou 18, dans lequel, dans le cas où le dispositif de traitement pour qui un arrêt temporaire de traitement est requis est le troisième dispositif de traitement, le dispositif de commande détermine si oui ou non, au sein de la période de temps d'attente acceptable, l'état de stockage de la seconde unité de stockage peut être placé dans un état capable de stocker le substrat en feuille qui lui est délivré depuis le deuxième dispositif de traitement même si le troisième dispositif de traitement est arrêté temporairement pendant la période de temps d'arrêt.

22. Système de fabrication selon les revendications 13 ou 18, dans lequel, dans le cas où le dispositif de commande a déterminé que l'état de stockage d'au moins une des unités de stockage peut être réalisé pour satisfaire à l'état de stockage requis au sein de la période de temps d'attente acceptable, et à un stade auquel les états de stockage des unités de stockage ont été placés dans l'état de stockage requis, tandis que le transport et le traitement du substrat en feuille dans au moins un des dispositifs de traitement spécifique pour qui un arrêt temporaire de traitement est requis est arrêté temporairement pendant la période de temps d'arrêt, le transport et le traitement du substrat en feuille dans chacun des dispositifs de traitement à l'exception du dispositif de traitement spécifique sont poursuivis.

23. Système de fabrication selon l'une quelconque des revendications 19 à 22, dans lequel :

une région formant dispositif sur laquelle un motif est formé est agencée sur le substrat en feuille dans un état contigu avec et en sandwich entre des parties marginales le long de la direction longitudinale ;
le premier dispositif de traitement et le deuxième dispositif de traitement effectuent le traitement dans une plage qui est plus courte qu'une longueur des parties marginales dans la direction longitudinale ; et
le troisième dispositif de traitement effectue le traitement dans une plage qui est plus longue qu'une longueur des parties marginales dans la direction longitudinale ; et
le dispositif de commande :

dans le cas où le dispositif de traitement pour qui un arrêt temporaire de traitement est requis est le troisième dispositif de traitement, et dans le cas où il est déterminé que l'état de stockage des unités de stockage satisfait à l'état de stockage requis, ou à un stade auquel l'état de stockage des unités de stockage a été placé dans l'état de stockage requis, exécute un arrêt temporaire de transport et de traitement du substrat en feuille dans le troisième dispositif de traitement ; et
dans le cas où le dispositif de traitement pour qui un arrêt temporaire de traitement est requis est le premier dispositif de traitement ou le deuxième dispositif de traitement, et lorsque les parties marginales sont mises dans une position de traitement où le dispositif de traitement pour qui un arrêt temporaire de traitement est requis effectue le traitement sur le substrat en feuille, exécute un arrêt temporaire de transport et de traitement du substrat en feuille dans le dispositif de traitement pour qui un arrêt temporaire de traitement est requis.

24. Système de fabrication selon l'une quelconque des revendications 19 à 22, dans lequel, dans le cas où le dispositif de commande a déterminé que les états de stockage des unités de stockage ne peuvent pas être réalisés pour satisfaire à l'état de stockage requis au sein de la période de temps d'attente acceptable, le traitement par la pluralité de dispositifs de traitement est arrêté, tandis que le transport du substrat en feuille circulant à travers le premier dispositif de traitement, le deuxième dispositif de traitement et le troisième dispositif de traitement est arrêté entièrement.

25. Système de fabrication selon l'une quelconque des revendications 13 à 15, dans lequel le premier dispositif de traitement inclut une unité à tête d'enduction à filière adaptée pour appliquer un liquide qui devient le film mince photosensible sur le substrat en feuille, et le premier dispositif de traitement requiert l'arrêt temporaire lorsqu'une opération de réapprovisionnement du liquide vers l'unité à tête d'enduction à filière est requise.

26. Système de fabrication selon l'une quelconque des revendications 13 à 15, dans lequel le deuxième dispositif de traitement inclut un mécanisme d'étalonnage adapté pour étalonner une erreur de position lors de l'irradiation de la surface du substrat en feuille avec une énergie lumineuse, et le deuxième dispositif de traitement requiert l'arrêt temporaire lorsqu'une opération d'étalonnage par le mécanisme d'étalonnage est requise.

# FIG. 1

FIG. 2

FIG. 3

FIG. 4

FIG. 5

EP 3 358 611 B1

# FIG. 6

FIG. 7

FIG. 8

PR4 (PR5)

LOWER LEVEL
CONTROL DEVICE

80

87

86

NR8

83

R7

P

NR7

R4

84

R5

LQ

Ts

Cs

R6

BT

H1

H2

HEATER
DRIVING UNIT

82

P

Z

Y

X

EP 3 358 611 B1

# FIG. 9

FIG. 10

INT.

S1 IS THERE A PROLONGED TIME PERIOD STOPPAGE?
— NO
— YES

S2 DURING ADJUSTMENT?
— NO
— YES → RET

S3 CONFIRM CURRENT PROCESSING POSITION AND UPSTREAM AND DOWSTREAM STORAGE STATES, CONFIRM OPERATIONCONTENT/OPERATION TIME PERIOD

S4 STOPPAGE POSSIBLE?
— NO
— YES → STOP INSTRUCTION TO STOP REQUESTING DEVICE (S5) → RET

S6 SIMULATION OF CONDITION (STATE) THAT ENABLES STOPPAGE

S7 STOPPAGE POSSIBLE AFTER CHANGING CONDITIONS?
— NO → LINE STOPPAGE INSTRUCTION (S9) → RET
— YES → INSTRUCT ADJUSTMENT TARGET DEVICE TO ADJUST PROCESSING CONDITIONS/CONVEYING CONDITIONS (S8) → RET

# FIG. 11

SIMULATION

IS THERE AN UPSTREAM STORAGE DEVICE? — S21 NO

YES

SELECT CONDITION CHANGE CANDIDATES OF UPSTREAM DEVICE AND CONCERNED DEVICE BASED ON ALLOWABLE DELAY TIME PERIOD — S22

IS THERE A CONDITION FOR WHICH CONDITION CHANGE AND LATENCY ARE APPROPRIATE? — S23 YES

NO

IS THERE A DOWNSTREAM STORAGE DEVICE? — S25 YES

NO

SELECT CONDITION CHANGE CANDIDATES OF DOWNSTREAM DEVICE AND CONCERNED DEVICE BASED ON ALLOWABLE DELAY TIME PERIOD — S26

IS THERE A CONDITION FOR WHICH CONDITION CHANGE AND LATENCY ARE APPROPRIATE? — S27

NO

IMPOSSIBLE TO INDEPENDENTLY STOP — S24

YES

POSSIBLE TO INDEPENDENTLY STOP — S28

END

# FIG. 12

START

IS FILM THICKNESS
OF PHOTOSENSITIVE
FUNCTIONAL
LAYERWITHIN
ALLOWABLE RANGE? S31 — YES

NO

S32
DETERMINE THAT
PROCESSING ERROR
OCCURS IN PROCESSING
DEVICE PR2

IS EXPOSURE
AMOUNT WITHIN
ALLOWABLE RANGE? S33 — YES

NO S34

DETERMINE THAT
PROCESSING
ERROR OCCURS IN
PROCESSING
DEVICE PR3

DOES LINE WIDTH S35
OF PATTERN FORMED
IN PHOTOSENSITIVE
FUNCTIONAL LAYER
LIE WITHIN
ALLOWABLE RANGE? — YES

NO

S36
DETERMINE THAT
PROCESSING
ERROR OCCURS IN
PROCESSING
DEVICE PR4

DOES LINE WIDTH S37
OF FORMED METAL
LAYER PATTERN LIE
WITHIN ALLOWABLE
RANGE? — YES

NO S38

DETERMINE THAT
PROCESSING ERROR
OCCURS IN
PROCESSING
DEVICE PR5

S39
DETERMINE THAT
PROCESSING ERROR
HAS NOT OCCURRED

END

EP 3 358 611 B1

**FIG. 13**

START

COVERAGE POSSIBLE BY CHANGING PROCESSING CONDITIONS OF PROCESSING DEVICE PR3?  S41  YES

NO

CHANGE PROCESSING CONDITIONS AND CONVEYING SPEED CONDITION OF PROCESSING DEVICE PR3  S43

CHANGE PROCESSING CONDITIONS OF PROCESSING DEVICE PR3  S42

COVERAGE POSSIBLE BY CHANGING PROCESSING CONDITIONS OF ANY OTHER ONE OF THE PROCESSING DEVICES PR?  S44

YES

CHANGE PROCESSING CONDITIONS OF CONCERNED OTHER PROCESSING DEVICE PR  S45

NO

CHANGE PROCESSING CONDITIONS OF PLURALITY OFOTHER PROCESSING DEVICES PR  S46

NO  CHANGE IN PROCESSING CONDITIONS COMPLETED?  S47

YES

RESTORE CONVEYING SPEED OF PROCESSING DEVICE PR3 TO ITS ORIGINAL STATE  S48

END

EP 3 358 611 B1

FIG. 14

START

S51 COVERAGE POSSIBLE BY CHANGING PROCESSING CONDITIONS OF PROCESSING DEVICE PR3? — YES → S52 CHANGE PROCESSING CONDITIONS OF PROCESSING DEVICE PR3

NO

S53 CHANGE PROCESSING CONDITIONS AND CONVEYING SPEED CONDITION OF PROCESSING DEVICE PR3

S54 COVERAGE POSSIBLE BY CHANGING PROCESSING CONDITIONS OF PROCESSING DEVICE PR IN WHICH PROCESSING ERROR IS GENERATED? — YES → S55 CHANGE PROCESSING CONDITIONS OF PROCESSING DEVICE PR IN WHICH PROCESSING ERROR IS GENERATED

NO

S56 COVERAGE POSSIBLE BY CHANGING PROCESSING CONDITIONS OF OTHER PROCESSING DEVICE PR? — YES → S57 CHANGE PROCESSING CONDITIONS OF CONCERNED OTHER PROCESSING DEVICE PR

NO

S58 CHANGE PROCESSING CONDITIONS OF PLURALITY OF OTHER PROCESSING DEVICES PR

S59 CHANGE IN PROCESSING CONDITIONS COMPLETED? — NO

YES

S60 RESTORE SETTING CONDITIONS OF PROCESSING DEVICE PR3 TO THEIR ORIGINAL STATE

END

EP 3 358 611 B1

FIG. 15

EP 3 358 611 B1

FIG. 16

EP 3 358 611 B1

FIG. 17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0428415 A
- JP 2009146746 A
- WO 2013146184 A
- WO 2014034161 A
- JP 5494621 B